(19) Europäisches Patentamt / European Patent Office / Office européen des brevets

(11) **EP 4 757 219 A1**

(12) **EUROPEAN PATENT APPLICATION**
published in accordance with Art. 153(4) EPC

(43) Date of publication:
**10.06.2026 Bulletin 2026/24**

(21) Application number: **24863159.0**

(22) Date of filing: **03.09.2024**

(51) International Patent Classification (IPC):
**H04L 1/00** $^{(2006.01)}$   **H03M 13/11** $^{(2006.01)}$

(52) Cooperative Patent Classification (CPC):
**H03M 13/11; H04L 1/00**

(86) International application number:
**PCT/KR2024/013252**

(87) International publication number:
**WO 2025/053578 (13.03.2025 Gazette 2025/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **04.09.2023 KR 20230117157**
**12.10.2023 KR 20230135523**

(71) Applicant: **Samsung Electronics Co., Ltd.**
**Suwon-si, Gyeonggi-do 16677 (KR)**

(72) Inventor: **MYUNG, Seho**
**Suwon-si Gyeonggi-do 16677 (KR)**

(74) Representative: **Nederlandsch Octrooibureau**
**P.O. Box 29720**
**2502 LS The Hague (NL)**

(54) **METHOD AND APPARATUS FOR ENCODING AND DECODING DATA IN COMMUNICATION OR BROADCASTING SYSTEM**

(57) The present disclosure relates to a 5G or 6G communication system for supporting higher data transfer rates than 4G communication systems such as LTE. The present invention relates to a method performed by a transmitter in a communication system, the method comprising the steps of: determining the number of input bits; determining a base matrix on the basis of the number of input bits; determining a lifting size (Z) on the basis of at least one of the number of input bits or the base matrix; determining a parity check matrix on the basis of at least one of the base matrix and the lifting size (Z); and performing encoding on the basis of the parity check matrix and the input bits, wherein the parity check matrix includes a first submatrix corresponding to the input bits and a second submatrix corresponding to first parity bits, three cyclic permutation matrices are included in a first column block of the second submatrix, the greatest common divisor of at least one of difference values of each exponent of the cyclic permutation matrices and the lifting size (Z) is 1 or the smallest number greater than 1 among divisors of the lifting size (Z), and the at least one of the difference values of each exponent of the cyclic permutation matrices is $Z/2^i$ ($0 \le i \le L$), where $Z = p \cdot 2^i$ ($p$ is an odd number, $0 \le i \le L$).

FIG. 10

**Description**

[Technical Field]

Various embodiments of the disclosure relate to a method and an apparatus for encoding and decoding data in a communication or broadcast system.

[Background Art]

Considering the development of wireless communication from generation to generation, the technologies have been developed mainly for services targeting humans, such as voice calls, multimedia services, and data services. Following the commercialization of 5G (5th-generation) communication systems, it is expected that the number of connected devices will exponentially grow. Increasingly, these will be connected to communication networks. Examples of connected things may include vehicles, robots, drones, home appliances, displays, smart sensors connected to various infrastructures, construction machines, and factory equipment. Mobile devices are expected to evolve in various form-factors, such as augmented reality glasses, virtual reality headsets, and hologram devices. In order to provide various services by connecting hundreds of billions of devices and things in the 6G (6th-generation) era, there have been ongoing efforts to develop improved 6G communication systems. For these reasons, 6G communication systems are referred to as beyond-5G systems.

6G communication systems, which are expected to be commercialized around 2030, will have a peak data rate of tera (1,000 giga)-level bps and a radio latency less than 100µsec, and thus will be 50 times as fast as 5G communication systems and have the 1/10 radio latency thereof.

In order to accomplish such a high data rate and an ultra-low latency, it has been considered to implement 6G communication systems in a terahertz band (for example, 95GHz to 3THz bands). It is expected that, due to severer path loss and atmospheric absorption in the terahertz bands than those in mmWave bands introduced in 5G, technologies capable of securing the signal transmission distance (that is, coverage) will become more crucial. It is necessary to develop, as major technologies for securing the coverage, radio frequency (RF) elements, antennas, novel waveforms having a better coverage than orthogonal frequency division multiplexing (OFDM), beamforming and massive multiple input multiple output (MIMO), full dimensional MIMO (FD-MIMO), array antennas, and multiantenna transmission technologies such as large-scale antennas. In addition, there has been ongoing discussion on new technologies for improving the coverage of terahertz-band signals, such as metamaterial-based lenses and antennas, orbital angular momentum (OAM), and reconfigurable intelligent surface (RIS).

Moreover, in order to improve the spectral efficiency and the overall network performances, the following technologies have been developed for 6G communication systems: a full-duplex technology for enabling an uplink transmission and a downlink transmission to simultaneously use the same frequency resource at the same time; a network technology for utilizing satellites, high-altitude platform stations (HAPS), and the like in an integrated manner; an improved network structure for supporting mobile base stations and the like and enabling network operation optimization and automation and the like; a dynamic spectrum sharing technology via collison avoidance based on a prediction of spectrum usage; an use of artificial intelligence (AI) in wireless communication for improvement of overall network operation by utilizing AI from a designing phase for developing 6G and internalizing end-to-end AI support functions; and a next-generation distributed computing technology for overcoming the limit of UE computing ability through reachable superhigh-performance communication and computing resources (such as mobile edge computing (MEC), clouds, and the like) over the network. In addition, through designing new protocols to be used in 6G communication systems, developing mecahnisms for implementing a hardware-based security environment and safe use of data, and developing technologies for maintaining privacy, attempts to strengthen the connectivity between devices, optimize the network, promote softwarization of network entities, and increase the openness of wireless communications are continuing.

It is expected that research and development of 6G communication systems in hyper-connectivity, including person to machine (P2M) as well as machine to machine (M2M), will allow the next hyper-connected experience. Particularly, it is expected that services such as truly immersive extended reality (XR), high-fidelity mobile hologram, and digital replica could be provided through 6G communication systems. In addition, services such as remote surgery for security and reliability enhancement, industrial automation, and emergency response will be provided through the 6G communication system such that the technologies could be applied in various fields such as industry, medical care, automobiles, and home appliances.

[Disclosure]

[Technical Problem]

The disclosure provides an algebraic characteristic that a parity check matrix of an LDPC code needs to satisfy to reduce decoding latency and lower encoding complexity. In addition, the disclosure provides an efficient encoding and decoding method and apparatus using an LDPC code having the algebraic characteristic.

The disclosure provides an algebraic characteristic that a parity check matrix of an LDPC code needs to satisfy to reduce a block error rate (BLER). In addition, the disclosure provides an efficient encoding and decoding method and apparatus using an LDPC code having the algebraic characteristic.

The disclosure provides an algebraic characteristic that a parity check matrix of an LDPC code needs to satisfy, by appropriately combining the algebraic characteristics to simultaneously reduce decoding latency, encoding complexity and BLER. In addition, the disclosure provides an efficient encoding and decoding method and apparatus using an LDPC code having the combined algebraic characteristic.

[Technical Solution]

In a communication system according to an embodiment of the disclosure, a data transmission method of a base station or a terminal may include: LDPC-encoding data, based on a base matrix and/or a parity check matrix; applying appropriate rate matching to the encoded data; modulating the rate-matched encoded data; and transmitting the modulated signal through a transmission device, wherein the base matrix or the parity check matrix or a weight matrix corresponding thereto satisfies a specific algebraic condition.

In a communication system according to an embodiment of the disclosure, a data reception method of a base station or a terminal may include: receiving a modulated signal through a reception device; based on the received signal, performing demodulation to determine values for decoding; performing LDPC decoding, based on the determined values and a base matrix and/or a parity check matrix; appropriately applying rate dematching to the LDPC-decoded result; and determining data from the rate dematched result, wherein the base matrix or the parity check matrix or a weight matrix corresponding thereto satisfies a specific algebraic condition.

[Advantageous Effects]

According to the disclosure, by providing an algebraic characteristic of a parity check matrix for reducing the latency and the BLER, the LDPC code may be effectively supported for variable lengths and variable rates.

[Description of Drawings]

FIG. 1 is a diagram illustrating a systematic LDPC codeword structure.
FIG. 2 is a diagram illustrating a method for graphically expressing an LDPC code.
FIG. 3A is an exemplary diagram illustrating a cycle characteristic of a QC-LDPC code.
FIG. 3B is an exemplary diagram illustrating a cycle characteristic of a QC-LDPC code.
FIG. 4 is a diagram illustrating a transport block structure according to an embodiment of the disclosure.
FIG. 5 is an exemplary diagram illustrating an LDPC encoding process according to an embodiment of the disclosure.
FIG. 6 is an exemplary diagram illustrating an LDPC decoding process according to an embodiment of the disclosure.
FIG. 7 is a block diagram of a transmission device according to an embodiment of the disclosure.
FIG. 8 is a block diagram of a reception device according to an embodiment of the disclosure.
FIG. 9 is a diagram illustrating a structure of an LDPC decoding unit according to an embodiment of the disclosure.
FIG. 10 is an exemplary diagram illustrating a structure of a parity check matrix of an LDPC code.
FIG. 11A is an exemplary diagram illustrating a parity check matrix of an LDPC code satisfying a characteristic proposed in the disclosure.
FIG. 11B is an exemplary diagram illustrating a parity check matrix of an LDPC code satisfying a characteristic proposed in the disclosure.

[Mode for Invention]

Hereinafter, exemplary embodiments of the disclosure will be described in detail with reference to the accompanying drawings. Also, in describing the disclosure, a detailed description of relevant known functions or configurations will be omitted when it is determined that the description may make the subject matter of the disclosure unnecessarily unclear. The terms which will be described below are terms defined in consideration of the functions in the disclosure, and may be different according to users, intentions of the users, or customs. Therefore, the definitions of the terms should be made based on the contents throughout the specification.

Based on determinations by those skilled in the art, the main idea of the disclosure may also be applied to other systems having similar technical backgrounds through some modifications without significantly departing from the scope of the disclosure. For reference, the meaning of the term "communication system" generally includes a broadcast system, but in the disclosure, a communication may be definitely referred to as a broadcast system when the main service of the communication system is a broadcast service.

The advantages and features of the disclosure and ways to achieve them will be apparent by making reference to embodiments as described below in detail in conjunction with the accompanying drawings. However, the disclosure is not limited to the embodiments set forth below, but may be implemented in various different forms. The following embodiments are provided only to completely disclose the disclosure and inform those skilled in the art of the scope of the disclosure, and the disclosure is defined only by the scope of the appended claims. Throughout the specification, the same or like reference signs indicate the same or like elements.

Low density parity check (LDPC) codes, which were first introduced by Gallager in the 1960s, remained forgotten for a long time due to an implementation complexity that was difficult to realize at the technological level of that era. However, as turbo codes proposed by Berrou, Glavieux, and Thitimajshima in 1993 demonstrated performance approaching Shannon's channel capacity, extensive interpretations of their performance and characteristics led to significant research into iterative decoding and graph-based channel encoding. In light of this, as LDPC codes were reinvestigated in the late 1990s, it was found that LDPC codes also possess performance approaching Shannon's channel capacity when decoding is performed by applying iterative decoding based on the sum-product algorithm on a Tanner graph corresponding to the LDPC codes.

LDPC codes are generally defined by a parity-check matrix and may be represented using a bipartite graph, commonly referred to as a Tanner graph. Generally, LDPC codes are a type of parity-check code and were named "low-density" parity-check codes because the ratio of the number of 1s (i.e., density) in the parity-check matrix for very long lengths is extremely low. Therefore, the techniques proposed based on the LDPC code for convenience in the disclosure may be easily extended to general parity check matrix codes.

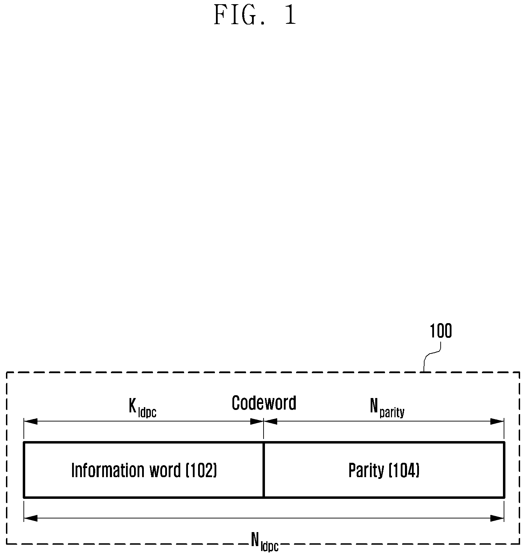

FIG. 1 is a diagram illustrating a systematic LDPC codeword structure.

According to FIG. 1, a device performing LDPC encoding receives an information word 102 including $K_{ldpc}$ bits or symbols as input, performs encoding, and generates a codeword 100 including $N_{ldpc}$ bits or symbols. For the descriptive convenience, it is assumed that an information word 102 including $K_{ldpc}$ bits is input, and a codeword 100 configured by $N_{ldpc}$ bits is generated. That is, when an information word $\underline{i} = (i_0, i_1, i_2, \ldots, i_{K_{ldpc}-1})$ of $K_{ldpc}$ input bits is LDPD encoded, a codeword $\underline{c} = (c_0, c_1, c_2, \ldots, c_{N_{ldpc}-1})$ 100 is generated. In other words, the information word and the codeword are a bit string composed of multiple bits, and information word bits and codeword bits mean bits composing the information word and the codeword, respectively. Conventionally, when an LDPC encoding bit includes information words like

$$\underline{c} = \left( c_0, c_1, c_2, \ldots, c_{N_{ldpc}-1} \right) = \left( \underline{i}, \underline{w} \right) =$$

$$(i_0, i_1, i_2, \ldots, i_{K_{ldpc}-1}, w_0, w_1, w_2, \ldots, w_{N_{ldpc}-K_{ldpc}-1}),$$

and it is called a systematic code. Here, $w = [w_0\ w_1\ w_2\ \cdots\ w_{Nldpc-Kldpc-1}]$ is a parity bit 104, and the number $N_{parity}$ of parity bits may be expressed as $N_{parity} = N_{ldpc} - K_{ldpc}$.

An LDPC code is a type of linear block code, and includes a process of determining a codeword that satisfies the following condition given in Equation 1 below.

[Equation 1]

$$H \cdot \underline{c}^T = \begin{bmatrix} \mathbf{h}_0 & \mathbf{h}_1 & \mathbf{h}_2 & \cdots & \mathbf{h}_{N_{ldpc}-1} \end{bmatrix} \cdot \underline{c}^T = \sum_{i=0}^{N_{ldpc}-1} c_i \cdot \mathbf{h}_i = \underline{0}$$

Here, $\underline{c} = [c_0\ c_1\ c_2\ \cdots\ c_{Nldpc-1}]$ is satisfied.

In Equation 1, H denotes a parity check matrix, c denotes a codeword, $c_i$ denotes an i-th bit of the codeword, $N_{ldpc}$ denotes an LDPC codeword length, and $\mathbf{h}_i$ denotes an i-th column of the parity check matrix H.

The parity check matrix H includes $N_{ldpc}$ columns, which is the same as the number of bits of the LDPC codeword.

Equation 1 indicates that the sum of the products of the i-th column of the parity check matrix ($\mathbf{h}_i$) and the i-th codeword bit $c_i$ is equal to "0", and thus the i-th column ($\mathbf{h}_i$) is associated with the i-th codeword bit $c_i$.

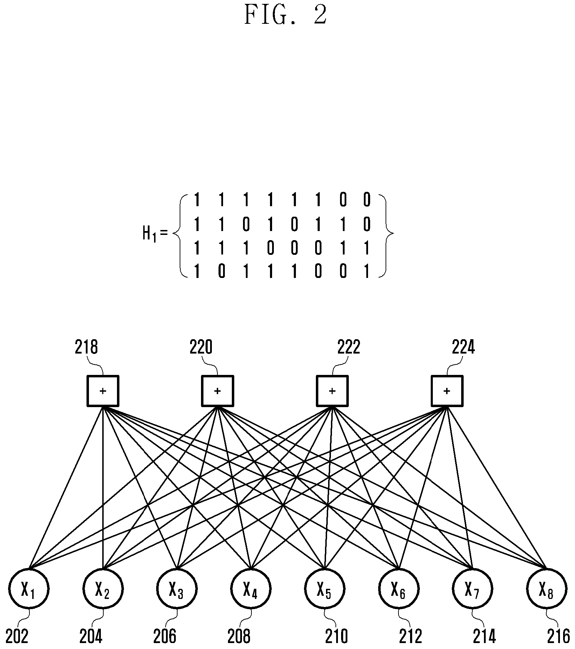

FIG. 2 is a diagram illustrating a method for graphically expressing an LDPC code.

A method of graphically expressing an LDPC code will be described with reference to FIG. 2.

FIG. 2 is a diagram illustrating an example of a parity check matrix $H_1$ of an LDPC code having 4 rows and 8 columns, and a Tanner graph thereof. Referring to FIG. 2, the parity check matrix $H_1$ has 8 columns, and thus, a codeword of length 8 is generated, the code generated through $H_1$ means an LDPC code, and each column corresponds to encoded 8 bits.

Referring to FIG. 2, a Tanner graph for an LDPC code which is encoded or decoded based on a parity check matrix $H_1$, includes 8 variable nodes $x_1$ 202, $x_2$ 204, $x_3$ 206, $x_4$ 208, $x_5$ 210, $x_6$ 212, $x_7$ 214, and $x_8$ 216 and 4 check nodes 218, 220, 222, and 224. Here, an i-th column and a j-th row of the parity check matrix $H_1$ of the LDPC code correspond to a variable node $x_i$ and a j-th check node, respectively. Furthermore, the meaning of the value 1, i.e., the non-zero value, at the intersection of the i-th column and the j-th row of the parity check matrix $H_1$ of the LDPC code, is that, as in FIG. 2, a line segment (edge) connecting the variable node $x_i$ and the j-th check node exists on the Tanner graph.

In a Tanner graph of an LDPC code, degrees of a variable node and a check node mean the number of line segments connected to the respective nodes, and this is the same as the number of non-zero elements (entries) in the column or row corresponding to the node in the parity check matrix of the LDPC code. For example, in FIG. 2, the degrees of the variable nodes $x_1$ 202, $x_2$ 204, $x_3$ 206, $x_4$ 208, $x_5$ 210, $x_6$ 212, $x_7$ 214, and $x_8$ 216 are 4, 3, 3, 3, 2, 2, 2, and 2, respectively, and the degrees of the check nodes 218, 220, 222, and 224 are 6, 5, 5, and 5, respectively. In addition, in each of the columns of the parity check matrix $H_1$ in FIG. 2 corresponding to the variable nodes in FIG. 2, the number of non-zero elements is equal to the degrees of the variable nodes 4, 3, 3, 3, 2, 2, 2, and 2 in the above order, and in each of the rows of the parity check matrix $H_1$ in FIG. 2 corresponding to the check nodes in FIG. 2, the number of non-zero elements is equal to the degrees of the check nodes 6, 5, 5, and 5 in the above order. For this reason, the degree of each variable node is also referred to as a column degree or column weight, and the degree of a check node is also referred to as a row degree or row weight.

Coded LDPC codeword bits may be decoded based on an iterative decoding algorithm based on a sum-product algorithm on the bipartite graph listed in FIG. 2. Here, the sum-product algorithm is a type of message passing algorithm, and the message passing algorithm refers to an algorithm in which messages are exchanged through edges on a bipartite graph, and an output message is calculated from messages input to a variable node or a check node and then updated.

Here, a value of an i-th encoding bit may be determined based on a message of an i-th variable node. The method of determining the value of the i-th encoding bit may employ either hard decision or soft decision. Therefore, the performance of the i-th bit $c_i$ of the LDPC codeword corresponds to the performance of the i-th variable node of the Tanner graph, and this may be determined by the location and number of 1s in the i-th column of the parity check matrix. In other words, the performance of the $N_{ldpc}$ codeword bits of the codeword may be determined by the location and number of 1s in the parity check matrix, which means that the performance of the LDPC code is greatly affected by the parity check matrix. Therefore, in order to design an LDPC code having excellent performance, there is a need for a method of designing a good parity check matrix.

In communication and broadcasting systems, a parity-check matrix typically employs quasi-cyclic LDPC codes (or QC-LDPC codes, hereafter referred to as QC-LDPC codes) using quasi-cyclic parity-check matrices for ease of implementation. Depending on the communication and broadcasting system, a parity check matrix having a structure similar to the quasi-cyclic structure is used, although the structure is not a complete quasi-cyclic structure, and in such cases, the LDPC code may not be strictly classified as a QC-LDPC code in terms of algebra, but may be classified as a QC-LDPC code for convenience.

A conventional QC-LDPC code is characterized by having a parity check matrix including 0-matrices (zero matrices) or circulant permutation matrices (or circular permutation matrices) having the form of small square matrices. Here, the permutation matrix means a matrix in which each row or column includes one 1 and the remaining elements are all 0. In addition, the circulant permutation matrix refers to a matrix in which each element of an identity matrix is cyclically shifted to the right or left. In general, an identity matrix itself is also included in the circulant permutation matrix, since the identity matrix is considered as a result of performing no cyclic shift with regard to each element of the identity matrix. Therefore, the circulant permutation matrix basically includes an identity matrix, but the identity matrix and the circulant permutation matrix other than the identity matrix may be distinguished for the convenience of description.

Hereinafter, the QC-LDPC code will be described in detail.

First, a circulant permutation matrix $P = (P_{i,j})$ of size $Z \times Z$ is defined as in Equation 2 below. Here, $P_{i,j}$ denotes the element (entry) at the i-th row and the j-th column of the matrix P. ( $0 \leq i,j < Z$ )

[Equation 2-1]

$$P_{i,j} = \begin{cases} 1 & \text{if } i + 1 \equiv j \pmod{Z} \\ 0 & \text{otherwise.} \end{cases}$$

For the permutation matrix P defined as above, $P^i$ ($0 \le i < Z$) is a circular permutation matrix having a form in which each element of an identity matrix of size $Z \times Z$ is circularly shifted to the right by i times. The circulant permutation matrix may be defined as in [Equation 2-2] below, in which case $P^i$ is a circulant permutation matrix obtained by cyclically shifting each element of the identity matrix of size $Z \times Z$ i times to the left.

[Equation 2-2]

$$P_{i,j} = \begin{cases} 1 & \text{if } i \equiv j + 1 \pmod{Z} \\ 0 & \text{otherwise.} \end{cases}$$

In the disclosure, for convenience, various embodiments are described by using a circulant permutation matrix defined based on [Equation 2-1], but the circulant permutation matrices defined based on [Equation 2-2] may be used in the embodiments of the disclosure, since the circulant permutation matrices defined in [Equation 2-1] and [Equation 2-2] are only different in expressions but have the same fundamental algebraic properties, or various types of circulant permutation matrices having the same fundamental algebraic properties may be used.

The parity check matrix H of the simplest QC-LDPC code may be represented in the form of the following Equation 3.

[Equation 3]

$$\mathbf{H} = \begin{bmatrix} P^{V_{1,1}} & P^{V_{1,2}} & \cdots & P^{V_{1,n_b}} \\ P^{V_{2,1}} & P^{V_{2,2}} & \cdots & P^{V_{2,n_b}} \\ \vdots & \vdots & \ddots & \vdots \\ P^{V_{m_b,1}} & P^{V_{m_b,2}} & \cdots & P^{V_{m_b,n_b}} \end{bmatrix}$$

For convenience, if $P^{-1}$ is defined as a 0-matrix of size $Z \times Z$, each exponent $V_{i,j}$ of the circulant permutation matrix or 0-matrix in Equation 3 has one of the values of $\{-1, 0, 1, 2,..., Z-1\}$. The identity matrix may be expressed as $P^0$ or $I$, and the 0-matrix may be expressed as $P^{-1}$ or $O$. In addition, since the parity check matrix H of Equation 3 has $n_b$ column blocks and $m_b$ row blocks, the size of the parity check matrix H is $n_b Z \times m_b Z$.

If the parity check matrix of Equation 3 has a maximum rank (or full rank, or complete coefficient), the length of the information word bits of the QC-LDPC code corresponding to the parity check matrix is $(n_b - m_b)Z$. For convenience, the $k_b = (n_b - m_b)$ column blocks corresponding to the information word bits may be referred to as information word column blocks, the number of information word bits may be referred to as $k_b Z$, and the remaining $m_b$ column blocks corresponding to the parity bits may be referred to as parity column blocks. In this case, the number of parity bits is $m_b Z$. For reference, if the parity check matrix of Equation 3 does not have the maximum rank, the information word bit is larger than $(n_b - m_b)Z$ and the number of information word bits has a value larger than $k_b Z$ and the number of parity bits has a value smaller than $m_b Z$.

In general, a binary matrix of size $m_b \times n_b$ obtained by replacing each circulant permutation matrix and each 0-matrix in the parity check matrix of Equation 3 with 1 and 0, respectively, is referred to as a mother matrix, a base matrix, or a base graph of the parity check matrix H, and is expressed as M(H) or $\mathbf{H_{BG}}$. In addition, an integer matrix of size $m_b \times n_b$ obtained by selecting an exponent of each circulant permutation matrix or 0-matrix as in Equation 4 is referred to as an exponent matrix $V(\mathbf{H})$ of the parity check matrix H.

[Equation 4]

$$V(\mathbf{H}) = \begin{bmatrix} V_{1,1} & V_{1,2} & \cdots & V_{1,n_b} \\ V_{2,1} & V_{2,2} & \cdots & V_{2,n_b} \\ \vdots & \vdots & \ddots & \vdots \\ V_{m_b,1} & V_{m_b,2} & \cdots & V_{m_b,n_b} \end{bmatrix}$$

Of course, the above-mentioned names of the matrices are only examples, and the exponent matrix $V(\mathbf{H})$ may be referred to by another name. For example, since the exponents of the respective circulant permutation matrices correspond to values that shift an identity matrix in a circular manner, as in [Equation 2-1] or [Equation 2-2], each exponent may be referred to as a circular shift value (or a shift value), and $V(\mathbf{H})$ may be referred to as a circular shift value matrix or a shift value matrix. In general, when a value $Z$ corresponding to the size of the exponent matrix or the shift value matrix and the circulant permutation matrix or the zero-matrix is given, the parity check matrix may be determined or identified. For this reason, although the parity check matrix is defined as a binary matrix H satisfying the condition in Equation 1 according to the mathematical definition, in some cases, the exponent matrix or the shift value matrix may also be named as the parity check matrix for convenience.

A single integer included in the exponent matrix or the shift value matrix corresponds to a circulant permutation matrix in the parity check matrix, and thus the exponent matrix may be expressed as sequences of integers for convenience. In general, the parity check matrix may also be expressed by various sequences capable of expressing the same characteristics as the exponent matrix in an algebraic manner. For convenience, this disclosure has expressed the parity check matrix as an exponent matrix or a sequence indicating the positions of 1s within the parity check matrix. However, since there are various sequence notation methods capable of distinguishing the positions of the 1s or 0s included in the parity check matrix, the method expressed herein is not limited to this representation, and various sequences or matrix forms exhibiting the same algebraic effect may be used. The sequence may be referred to as an LDPC sequence, an LDPC code sequence, an LDPC sequence, a parity check matrix sequence, a (cyclic) shift value sequence, or the like, in order to distinguish the sequence from other sequences.

In addition, the transceiver may directly generate a parity check matrix to perform LDPC encoding and decoding, or may perform LDPC encoding and decoding, based on an exponent matrix, a shift value matrix, a sequence, or the like that have the same algebraic effect as the parity check matrix, according to implementation features. Therefore, in the disclosure, encoding and decoding using a parity check matrix have been described for convenience, but in an actual transceiver, encoding and decoding may be implemented through various methods that may provide the same effects as the parity check matrix.

For reference, the term "the same algebraic effect" means that two or more different expressions are logically or mathematically identical or convertible to each other. Particularly, in the case of a code that may be defined by a matrix, such as an LDPC code, this may mean that algebraic values defined by a matrix, such as a minimum distance, a rank, or the like, and cycle characteristics on a Tanner graph are the same, or that a basic structure or operation in an encoding/decoding process is the same. For example, if the same matrix is obtained through an appropriate column permutation, a row permutation, and the like, the two matrices may be considered algebraically identical from the perspective of codes. In addition, various transpose operations that do not change the essential characteristics of the signs may also provide the same algebraic effect.

For example, when there is a matrix A as described below, various transformations providing algebraically identical effects are shown as A1 to A8.

$$A = \begin{bmatrix} P^{a_{1,1}} & P^{a_{1,2}} & P^{a_{1,3}} & P^{a_{1,4}} \\ P^{a_{2,1}} & P^{a_{2,2}} & P^{a_{2,3}} & P^{a_{2,4}} \\ P^{a_{3,1}} & P^{a_{3,2}} & P^{a_{3,3}} & P^{a_{3,4}} \\ P^{a_{4,1}} & P^{a_{4,2}} & P^{a_{4,3}} & P^{a_{4,4}} \end{bmatrix}$$

$$A_1 = \begin{bmatrix} P^{a_{1,1}} & P^{a_{1,3}} & P^{a_{1,2}} & P^{a_{1,4}} \\ P^{a_{2,1}} & P^{a_{2,3}} & P^{a_{2,2}} & P^{a_{2,4}} \\ P^{a_{3,1}} & P^{a_{3,3}} & P^{a_{3,2}} & P^{a_{3,4}} \\ P^{a_{4,1}} & P^{a_{4,3}} & P^{a_{4,2}} & P^{a_{4,4}} \end{bmatrix}, \quad A_2 = \begin{bmatrix} P^{a_{3,1}} & P^{a_{3,3}} & P^{a_{3,2}} & P^{a_{3,4}} \\ P^{a_{2,1}} & P^{a_{2,3}} & P^{a_{2,2}} & P^{a_{2,4}} \\ P^{a_{1,1}} & P^{a_{1,3}} & P^{a_{1,2}} & P^{a_{1,4}} \\ P^{a_{4,1}} & P^{a_{4,3}} & P^{a_{4,2}} & P^{a_{4,4}} \end{bmatrix},$$



# EP 4 757 219 A1

$$A_3 = \begin{bmatrix} P^{a_{1,1}+x} & P^{a_{1,2}} & P^{a_{1,3}+y} & P^{a_{1,4}} \\ P^{a_{2,1}+x} & P^{a_{2,2}} & P^{a_{2,3}+y} & P^{a_{2,4}} \\ P^{a_{3,1}+x} & P^{a_{3,2}} & P^{a_{3,3}+y} & P^{a_{3,4}} \\ P^{a_{4,1}+x} & P^{a_{4,2}} & P^{a_{4,3}+y} & P^{a_{4,4}} \end{bmatrix},$$

$$A_4 = \begin{bmatrix} P^{a_{1,1}+x} & P^{a_{1,2}} & P^{a_{1,3}+y} & P^{a_{1,4}} \\ P^{a_{2,1}+x+z} & P^{a_{2,2}+z} & P^{a_{2,3}+y+z} & P^{a_{2,4}+z} \\ P^{a_{3,1}+x} & P^{a_{3,2}} & P^{a_{3,3}+y} & P^{a_{3,4}} \\ P^{a_{4,1}+x+w} & P^{a_{4,2}+w} & P^{a_{4,3}+y+w} & P^{a_{4,4}+w} \end{bmatrix},$$

$$A_5 = \begin{bmatrix} P^{-a_{1,1}} & P^{-a_{2,1}} & P^{-a_{3,1}} & P^{-a_{4,1}} \\ P^{-a_{1,2}} & P^{-a_{2,2}} & P^{-a_{3,2}} & P^{-a_{4,2}} \\ P^{-a_{1,3}} & P^{-a_{2,3}} & P^{-a_{3,3}} & P^{-a_{4,3}} \\ P^{-a_{1,4}} & P^{-a_{2,4}} & P^{-a_{3,4}} & P^{-a_{4,4}} \end{bmatrix},$$

$$A_6 = \begin{bmatrix} P^{a_{1,1}} & P^{a_{2,1}} & P^{a_{3,1}} & P^{a_{4,1}} \\ P^{a_{1,2}} & P^{a_{2,2}} & P^{a_{3,2}} & P^{a_{4,2}} \\ P^{a_{1,3}} & P^{a_{2,3}} & P^{a_{3,3}} & P^{a_{4,3}} \\ P^{a_{1,4}} & P^{a_{2,4}} & P^{a_{3,4}} & P^{a_{4,4}} \end{bmatrix},$$

$$A_7 = \begin{bmatrix} P^{-a_{1,1}} & P^{-a_{1,2}} & P^{-a_{1,3}} & P^{-a_{1,4}} \\ P^{-a_{2,1}} & P^{-a_{2,2}} & P^{-a_{2,3}} & P^{-a_{2,4}} \\ P^{-a_{3,1}} & P^{-a_{3,2}} & P^{-a_{3,3}} & P^{-a_{3,4}} \\ P^{-a_{4,1}} & P^{-a_{4,2}} & P^{-a_{4,3}} & P^{-a_{4,4}} \end{bmatrix},$$

$$A_8 = \begin{bmatrix} P^{ka_{1,1}} & P^{ka_{1,2}} & P^{ka_{1,3}} & P^{ka_{1,4}} \\ P^{ka_{2,1}} & P^{ka_{2,2}} & P^{ka_{2,3}} & P^{ka_{2,4}} \\ P^{ka_{3,1}} & P^{ka_{3,2}} & P^{ka_{3,3}} & P^{ka_{3,4}} \\ P^{ka_{4,1}} & P^{ka_{4,2}} & P^{ka_{4,3}} & P^{ka_{4,4}} \end{bmatrix},$$

(where k and Z are coprime integers)

$A_1$ is an example of a block unit permutation in which a second column block and a third column block of $A$ are replaced. $A_2$ is an example of a block unit permutation in which a first row block and a third row block are replaced in addition to $A_1$. $A_3$ is an example in which cyclic permutations are applied only to a first column block and a third column block of $A$. $A_4$ is an example in which cyclic permutations are additionally applied only to a second row block and a fourth row block in the $A_3$. $A_5$ is an example in which a transpose transformation is applied to $A$. $A_6$ is an example in which a block unit transpose is applied to $A$. $A_7$ shows an example in which signs of exponents (or cyclic shift values) of $A$ are replaced (for convenience, the 0-matrix of size $Z \times Z$ is expressed as $P^{-1}$, and in this case, the use of the negative exponents (or the negative shift values) may cause confusion, so $(-a_{i,j})$ may be expressed as a positive value as $(Z - a_{i,j})$). $A_8$ is an example in which an affine transformation with a constant term of 0 is applied with regard to $A$ (in general, an affine transformation with a non-zero constant term may also be applied). For reference, the above examples were described for the case where $P^{a_{i,j}}$ has no elements corresponding to a 0-matrix of size $Z \times Z$, for convenience. However, if a 0-matrix is included, the part corresponding to the 0-matrix is always a 0-matrix regardless of the transformation. For example, if $P^{a_{2,3}}$ is a 0-matrix in $A$, then $P^{a_{2,3}}$ is a 0-matrix in $A_1$, $A_2$ and $A_6$, and $P^{a_{2,3}+y}$ and $P^{a_{2,3}+y+z}$ are 0-matrices in $A_3$ and $A_4$, respectively, $P^{-a_{2,3}}$ is a 0-matrix in $A_5$ and $A_7$, and $P^{ka_{2,3}}$ is a 0-matrix in $A_8$.

The above transformations are only examples, and there may be various other transformations. In addition, each of the transformations may be applied independently, but may be applied with appropriate overlapping and combination. The feature of each of the transformations or a combination of transformations is that the same may be transformed back to the original matrix through an appropriate invertible transformation process.

The above-mentioned various transformations or combinations of the transformations are substantially transformations in which the arrangements of bits (or variable nodes) or check nodes on the Tanner graph are simply changed, or are symmetric transformations or reversible transformations in which specific structures are maintained. Therefore, in terms of code performance, the instantaneous performance may differ depending on the given channel situation, but the same average performance may be provided. In this disclosure, all parity check matrices that may be obtained through a transformation that yields an algebraically identical effect are considered as the same parity check matrix.

So far, for the sake of convenience, only the case in which one circulant permutation matrix corresponding to a square block of one size $Z \times Z$ has been described, but the disclosure may also be applied to the case in which multiple circulant permutation matrices are included in one block. For example, when two circulant permutation matrices, $P^{V_{ij}^{(1)}}$ and $P^{V_{ij}^{(2)}}$, , correspond to the position of the i-th row block and the j-th column block as in Equation 5 below, it may be simply expressed in a sum form of $P^{V_{ij}^{(1)}} + P^{V_{ij}^{(2)}}$, , and the exponent matrix (or cyclic shift value matrix) may be expressed as in Equation 6 below. According to Equation 6, the exponent matrix is defined as a matrix where two integers correspond to the i-th row and j-th column, corresponding to row blocks and column blocks including the sum of the aforementioned multiple circulant permutation matrices.

[Equation 5]

$$\mathbf{H} = \begin{bmatrix} & P^{V_{i,j}^{(1)}} + P^{V_{i,j}^{(2)}} & \end{bmatrix}$$

[Equation 6]

$$V(\mathbf{H}) = \begin{bmatrix} & \left( V_{i,j}^{(1)}, V_{i,j}^{(2)} \right) & \end{bmatrix}$$

As shown in the embodiment described above, in a general QC-LDPC code, one or multiple circulant permutation matrices may correspond to one row block and column block in a parity check matrix, and for reference, a matrix of size $Z \times Z$ in which multiple circulant permutation matrices are repeated within a single row block and column block is called a circulant matrix (also known as a circulant or circular matrix). In general, a circulant matrix may have elements that are not only binary numbers, but also arbitrary numbers as elements, but in the disclosure, since it is described based on binary codes for convenience, the circulant matrix refers to a binary cyclic matrix. Of course, the algebraic structure and features proposed in the disclosure may also be extended in a similar manner to non-binary codes, but detailed descriptions thereof will be omitted from the disclosure.

Meanwhile, the base matrix (or mother matrix or base graph) with regard to the parity check matrix and the exponent matrix (or cyclic shift value matrix) in Equations 5 and 6 may be a binary matrix obtained by replacing each of the circulant permutation matrix and the 0-matrix with 1 and 0, respectively, in a similar manner to the definition used in Equation 3, and a circulant matrix (i.e., a sum of multiple circulant permutation matrices) included in a block may also be replaced with 1.

A simple example of the relationship between a parity check matrix, an exponent matrix (or a cyclic shift value matrix), a base matrix, and the like is given in the following [Equation 7].

[Equation 7]

$$\mathbf{H_1} = \begin{bmatrix} P^{159} & O & P^0 & P^0 & O & O \\ P^{117} & P^{109} & O & P^0 & P^0 & O \\ O & P^{225} & P^1 & O & P^0 & P^0 \\ P^{84} & P^{211} & P^0 & O & O & P^0 \end{bmatrix} \left( = \begin{bmatrix} P^{159} & O & I & I & O & O \\ P^{117} & P^{109} & O & I & I & O \\ O & P^{225} & P^1 & O & I & I \\ P^{84} & P^{211} & I & O & O & I \end{bmatrix} \right),$$

$$M(\mathbf{H_1}) = \begin{bmatrix} 1 & 0 & 1 & 1 & 0 & 0 \\ 1 & 1 & 0 & 1 & 1 & 0 \\ 0 & 1 & 1 & 0 & 1 & 1 \\ 1 & 1 & 1 & 0 & 0 & 1 \end{bmatrix},$$

$$V(\mathbf{H_1}) = \begin{bmatrix} 159 & -1 & 0 & 0 & -1 & -1 \\ 117 & 109 & -1 & 0 & 0 & -1 \\ -1 & 225 & 1 & -1 & 0 & 0 \\ 84 & 211 & 0 & -1 & -1 & 0 \end{bmatrix}.$$

In Equation 7, the expression of an exponent (or a shift value) of a 0-matrix of size $Z \times Z$ as -1 is only an example, and it may be expressed in various ways. Furthermore, the matrix expression of the above [Equation 7] may be expressed through various other methods, and as a specific example, the expression method of the parity check matrix of an LDPC code defined in the 3GPP 5G standard specification, 3GPP TS 38.212, may also be used. In 3GPP TS 38.212, because the sizes of the parity check matrices of the LDPC codes corresponding to base graph 1 (BG1) and base graph 2 (BG2) are too large, the matrices are expressed in the form of tables. When the expression method is applied to the matrices of Equation 7, the result is as shown in Table 1 below.

$\mathbf{H_{BG1}}$ is a matrix of size $4 \times 8$, and $\mathbf{H_1}$ is a matrix of size $4Z \times 8Z$. Here, 0 or 0-matrices of size $Z \times Z$ corresponds to the elements of the base matrices (or base graphs) and the parity check matrices not represented in Table 1 below.

[Table 1]

| $\mathbf{H_{BG1}}$ | | $V_{i,j}$ |
|---|---|---|
| Row index $i$ | Column index $j$ | |
| 0 | 0 | 159 |
| | 2 | 0 |
| | 3 | 0 |
| 1 | 0 | 117 |
| | 1 | 109 |
| | 3 | 0 |
| | 4 | 0 |
| 2 | 1 | 225 |
| | 2 | 1 |
| | 4 | 0 |
| | 5 | 0 |
| 3 | 0 | 84 |
| | 1 | 211 |
| | 2 | 0 |
| | 5 | 0 |

If the base matrix and the exponent matrix in Equation 7 are expressed by using a sequence, the same may be expressed in the following manner.

$$M(\mathbf{H_1}):$$

0 2 3

0 1 3 4

1 2 4 5

0 1 2 5

$$V(\mathbf{H_1}):$$

159 0 0

117 109 0 0

225 1 0 0

84 211 0 0

As described above, when the exponent matrix $V(\mathbf{H_1})$ is expressed as a sequence, the exponent matrix may be referred to as a shift sequence, a shift value sequence, an LDPC sequence, or the like, for the convenience. In the above sequence expression, $M(\mathbf{H_1})$ is a method in which the positions of columns having a non-zero element are listed for each row, and $V(\mathbf{H_1})$ is a method in which the exponents or shift values of the non-zero circulant permutation matrices are listed for each row. From the above sequences, an exponent matrix (or a shift value matrix) may be defined accurately, and if information regarding the $Z$ value is obtained, a parity check matrix may also be defined accurately.

Another simple example of the relationship between a parity check matrix and an exponent matrix (or a cyclic shift value matrix), a base matrix, etc. is given in the following [Equation 8]. The example in Equation 8 illustrates a case where the parity check matrix includes a circulant matrix corresponding to two or more circulant permutation matrices within at least one block of size $Z \times Z$.

[Equation 8]

$$\mathbf{H_2} = \begin{bmatrix} P^{117} + P^{159} & P^{109} & P^0 & P^0 \\ P^{84} & P^{211} + P^{225} & P^1 + P^3 & P^0 \end{bmatrix},$$

$$M(\mathbf{H_2}) = \begin{bmatrix} 1 & 1 & 1 & 1 \\ 1 & 1 & 1 & 1 \end{bmatrix},$$

$$V(\mathbf{H_2}) = \begin{bmatrix} 117,159 & 109 & 0 & 0 \\ 84 & 211,225 & 1,3 & 0 \end{bmatrix},$$

$$W(\mathbf{H_2}) = \begin{bmatrix} 2 & 1 & 1 & 1 \\ 1 & 2 & 2 & 1 \end{bmatrix}.$$

For reference, in Equation 8, $W(\mathbf{H_2})$ is a weight matrix with regard to a base matrix, an exponent matrix, or a parity check matrix, and is a matrix representing the number of circulant permutation matrices corresponding to the i-th row and j-th column of the base matrix and the exponent matrix, or to the i-th row block and j-th column block of the parity check matrix. For example, $W(\mathbf{H_2})$ may indicate a matrix in which the number of circulant permutation matrices configuring a circulant matrix of size $Z \times Z$ corresponding to an i-th row block and a j-th column block in a parity check matrix is represented as an element in an i-th row and a j-th column. That is, $W(\mathbf{H_2})$ is a matrix in which 0 is expressed as an element when a corresponding matrix is a 0-matrix, and w is expressed as an element when corresponding matrices are w circulant permutation matrices. (For reference, a 0-matrix may be considered as a circulant matrix in a broad sense, but it is not a cyclic "permutation" matrix.)

The base matrix, the parity check matrix, or the cyclic shift value matrix (or exponent matrix) defined in [Equation 8] may be represented as shown in [Table 2] by applying the method used in 3GPP TS 38.212 to express the parity check matrices of LDPC codes, as shown in [Table 1].

$\mathbf{H_{BG2}}$ is a matrix of size $2 \times 4$, and $\mathbf{H_2}$ is a matrix of size $2Z \times 4Z$. Here, 0 or 0-matrices of size $Z \times Z$ corresponds to

the elements of the base matrices (or base graphs) and the parity check matrices not represented in Table 2 below.

[Table 2]

| H$_{BG2}$ | | V$_{i,j}$ |
|---|---|---|
| Row index $i$ | Column index $j$ | |
| 0 | 0 | 117,159 |
| | 1 | 109 |
| | 2 | 0 |
| | 3 | 0 |
| 1 | 0 | 84 |
| | 1 | 211, 225 |
| | 2 | 1, 3 |
| | 3 | 0 |

If the base matrix and the exponent matrix in Equation 8 are expressed by using a sequence, the same may be expressed in the following manner.

$$M(\mathbf{H_2}):$$
$$0\ 1\ 2\ 3$$
$$0\ 1\ 2\ 3$$

$$V(\mathbf{H_2}):$$
$$(117,\ 159)\ 109\ 0\ 0$$
$$84\ (211,\ 225)\ (1,\ 3)\ 0$$

As another expression method, the same may be expressed in the form of a sequence only by using a weight matrix as follows.

$$M(\mathbf{H_2}):$$
$$0\ 1\ 2\ 3$$
$$0\ 1\ 2\ 3$$

$$W(\mathbf{H_2}):$$
$$2\ 1\ 1\ 1$$
$$1\ 2\ 2\ 1$$

$$V(\mathbf{H_2}):$$
$$117\ 159\ 109\ 0\ 0$$
$$84\ 211\ 225\ 1\ 3\ 0$$

In the expression method, $M(\mathbf{H_2})$ is a method in which the positions of the columns having a non-zero element are listed for each row, $W(\mathbf{H_2})$ is a matrix defined based on the number of circulant permutation matrices configuring the base matrix, the exponent matrix, or the parity check matrix, and $V(\mathbf{H_2})$ is a method in which the exponents or shift values of each circulant matrix other than a 0-matrix are listed for each row. From the above sequences, an exponent matrix may be defined accurately, and if information regarding the $Z$ value is obtained, a parity check matrix may also be defined accurately.

The performance of an LDPC code is determined according to a parity check matrix, and therefore, it is necessary to design the parity check matrix in order to obtain the LDPC code with excellent performance. Additionally, an LDPC encoding or decoding method capable of supporting various input lengths and code rates is required.

"Lifting" may refer to a method not only used for the efficient design of QC-LDPC codes, but also used to generate parity check matrices having various lengths or LDPC codewords by using a given base matrix and exponent matrix. That is, the lifting may refer to a method applied to efficiently design very large parity-check matrices by configuring Z values according to specific rules to determine the size of a circulant permutation matrix or 0 matrix from a given small parent matrix, or it may refer to a method for generating parity-check matrices of various lengths or generating LDPC codewords by applying appropriate Z values to a given exponent matrix or an associated sequence.

The features of the QC-LDPC code designed through the lifting and the conventional lifting method are briefly described below, with reference to the reference [Myung2006].

Reference [Myung2006]

S. Myung, K. Yang, and Y. Kim, "Lifting Methods for Quasi-Cyclic LDPC Codes," IEEE Communications Letters. vol. 10, pp. 489-491, June 2006.

First, when an LDPC code $C_0$ is given, S QC-LDPC codes designed through the lifting method are denoted as $C_1, \ldots, C_S$, and the value corresponding to the size of the row block and the column block of the parity check matrix of each QC-LDPC code is denoted as $L_k$. Here, $C_0$ corresponds to the smallest LDPC code having the parity check matrix as the mother matrix of the C1,..., CS codes, and the $Z_0$ value corresponding to the row block and column block sizes is 1. In addition, for convenience, the parity check matrix $\mathbf{H}_k$ of each code $C_k$ has an exponent matrix $V(\mathbf{H}_k) = \left(V_{ij}^{(k)}\right)$ of size $m \times n$, and each exponent $V_{i,j}^{(k)}$ is selected as one of the values of {-1, 0, 1, 2,..., $Z_k$-1}.

The conventional lifting method is composed of steps such as $C_0 \to C_1 \to \ldots \to C_S$, and has a feature of satisfying the condition of $Z_{k+1} = q_{k+1}Z_k$ ($q_{k+1}$ is a positive integer, and k=0,1,..., S-1). In addition, if only the parity check matrix $\mathbf{H}_S$ of the $C_s$ is stored due to the characteristics of the lifting process, all of the QC-LDPC codes $C_0, C_1, ..., C_S$ may be represented by the following Equation 9 or 10 according to the lifting method.

[Equation 9]

$$V(\mathbf{H}_k) \equiv \left\lfloor \frac{Z_k}{Z_S} V(\mathbf{H}_S) \right\rfloor$$

or

[Equation 10]

$$V(\mathbf{H}_k) \equiv V(\mathbf{H}_S) \pmod{Z_k}$$

In addition to the method of designing a larger QC-LDPC code $C_1, ..., C_S$ from $C_0$ as described above, a method of generating a smaller code $C_i$(i=k-1, k-2, ... 1, 0) from a larger code $C_k$ by using an appropriate method as in Equation 9 or 10 may be referred to as "lifting". For reference, LDPC codes of various lengths may be generated using the lifting method of [Mathematical Expression 10] in 3GPP TS 38.212.

In the lifting method of Equation 9 or 10, the $Z_k$ corresponding to the sizes of the row blocks or column blocks in the parity check matrix of each QC-LDPC code $C_k$ have a multiple relationship, and the exponent matrix is also selected according to a specific method. Such a conventional lifting method helps to easily design QC-LDPC codes that improve the error floor characteristics by improving the algebraic or graph characteristics of each parity check matrix, designed through lifting.

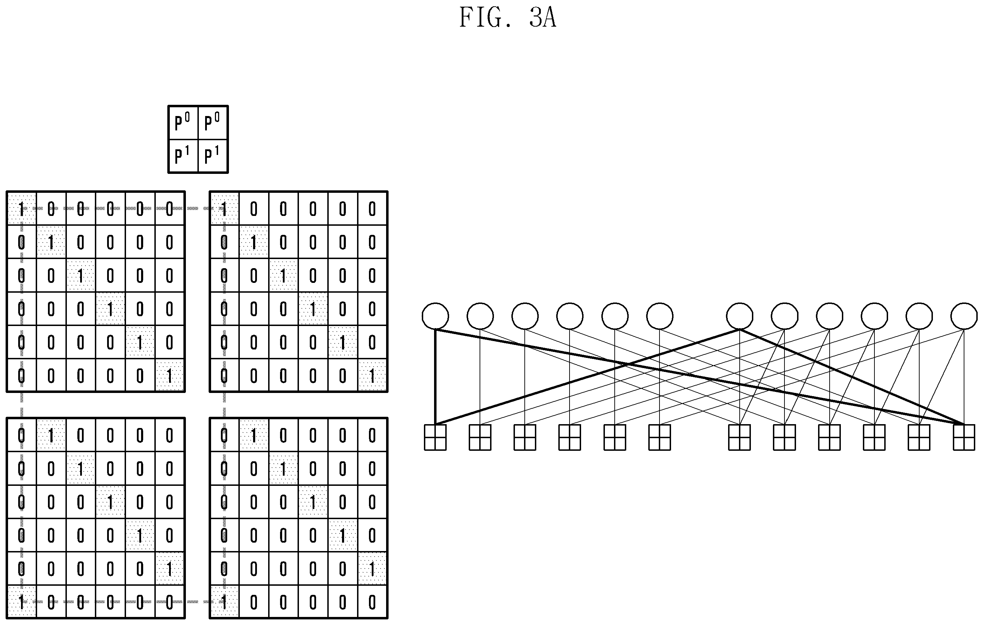

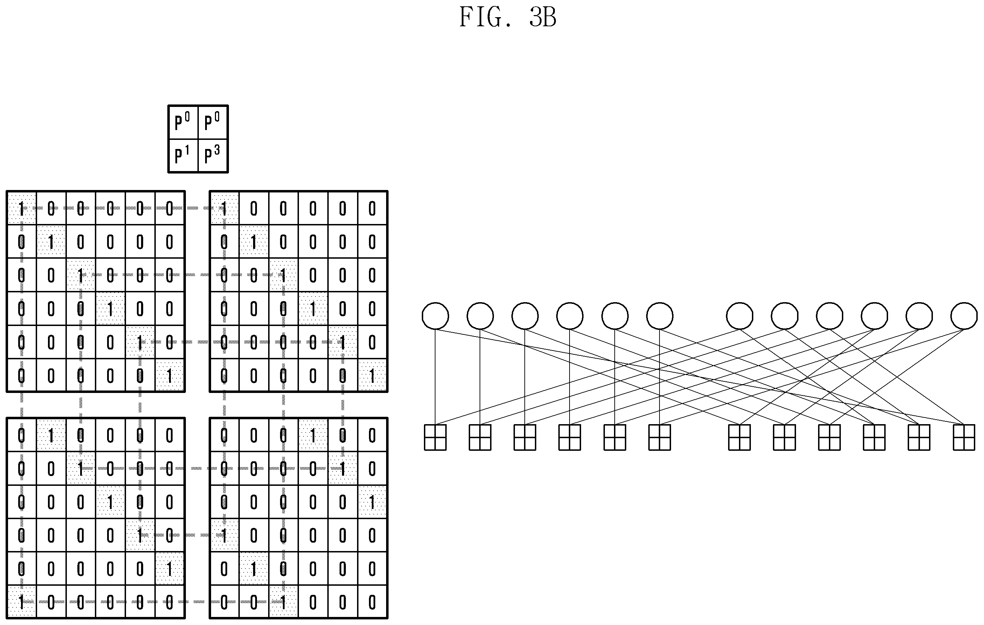

FIGS. 3A and 3B are diagrams simply illustrating that cycle characteristics may greatly differ according to an exponent matrix of a QC-LDPC code.

FIG. 3A is a diagram illustrating a cycle characteristic of a QC-LDPC code.

The exponent matrix in FIG. 3A is $\begin{bmatrix} P^0 & P^0 \\ P^1 & P^1 \end{bmatrix}_{(Z=6)}$, and in this case, a large number of 4-cycles may exist in the Tanner graph. Codes having many short cycles may cause serious degradation in decoding performance.

FIG. 3B is a diagram illustrating a cycle characteristic of a QC-LDPC code.

The exponent matrix of FIG. 3B is $\begin{bmatrix} P^0 & P^0 \\ P^1 & P^3 \end{bmatrix}_{(Z=6)}$ , and in this case, the length of the shortest cycle on the Tanner graph is 12. As described above, since only a change of one exponent of a circulant permutation matrix may significantly change the cycle characteristics on the Tanner graph, the selection of an exponent matrix plays an important role in improving the performance of an LDPC code. The lifting method may also be considered as one of the design methods that consider such cycle characteristics.

Generally, lifting may be considered as changing the values of the elements of the exponent matrix of Equation 4 for various Z values, and being used for LDPC encoding and decoding. For example, assuming that the exponent matrix of Equation 4 is $V(H) = (V_{i,j})$ and the exponent matrix transformed according to the Z value is $V(H(Z)) = (V_{i,j}(Z))$, a transformation formula such as Equation 11 may generally be applied.

[Equation 11]

$$V_{i,j}(Z) = \begin{cases} V_{i,j} & V_{i,j} < 0 \\ f(V_{i,j}, Z) & V_{i,j} \geq 0 \end{cases} \text{ or } V_{i,j}(Z) = \begin{cases} V_{i,j} & V_{i,j} \leq 0 \\ f(V_{i,j}, Z) & V_{i,j} > 0 \end{cases}$$

In Equation 11, $f(x, Z)$ may be defined in various forms. For example, Equation 9 may correspond to $f(x, Z) = \left\lfloor \dfrac{Z}{Z_{\max}} x \right\rfloor$ ($Z_{\max} = Z_S$), and Equation 10 may correspond to $f(x, Z) = \mathrm{mod}(x, Z)$ (where $\mathrm{mod}(a,b)$ indicates a modulo-b operation on a). In addition, $f(x, Z)$ may be defined by various methods, as shown in Equation 12 below.

[Equation 12]
$$f(x, Z) = \mathrm{mod}(x, 2^{\lfloor \log_2 Z \rfloor})$$

or

$$f(x, Z) = \left\lfloor \frac{x}{2^{D - \lfloor \log_2 Z \rfloor}} \right\rfloor$$

or

$$f(x, Z) = \left\lfloor \frac{Z}{D} x \right\rfloor$$

In Equation 12, D represents a constant which is a positive integer defined in advance.

For reference, in the transformation formula of Equation 11 above, a reference value (or a reference value of $V_{i,j}$ for distinguishing the application of $V_{i,j}$ and $f(V_{i,j}, Z)$) for applying the transformation formula (or the transformation function) f is shown as 0 for the sake of convenience, but the reference value may be differently configured depending on a method for representing a 0-matrix of size $Z \times Z$ or a lifting size Z value to be supported. For example, if a 0-matrix of size $Z \times Z$ is defined as a number or symbol other than the negative integer -1 that is predetermined, the reference value for applying the transformation formula f may be defined differently. Furthermore, when based on a method that excludes and does not denote exponents corresponding to 0 matrices in the representation of exponent matrices or LDPC sequences from the outset, the rules for exponents less than 0 in Equation 11 may be omitted. Since the transformation formula f is applied to a non-zero circulant permutation matrix or a circulant matrix, generally, there are various methods to express a method of omitting the transformation for a zero-matrix of size $Z \times Z$.

An example of applying LDPC encoding and decoding based on multiple exponent matrices or LDPC sequences based on one predetermined base matrix according to an embodiment of the disclosure will be described. That is, one base matrix is fixed, and an exponent matrix, a (circular) shift value matrix, or an LDPC sequence of an LDPC code defined based on the base matrix may be determined, and lifting is applied according to the lifting size included in each lifting size group from the matrix or sequence, thereby performing variable-length LDPC encoding and decoding. This method has the characteristic that elements or numbers constituting the exponent matrix or LDPC sequence of the LDPC code may have different values, but the positions of the corresponding elements or numbers are exactly the same on the base matrix.

The LDPC code defined in TS 38.212, a 3GPP 5G standard specification, is also a code designed in the same method and in this case, two base matrices $\mathbf{H_{BG}}$ are defined, and for each base matrix, 8 exponent matrices (or cyclic shift value matrices)   $V\left(\mathbf{H}_{i_{LS}}\right) = \left(V_{i,j}^{(i_{LS})}\right)$   ($i_{LS}$ = 0, 1, 2, ..., 7) are defined and may be used for LDPC encoding. That is, according to the standard specification, a total of 2 base matrices and 16 exponent matrices are defined, and various parity check matrices of LDPC codes may be determined based on appropriate lifting sizes $Z$. A matrix corresponding to $V(\mathbf{H}_{i_{LS}})$ is named as a parity check matrix in TS 38.212, and a matrix corresponding to a normal parity check matrix is named as matrix-$\mathbf{H}$. $V(\mathbf{H}_{i_{LS}})$ is a matrix of integers, and a parity check matrix in the strict sense may be constructed only when the lifting size $Z$ is specified, but as previously described, $V(\mathbf{H}_{i_{LS}})$ may also be referred to as the parity-checking matrix for convenience.

Hereinafter, for the convenience of description, the LDPC code and the expression method thereof defined in 3GPP 5G standard specification TS 38.212 will be used as much as possible, but may be expressed by conventional mathematical expressions or other methods in some cases. First, in order to determine the parity check matrix or matrix-$\mathbf{H}$ of the LDPC code, the lifting size ($Z$) to be supported is indicated in [Table 3] below. (Hereinafter, the set index $i_{LS}$ for each lifting size set is only an example, and the order may be changed.)

[Table 3]

| Set index ($i_{LS}$) | Set of lifting sizes (Z) |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

In the disclosure, the lifting size or a block size are basically expressed in the manner of [Table 3] below, but may be expressed in the manner of [Table 4] below, and various other expression methods are also possible.

[Table 4]

| Set index ($i_{LS}$) | Set of lifting sizes (Z) |
|---|---|
| 0 | $2 \times 2^k$, $k$ = 0, 1, 2, ... , 7 |
| 1 | $3 \times 2^k$, $k$ = 0, 1, 2, ... , 7 |
| 2 | $5 \times 2^k$, $k$ = 0, 1, 2, ... , 6 |
| 3 | $7 \times 2^k$, $k$ = 0, 1, 2, ... , 5 |
| 4 | $9 \times 2^k$, $k$ = 0, 1, 2, ... , 5 |
| 5 | $11 \times 2^k$, $k$ = 0, 1, 2, ... , 5 |
| 6 | $13 \times 2^k$, $k$ = 0, 1, 2, ..., 4 |
| 7 | $15 \times 2^k$, $k$ = 0, 1, 2, ... , 4 |

In 3GPP 5G, the lifting size or block size Z may be distinguished in multiple sets (or groups) and used as in [Table 3] or [Table 4] below. (hereinafter, it will be referred to as the set (or group) of lifting sizes or the set (or group) of block sizes will be referred to for the convenience)

In the 3GPP 5G standard, the parity check matrix or matrix-$\mathbf{H}$ is determined based on the exponent matrix $V(\mathbf{H}_{i_{LS}}(Z)) \equiv V(\mathbf{H}_{i_{LS}})$ (mod $Z$) obtained using the lifting method in [Equation 10]. This means that

$$V_{i,j}^{(i_{LS})}(Z) = \mathrm{mod}\left(V_{i,j}^{(i_{LS})}, Z\right)$$   is  satisfied  with  respect  to  i  and  j  when   $V\left(\mathbf{H}_{i_{LS}}\right) = \left(V_{i,j}^{(i_{LS})}\right)$   and

$$V\left(\mathbf{H}_{i_{LS}}(Z)\right) = \left(V_{i,j}^{(i_{LS})}(Z)\right)$$ are satisfied. (For reference, in the 3GPP 5G standard specification TS 38.212,

$V_{i,j}^{(i_{LS})}(Z)$ was simply expressed as $P_{i,j}$.)

As described in Equation 11 above, in the disclosure, it should be noted that no particular transformation is applied to a part corresponding to a 0-matrix of size $Z \times Z$ in the base matrix and the exponent matrix. That is, no particular transformation is performed to a part corresponding to a 0-matrix in $V(\mathbf{H}_{i_{LS}}(Z)) \equiv V(\mathbf{H}_{i_{LS}})$ (mod $Z$), unless otherwise particularly described, and only the size of the 0-matrix may be changed according to the value $Z$. As a specific example, in the expression methods used in the 3GPP 5G standard specifications, as shown in [Table 1] and [Table 2], the part corresponding to the 0-matrix of size $Z \times Z$ is not indicated from the outset, so if only $V_{i,j}$ included in [Table 1] or [Table 2] is appropriately transformed using a predefined transformation such as modulo, the part corresponding to the 0-matrix naturally remains untransformed, thus it is equivalent to defining a 0-matrix with only a different size. The above expression method is merely an example for convenience of description, and various other expression methods may exist.

Since the parity check matrix or the matrix-**H** may be variously transformed by a lifting size defined in [Table 3] for a given exponent matrix (or cyclic shift value matrix), the required lifting size set may be differently defined according to the system. That is, [Table 3] and [Table 4] are only examples, and all lifting size ($Z$) values included in the lifting size (or block size) group (or set) in [Table 3] and [Table 4] may be used, or a part of the lifting sizes may be selected and used according to situations required by the system, and additionally, more varied lifting size values may be added as necessary.

For example, when the minimum value of the transport block size (TBS) is 24, in practice, $Z = 2, 3, 4, 5, 6, 9$, and 13 are not used in the system. This case may be defined as [Table 5] by excluding some $Z$ values.

[Table 5]

| Set index ($i_{LS}$) | Set of lifting sizes ($Z$) |
|---|---|
| 0 | {8, 16, 32, 64, 128, 256} |
| 1 | {12, 24, 48, 96, 192, 384} |
| 2 | {10, 20, 40, 80, 160, 320} |
| 3 | {7, 14, 28, 56, 112, 224} |
| 4 | {18, 36, 72, 144, 288} |
| 5 | {11, 22, 44, 88, 176, 352} |
| 6 | {26, 52, 104, 208} |
| 7 | {15, 30, 60, 120, 240} |

In an LDPC code-based communication system to which the lifting size in [Table 5] is applied, the minimum lifting size is 7, and thus each column block constituting the parity check matrix of an LDPC code used for LDPC encoding and decoding may include at least 7 columns.

If the minimum value of TBS is 8 or more in consideration of future scalability, and if additional values such as 8 or 16 are used, a lifting size set (or block size group) may be changed as in [Table 6] below.

[Table 6]

| Set index ($i_{LS}$) | Set of lifting sizes ($Z$) |
|---|---|
| 0 | {4, 8, 16, 32, 64, 128, 256} |
| 1 | {6, 12, 24, 48, 96, 192, 384} |
| 2 | {(5,) 10, 20, 40, 80, 160, 320} |
| 3 | {7, 14, 28, 56, 112, 224} |
| 4 | {(9,) 18, 36, 72, 144, 288} |
| 5 | {11, 22, 44, 88, 176, 352} |
| 6 | {(13,) 26, 52, 104, 208} |
| 7 | {15, 30, 60, 120, 240} |

Here, [Table 6] shows only the case of Z = 2 or 3 in [Table 3 or 4], since the minimum value of Z that may be determined in case that the TBS is 8 or more is 4 or more.

As another example of a lifting size set configuration, when the lifting size set is classified as A sets, $Z_1, Z_2, Z_3, ...,$ $Z_A$, the A sets may be classified in the following basic manner. (k = 1, 2, ...)

$$Z_1 = \{A, 2A, ..., 2^k A\}$$
$$Z_2 = \{(A + 1), 2(A + 1), ..., 2^k(A + 1)\}$$
$$...$$
$$Z_i = \{(A + i - 1), 2(A + i - 1), ..., 2^k(A + i - 1)\}$$
$$...$$
$$Z_A = \{2A - 1, 2(2A - 1), ..., 2^k(2A - 1)\}$$

For example, the cases of A = 4 and A = 8 may be represented as in the following [Table 7-1] and [Table 7-2]. (k = 0,1, 2, ...)

[Table 7-1]

| Set of lifting sizes (Z) |
|---|
| 4, 8, 16, 32, ... (= 4 × 2$^k$) |
| 5, 10, 20, 40, ... (= 5 × 2$^k$) |
| 6, 12, 24, 48, ... (= 6 × 2$^k$) |
| 7, 14, 28, 56, ... (= 7 × 2$^k$) |

[Table 7-2]

| Set of lifting sizes (Z) |
|---|
| 8, 16, 32, 64, ... (= 8 × 2$^k$) |
| 9, 18, 36, 72, ... (= 9 × 2$^k$) |
| 10, 20, 40, 80, ... (= 10 × 2$^k$) |
| 11, 22, 44, 88, ... (= 11 × 2$^k$) |
| 12, 24, 48, 96, ... (= 12 × 2$^k$) |
| 13, 26, 52, 108, ... (= 13 × 2$^k$) |
| 14, 28, 56, 112, ... (= 14 × 2$^k$) |
| 15, 30, 60, 120, ... (= 15 × 2$^k$) |

When the lifting size set is defined in the manner as shown in [Table 7-1] and [Table 7-2], there is an advantage in that the distribution of Z values may be configured to be relatively uniform. Although all of the lifting size sets defined in [Table 7-1] and [Table 7-2] include the same number of Z values, an appropriate Z value may be further added or omitted for each set as needed. For example, it is possible to define the lifting size sets of [Tables 3] to [Tables 6] based on the lifting size sets of [Table 7-2].

In addition, in [Table 7-1] and [Table 7-2], a *k* value range may be appropriately configured to configure Z values suitable for the system. For example, when a value of *k* is configured as *k* = 0,1, ..., 6, a lifting size set in which the number of different Z values in each set is 7 is obtained, and when a value of *k* is configured as *k* = 3, 4, ... , 6, a lifting size set in which the number of different Z values in each set is 4 is obtained. However, the value of *k* is an example, and the value of *k* is not intended to limit the scope of the disclosure. In addition, in some cases, it is also possible to add a suitable Z value or exclude some Z values from the above lifting size sets. For example, if the maximum value of Z configured in the system is Zmax, all values greater than Zmax may be removed (e.g., Zmax = 768). In addition, if all Z values supported in the conventional 3GPP 5G standards are included, some of values of 2, 3, 4, 5, 6, 7, and the like may be further included. Of course, if 5G or 6G systems additionally support values such as TBS = 8 or 16, values of Z = 2 or 3 will not be used, and values such as 4, 6, 7 or 4, 5, 6, 7 may be additionally included, and values not used in 5G may be excluded. The following [Table 8] shows specific examples of a lifting size set. (The numbers in parentheses in [Table 8] may be used as a lifting size or may not be used.)

[Table 8]

| Set index ($i_{LS}$) | Set of lifting sizes (Z) |
|---|---|
| 0 | {(2, 4,) 8, 16, 32, 64, 128, 256, 512} |
| 1 | {(3, 6,) 12, 24, 48, 96, 192, 384, 768} |
| 2 | {(5,) 10, 20, 40, 80, 160, 320, 640} |
| 3 | {7, 14, 28, 56, 112, 224, 448(, 896)} |
| 4 | {(9,) 18, 36, 72, 144, 288, 576} |
| 5 | {11, 22, 44, 88, 176, 352, 704} |
| 6 | {(13,) 26, 52, 104, 208, 416(, 832)} |
| 7 | {15, 30, 60, 120, 240, 480(, 960)} |

The lifting size sets may be defined in various methods in addition to [Table 3] to [Table 8], but a common characteristic is that the multiple lifting size sets should not have overlapping lifting sizes, and the lifting sizes included in each lifting size set should have a multiple or factor relationship. [Table 3] to [Table 8] are composed of consecutive multiples of $2^k$ ($k = 0, 1, 2, ...$) for the smallest lifting size in each lifting size set, but in general, it is also possible to compose them with non-consecutive multiples of $2^k$ ($k = 0, 1, 3, 5, ...$) and to include multiples of other integers in addition to multiples of 2.

In a new communication system including the 6G system, a new lifting size set may be added (e.g., [Table 5] to [Table 8]) while maintaining the existing lifting size set as is in order to support backward compatibility for the existing system (e.g., 5G system) (e.g., [Table 3] or [Table 4]). Alternatively, the lifting size set may be defined as one, and the range of the TBS used may be determined differently in advance according to the system configuration such as the application scenario or the target BLER, and thus the range of the Z values used also differs. For example, in case that a first minimum TBS and a first maximum TBS value are configured for a service to which a first target BLER is applied, and a second minimum TBS and/or a second maximum TBS value is defined for a service to which a second target BLER is applied, the first minimum TBS and the second minimum TBS may be different from each other, or the first maximum TBS and the second maximum TBS may be different from each other (the minimum and maximum values may both be different).

In addition, the applied service scenario, target BLER and the like may be determined based on upper layer signaling information. For example, generally, a CQI table or a MCS table may be determined in consideration of a target service scenario or BLERS. (For example, a first CQI table and/or a first MCS table may be determined in consideration of a first target service or BLER, a second CQI table and/or a second MCS table in consideration of a second target service or BLER, a third CQI table and/or a third MCS table in consideration of a third target service or BLER, ...)

This means that the range of lifting sizes to be used or a set of lifting sizes to be used may be determined from higher layer signaling information, and there may be various methods for intermediate operations according to the system. In addition, the lifting size set to be used may be indicated through physical layer signaling or higher layer signaling. A parity check matrix may be determined based on the indicated lifting size set and the determined lifting size Z value.

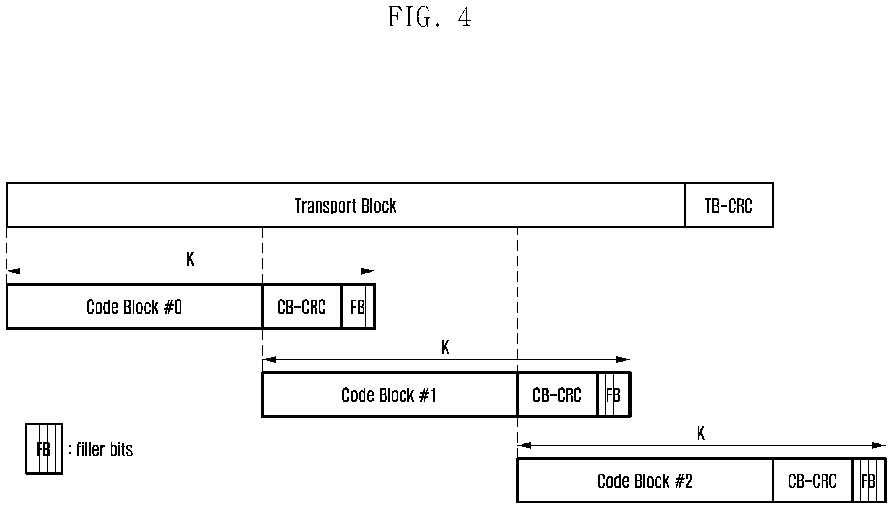

FIG. 4 is a diagram illustrating a transport block structure according to an embodiment of the disclosure.

Referring to FIG. 4, an L-bit CRC bit (TB-CRC bit) is added to a transport block composed of A bits, and one transport block may be one code block. In addition, when the value of B = A + L is larger than a specific threshold, a suitable segmentation process may be performed so as to divide the same into multiple code blocks. In this case, the size K of the code block is the same for all code blocks, and for this, specific bits called null bits or filler bits may be added for each code block. The null bit or filler bits may correspond to a value of 0 in the normal case, but they are not necessarily limited thereto, and may be constituted by any particular bits predetermined. The operation of adding bits determined in advance, such as a null bit or filler, as described above is referred to as shortening, since the size of the actual pure information word bits is reduced, and may also be referred to as zero-padding when the values are 0.

After the transport block size (TBS) of the transport block to be transmitted is determined, one of base matrices of two different LDPC codes used for LDPC encoding or decoding may be determined, based on the TBS size and the code rate indicated by the MCS, through a method such as the [Method for determining base matrix] below.

**[Method for determining base matrix]**

The LDPC base matrix for LDPC encoding and decoding of a transport block satisfying TBS = A may be determined based on the TBS size and the code rate indicated by the MCS as follows:

If $A \leq 292$ (or 288), or if $A \leq 3824$ and $R \leq 0.67$, or if $R \leq 0.25$, LDPC encoding may be performed by using LDPC base matrix 2.

Otherwise, LDPC encoding may be performed using LDPC base matrix 1. For reference, base matrix 1 $M(\mathbf{H}_{BG1})$ and base matrix 2 $M(\mathbf{H}_{BG2})$ defined in the 3GPP 5G standard are as follows:

$$M(\mathbf{H}_{BG1}):$$

0 1 2 3 5 6 9 10 11 12 13 15 16 18 19 20 21 22 23

0 2 3 4 5 7 8 9 11 12 14 15 16 17 19 21 22 23 24

0 1 2 4 5 6 7 8 9 10 13 14 15 17 18 19 20 24 25

0 1 3 4 6 7 8 10 11 12 13 14 16 17 18 20 21 22 25

0 1 26

0 1 3 12 16 21 22 27

0 6 10 11 13 17 18 20 28

0 1 4 7 8 14 29

0 1 3 12 16 19 21 22 24 30

0 1 10 11 13 17 18 20 31

1 2 4 7 8 14 32

0 1 12 16 21 22 23 33

0 1 10 11 13 18 34

0 3 7 20 23 35

0 12 15 16 17 21 36

0 1 10 13 18 25 37

1 3 11 20 22 38

0 14 16 17 21 39

1 12 13 18 19 40

0 1 7 8 10 41

0 3 9 11 22 42

1 5 16 20 21 43

0 12 13 17 44

1 2 10 18 45

0 3 4 11 22 46

1 6 7 14 47

0 2 4 15 48

1 6 8 49

0 4 19 21 50

1 14 18 25 51

0 10 13 24 52

1 7 22 25 53

0 12 14 24 54

1 2 11 21 55

0 7 15 17 56

1 6 12 22 57

0 14 15 18 58

1 13 23 59

0 9 10 12 60

1 3 7 19 61

0 8 17 62

1 3 9 18 63

0 4 24 64

1 16 18 25 65

0 7 9 22 66

1 6 10 67

$M(\mathbf{H}_{BG2})$:

0 1 2 3 6 9 10 11

0 3 4 5 6 7 8 9 11 12

0 1 3 4 8 10 12 13

1 2 4 5 6 7 8 9 10 13

0 1 11 14

0 1 5 7 11 15

0 5 7 9 11 16

1 5 7 11 13 17

0 1 12 18

1 8 10 11 19

0 1 6 7 20

0 7 9 13 21

1 3 11 22

0 1 8 13 23

1 6 11 13 24

0 10 11 25

1 9 11 12 26

1 5 11 12 27

0 6 7 28

0 1 10 29

1 4 11 30

0 8 13 31

1 2 32

0 3 5 33

1 2 9 34

0 5 35

2 7 12 13 36

0 6 37

1 2 5 38

0 4 39

2 5 7 9 40

1 13 41

0 5 12 42

2 7 10 43

0 12 13 44

1 5 11 45

0 2 7 46

10 13 47

1 5 11 48

0 7 12 49

2 10 13 50

1 5 11 51

The sizes of base matrix 1 $M(\mathbf{H}_{BG1})$ and base matrix 2 $M(\mathbf{H}_{BH2})$ are $46\times68$ and $42\times52$, respectively, and the size of the parity check matrix determined from the base matrices is $46Z\times68Z$ and $42Z\times52Z$, respectively.

In addition, the number ($L_{TB}$) of CRC bits to be added to the transport block according to the determined TBS may be determined as follows.

**[Method for determining the number of transport block CRC bits]**

The value of the CRC bit size, $L_{TB}$, for a transport block satisfying TBS = A may be configured differently according to the value of TBS as follows.

If A > 3824, $L_{TB}$ = 24; otherwise, $L_{TB}$ = 16.

In this way, based on the determined TBS size A or the total bit count B = A + L after appending the CRC to the transport block, appropriate code blocks may be determined from the transport block, and LDPC encoding and decoding may be performed for each code block. The process of determining the code block size (CBS) will be described in more detail.

**[Method for determining CBS]**

An input bit sequence for code block segmentation may be expressed as $b_0$, $b_1$, ..., $b_{B-1}$. (B > 0) If B is larger than the maximum code block size $K_{cb}$, segmentation of the input bit sequence is performed, and an additional L = 24-bit CRC is added to each code block. For LDPC base matrix 1, a maximum code block size is $K_{cb}$ = 8448, and for LDPC base matrix 2, a maximum code block size is $K_{cb}$ = 3840.

The specific steps will be described below.

Step 1: The number $C$ of code blocks may be determined.

If $B \leq K_{cb}$ satisfied, $L = 0$ and C = 1 are satisfied, and $B' = B$ is satisfied.

Otherwise, $L = 24$ and $C = \lceil B/(K_{cb} - L) \rceil$ are satisfied, and $B' = B + C \times L$ is satisfied.

Step 2: When a bit output from the code block segmentation is denoted as $c_{r0}$, $c_{r1}$,..., $cr_{(Kr-1)}$, r may denote a code block number ($0 \leq r < C$), and Kr (= K) may denote the number of bits of the code block for the code block number r. The number K of bits included in each code block may be calculated as follows:

$$K' = B'/C;$$

In the case of LDPC base matrix 1, $K_b$ = 22 is true.
In the case of LDPC base matrix 2,

$B > 640$ is satisfied, $K_b$ = 10;
$560 < B \leq 640$ is satisfied, $K_b$ = 9;
$192 < B \leq 560$ is satisfied, $K_b$ = 8;
$B \leq 192$ is satisfied, $K_b$ = 6.

Step 3: A minimum value $Z_c$ satisfying $K_b \cdot Z_c \geq K'$ may be determined from the values $Z$ in Table 3. With regard to LDPC base matrix 1, $K = 22Z_c$ is configured, and with regard to LDPC base matrix 2, $K = 10Z_c$ is configured.

In step 2 of [Method for determining CBS], the value $K_b$ may be a value corresponding to a column or a column block corresponding to an LDPC information word bit (information bit) in a base matrix (or base graph) or a parity check matrix of an LDPC code, and may correspond to a maximum value (= $K_b Z_c$) of an LDPC information word bit without shortening or zero padding. For example, even if the number of columns (or column blocks) corresponding to information word bits in the LDPC base matrix 2 or the parity check matrix corresponding to base matrix 2 is 10, if $K_b$ = 6 is configured, LDPC encoding/decoding for information word bits of maximum $6Z_c$ bits is substantially performed, and the information word bits corresponding to at least $(10 - K_b)Z_c = 4Z_c$ columns in the parity check matrix are shortened or zero-padded. Here, shortening or zero padding may mean that a transmitter and a receiver are prearranged to assign a bit value of 0, and may mean that a corresponding part in the parity check matrix is not used.

The lifting size $Z$ value for LDPC encoding and decoding may be determined based on lifting size sets indicated in Tables 3 to 8 or lifting size sets to or from which specific lifting size values are added or removed. Each $Z$ value is included in a particular set determined in advance according to the index $i_{LS}$. In step 3 of [Method for determining CBS], when the $Z$ value is determined, a corresponding set or an index $i_{LS}$ value of the set corresponding to the $Z$ value is determined, and a parity check matrix of an LDPC code corresponding to each index or a sequence corresponding thereto may also be determined. Based on the determined parity check matrix of the LDPC code or the corresponding sequence, a modulo operation based on a lifting size $Z$ is applied to the parity check matrix or the sequence to transform the same, thereby supporting encoding and decoding of LDPC codes of various lengths. In the 3GPP 5G standard, each number included in the parity check matrix of the LDPC code or the sequence also indicates a value corresponding to a circulant permutation matrix.

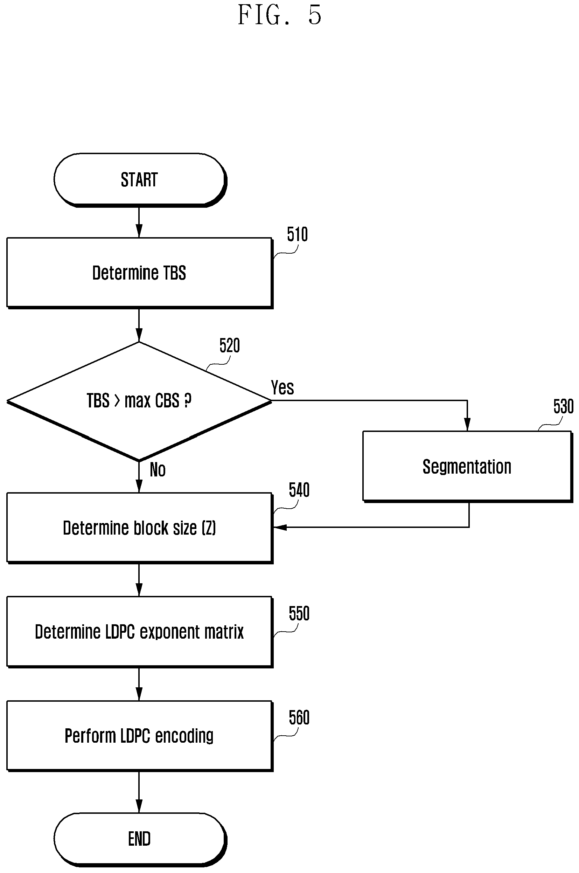

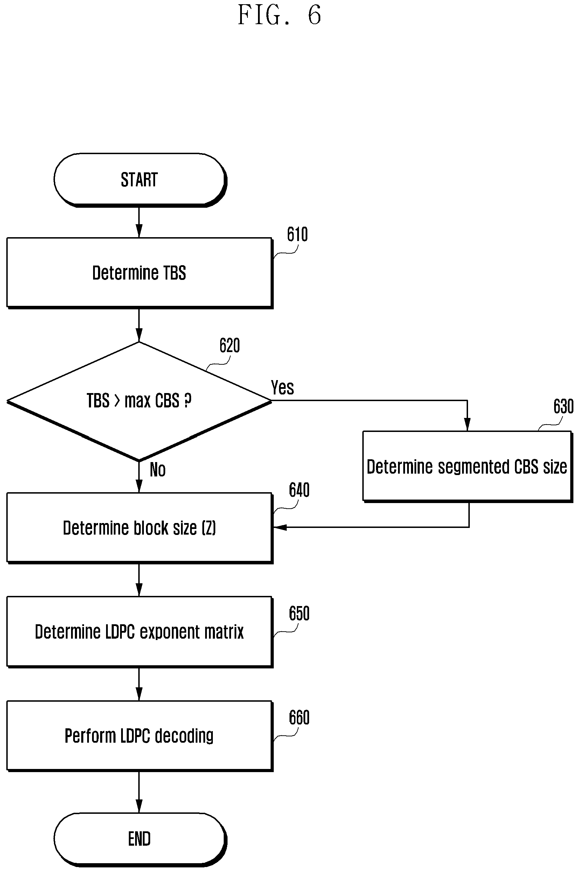

FIG. 5 and FIG. 6 show flowcharts illustrating an example of an LDPC encoding and decoding process based on a designed base matrix or exponent matrix.

FIG. 5 is a diagram illustrating an embodiment of an LDPC encoding process.

First, the transmitter determines a transport block size (TBS) to be transmitted as in step 510 of FIG. 5. In step 520, the transmitter determines whether the TBS is greater than or less than or equal to the max CBS.

If the TBS is larger than the max CBS, the transmitter may determine the CBS by segmenting the transport block in step 530. In case that the TBS is equal to or smaller than the max CBS, the transmitter omits the segmentation operation and determines the TBS as the CBS.

The transmitter determines the lifting size (Z) value to be applied to LDPC encoding, based on the CBS, in step 540.

Then, the transmitter determines a parity check matrix or a sequence according to the TBS, CBS, or lifting size (Z) value in step 550. Alternatively, the transmitter may determine an LDPC exponent matrix or sequence that has the same algebraic effect as the parity check matrix.

In addition, the transmitter performs LDPC encoding, based on the parity check matrix or the sequence, in step 560. Alternatively, the transmitter may perform LDPC encoding based on the exponent matrix or sequence in step 560. In addition, the transmitter may perform LDPC encoding, based on the lifting size and the exponent matrix or sequence, in step 560.

For reference, step 550 may include a process of transforming the determined LDPC exponent matrix or sequence, based on the determined lifting size in some cases. It is apparent that the LDPC exponent matrix or sequence, or the parity check matrix for LDPC encoding may be determined in various methods based on the TBS or CBS according to a system. For example, the transmitter may first determine a base matrix through the TBS, and then determine the LDPC exponent matrix or the parity check matrix based on the determined base matrix and the CBS, and various other methods may also be applied. For reference, between step 520 and step 540 or between step 530 and step 540, additional operations may be included depending on the system. For example, in the 3GPP 5G system, when the base matrix 2 ($M$ ($H_{BG2}$)) is used, the process of determining a value $K_b$ representing the number of columns actually used in the base matrix or the number of column blocks used in the parity check matrix according to the TBS size may be included. (For reference, the column block of the parity check matrix corresponding to the column of the $(10 - K_b)$ base matrices has shortening applied thereto.

Similarly, the LDPC decoding process may also be represented as in FIG. 6.

FIG. 6 is a diagram illustrating an embodiment of an LDPC decoding process.

If the TBS is determined in step 610, the receiver determines, in step 620, whether the TBS is greater than or less than or equal to the max CBS.

If the TBS is larger than the max CBS, the receiver determines the size of a CBS to which segmentation has been applied in step 630. If it is determined that the TBS is equal to or smaller than the max CBS, the TBS is immediately determined to be identical to the CBS.

The receiver determines a lifting size (Z) value to be applied to LDPC decoding in step 640.

Then, the receiver determines a parity check matrix or a sequence according to the TBS, CBS, or lifting size (Z) value in step 650. Alternatively, the transmitter may determine an exponent matrix or sequence that has the same algebraic effect as the parity check matrix.

In addition, the receiver may perform LDPC decoding based on the parity check matrix or sequence in step 660. Alternatively, the receiver may perform LDPC decoding by using an exponent matrix or sequence in step 660. For reference, step 650 may include a process of transforming the determined LDPC exponent matrix or sequence, based on the determined lifting size in some cases. It is apparent that the LDPC exponent matrix or sequence, or the parity check matrix for LDPC decoding may be determined in various methods based on the TBS or CBS according to a system. For example, the receiver may first determine a base matrix through the TBS, and then determine the LDPC exponent matrix or the parity check matrix based on the determined base matrix and the CBS, and various other methods may also be applied.

According to the embodiment described above, in steps 550 and 650 of FIGS. 5 and 6, the process of determining the exponent matrix or sequence of the LDPC code has been described with respect to the case where the exponent matrix or sequence is determined by one of the TBS, the CBS, or the lifting size (Z), but various other methods may also exist. In addition, between step 620 and step 640 or between step 630 and step 640 of FIG. 6, additional operations may be included depending on the system. For example, in the 3GPP 5G system, when the base matrix 2 ($M(\mathbf{H}_{BG2})$) is used, the process of determining a value $K_b$ representing the number of columns actually used in the base matrix or the number of column blocks used in the parity check matrix according to the TBS size may be included. For reference, the receiver may recognize that the bits corresponding to the column block of the parity check matrix corresponding to the column of ($10 - K_b$) base matrices have been shortened by the transmitter, and thus the receiver may additionally perform an appropriate operation on the shortened bits before performing LDPC decoding.

In the embodiments of the LDPC encoding and decoding processes based on the base matrix and the exponent matrix (or LDPC sequence) of the LDPC code in FIGS. 5 and 6, some of the information word bits of the LDPC code may be shortened or punctured, and some of the codeword bits may be punctured and repeated, thereby supporting the LDPC encoding and decoding with various code rates and various lengths. For example, in the LDPC encoding process of FIG. 5, as in the 3GPP 5G standard technology, shortening may be applied to some information word bits, some information word bits corresponding to the first two columns of the base matrix, that is, the first $2Z_c$ columns of the parity check matrix may be punctured, some parity bits may be punctured, or some of the LDPC codewords may be repeated, thereby supporting various information word bit lengths (or code block lengths) and various code rates.

When an input bit or a code block bit is denoted as $i_0, i_1, i_2, ..., i_{K-1}$ and an encoding bit is denoted as $d_0, d_1, d_2, ..., d_{N-1}$ (where $N = 66Z_c$ in the case of base matrix 1 and $N = 50Z_c$ in the case of base matrix 2), a part of the encoding process may be defined as in [Table 9] below.

[Table 9]

$$\text{for } k = 2Z_c \text{ to } K - 1$$
$$\text{if } i_k \neq < NULL >$$
$$d_{k-2Z_c} = i_k;$$
$$\text{else}$$
$$i_k = 0;$$
$$d_{k-2Z_c} = < NULL >;$$
$$\text{end if}$$
$$\text{end for}$$

According to the above encoding process, the first $2Z_c$ bits $i_0, i_1, i_2, ..., i_{2Z_c-1}$ among the input bits or code block bits are not included in the encoded bits. That is, it indicates that the $2Z_c$ bits are punctured in the transmitter and are not transmitted to the receiver. For reference, if some of the information word bits are punctured, this may indicate that a part of the information word 102 in FIG. 1 is not transmitted by the transmitter, and thus the receiver may process the information word bits not transmitted as erased and perform decoding. In other words, the punctured bits are considered as if they are lost, and thus the receiver may insert a corresponding value and perform demodulation because the probability of 0 and 1 is the same.

Information word bits punctured in the encoding process may not be transmitted even in the case of retransmission. When a circular buffer is used for rate matching, if the punctured information word bits are not stored in the circular buffer and rate matching and retransmission are performed, the punctured information word bits may not always be transmitted.

On the other hand, in the case of initial transmission, some of the information word bits may be punctured, and in the case of retransmission, all or some of the punctured information word bits may be transmitted. All information word bits may be stored in the circular buffer, and for the initial transmission, a redundancy value (RV) may be appropriately configured so that a part of the information word bits is punctured (e.g., RV0 is configured by excluding information word bits to be punctured). Even if some of the information word bits were punctured in the initial transmission, since bit values thereof are stored in the circular buffer, during retransmission, depending on the circular buffer rate matching operation and the selection of an appropriate RV value, some or all of the punctured information word bits may be transmitted.

For the convenience of description, $d_0, d_1, d_2, ..., d_{N-1}$ is referred to as the encoded bit in [Table 9], but the definition of the encoded bit may be changed for the convenience of description. For example, as $d_0, d_1, d_2, ..., d_{N-1}$ in [Table 9], a bit string after some information word bits are punctured may be defined as an encoded bit, but in an actual encoding process, the parity bit vector $\underline{w}$ is generated by using the input bits or code block bits $i_0, i_1, i_2, ..., i_{K-1}$ and thus, $(\underline{i}, \underline{w})$ = $(i_0, i_1, i_2, ..., i_{K_{ldpc}-1}, w_0, w_1, w_2, ..., w_{N_{ldpc}-K_{ldpc}-1})$ may be defined as the encoded bit, based on the information word bits before puncturing. In addition, a bit string $e_0, e_1, e_2, ..., e_{E-1}$ to which rate matching has been applied, based on an allocated resource amount, may be defined as an encoded bit, and a bit string $f_0, f_1, f_2, ..., f_{E-1}$ to which interleaving has been applied with regard to the rate-matched bit string, may also be defined as an encoded bit. In addition, an encode bit string may be variously defined for the convenience of description, but in general, although a bit string related to actual transmission in a system is $d_0, d_1, d_2, ..., d_{N-1}$, but $(\underline{i}, \underline{w})$ related to an encoding process may be defined as an encoded bit.

In the LDPC decoding process in FIG. 6, in order to correspond to the transmitter operations, appropriate operations with regard to the shortened information word bits and punctured bits or repeated bits may be additionally performed to perform decoding. In general, the shortened information word bits are 0, and the receiver may perform decoding by excluding columns corresponding to the shortened bits from the parity check matrix, or may perform decoding by configuring a value preconfigured by the system for the shortened bits. (Since the shortened information word bits are definitely 0, a highest value corresponding to 0 normally configured in the system is configured.) The punctured parity bits are considered lost, with an equal probability of being 0 or 1, so the receiver may perform decoding by inserting the corresponding value, or depending on the structure of the parity check matrix, may perform decoding without using at least some of the rows corresponding to the punctured parity bits. Generally, when the parity bit corresponding to a column of degree 1 is punctured, the LDPC decoder may perform decoding without using part or all of a corresponding part in the parity check matrix, resulting in the advantage of reduced decoding complexity.

In addition, when variable information word length or variable code rate is supported by using shortening or zero-padding of the LDPC code, the performance of the code may be improved according to the shortening order or the shortening method. If a shortening order is configured, by appropriately rearranging a part or the entire order of a given base matrix, the encoding performance may be improved. Additionally, performance may be improved by appropriately determining the number of column blocks to which lifting size or shortening will be applied for a specific information word length (or code block size CBS). Similarly, there is a method of improving the performance of an LDPC code by adjusting the puncturing order of parity bits or the transmission order of the generated LDPC codewords. For example, the performance may be improved by appropriately puncturing some of the information word bits and the parity bits rather than simply puncturing the parity bits to support a variable code rate. In addition, when some of the LDPC codewords are repeated to support a lower encoding rate, the order of repetition may be determined in advance to improve the LDPC encoding performance.

Typically, in the LDPC encoding process, the transmitter first determines the size of the input bits (or code block) to which LDPC encoding will be applied, then determines the lifting size Z for applying LDPC encoding based on the size, then determines an appropriate LDPC exponent matrix or sequence based on the lifting size, and performs LDPC encoding based on the lifting size Z and the determined exponent matrix or sequence. In this case, the LDPC exponent matrix or sequence may be applied to LDPC encoding without transformation, or the LDPC exponent matrix or sequence may be appropriately transformed according to the lifting size Z to perform LDPC encoding.

Similarly, in the LDPC decoding process, the receiver determines the size of the input bits (or code block) for the transmitted LDPC codeword, then determines the lifting size Z to be applied to the LDPC decoding according to the size, then determines a suitable LDPC exponent matrix or sequence according to the lifting size Z, and performs LDPC decoding, based on the lifting size Z and the determined exponent matrix or LDPC sequence. In this case, the LDPC exponent matrix or sequence may be applied to LDPC decoding without transformation, or the LDPC exponent matrix or sequence may be appropriately transformed according to the lifting size Z to perform LDPC decoding.

A submatrix corresponding to a parity bit in the parity check matrix may often have a special structure for efficient encoding. In this case, the encoding method or the complexity may change due to the lifting. Therefore, to maintain the same encoding method or complexity, lifting may not be applied to some parts of the exponent matrix for the submatrix corresponding to the parity in the parity check matrix, or lifting methods different from those applied to the exponent matrix for the submatrix corresponding to the information word bits may be applied. In other words, in the exponent matrix, the lifting method to be applied to the sequence corresponding to the information word bits and the lifting method to be applied to the sequence corresponding to the parity bits may be configured differently, and in some cases, no lifting may be applied to a part or the entire sequence corresponding to the parity bits, and a fixed value may be used without sequence transformation.

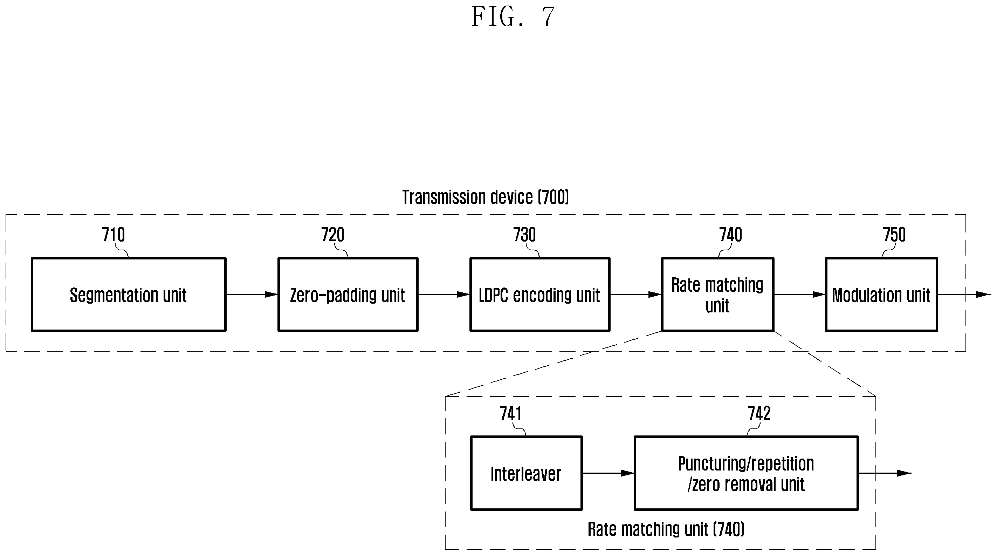

FIG. 7 is a block diagram of a transmission device according to an embodiment of the disclosure.

Specifically, as shown in FIG. 7, a transmission device 700 may include a segmentation unit 710, a zero-padding unit 720, an LDPC encoding unit 730, a rate matching unit 740, and a modulation unit 750 to process variable-length input bits. The rate matching unit 740 may include an interleaver 741, a puncturing/repetition/zero removal unit 742, and the like.

The elements illustrated in FIG. 7 are elements that perform encoding and modulation for variable-length input bits, and this is only an example. Some of the elements illustrated in FIG. 7 may be omitted or changed depending on the case, and other elements may be further added.

Meanwhile, the transmission device 700 may determine necessary parameters (e.g., at least one of an input bit length, a modulation and code rate (ModCod), a parameter for zero padding (or shortening), a code rate/code length of an LDPC code, a parameter for interleaving, a parameter for repetition and puncturing, and a modulation scheme), encode input bits based on the determined parameters, and then transmit the same to a reception device 800.

In terms of the number of input bits being variable, when the number of input bits is greater than a preconfigured value, the input bits may be segmented to have a length less than or equal to the predetermined value. In addition, each of the segmented blocks may correspond to one LDPC-coded block. However, in case that the number of input bits is less than or equal to a preconfigured value, the input bits may not be subject to segmentation, and the input bits may correspond to one LDPC-coded block.

Meanwhile, the transmission device 700 may store various parameters used for encoding, interleaving, and modulation. The parameters used for encoding may include at least one of a code rate of the LDPC code, a codeword length, and information on a parity check matrix. In addition, the parameter used for interleaving may include information regarding an interleaving rule, and the parameter used for modulation may include information regarding a modulation scheme. In addition, information regarding puncturing may include a puncturing length. The information regarding repetition may include a repetition length. The information regarding the parity check matrix may include an exponent value or a value equivalent to the exponent value in an algebraic sense when the parity matrix presented in the disclosure is used.

In this case, each component constituting the transmission device 700 may perform operations by using these parameters.

Meanwhile, although not illustrated, the transmission device 700 may further include a controller (not illustrated) for controlling the operation of the transmission device 700, depending on the case.

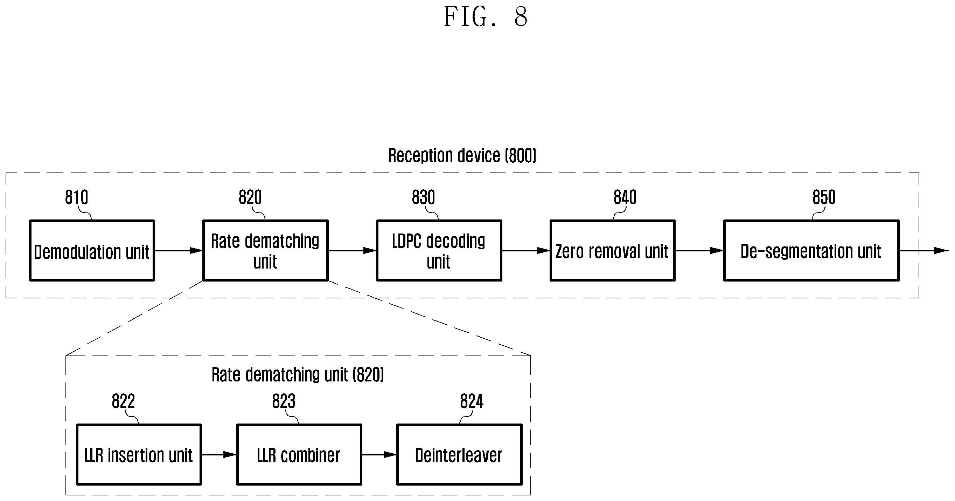

FIG. 8 is a block diagram of a reception device according to an embodiment of the disclosure.

Specifically, as shown in FIG. 8, a reception device 800 may include a demodulation unit 810, a rate dematching unit 820, an LDPC decoding unit 830, a zero removal unit 840, and a de-segmentation unit 850 in order to process variable-length information. The rate dematching unit 820 may include a log likelihood ratio (LLR) insertion unit 822, an LLR combiner 823, a deinterleaver 824, and the like.

Here, the components illustrated in FIG. 8 are components that perform the functions corresponding to the components in FIG. 8, and this is only an example, and some may be omitted or changed according to the case, and other components may be further added.

The parity check matrix of the disclosure may be read out by using a memory, may be predetermined in the transmission device or the reception device, or may be directly generated in the transmission device or the reception device. In addition, the transmission device may store or generate a sequence, an exponent matrix, or an algebraically equivalent value corresponding to the parity check matrix, and apply same to encoding. Similarly, the reception device may also store or generate a sequence, an exponent matrix, or an algebraically equivalent value corresponding to the parity check matrix and apply same to decoding.

Hereinafter, a detailed description of the receiver operation will be given based on FIG. 8.

The demodulation unit 810 demodulates a signal received from the transmission device 700.

Specifically, the demodulation unit 810 may be a component corresponding to the modulation unit 750 of the transmission device 700, and may demodulate a signal received from the transmission device 700 to generate values corresponding to bits transmitted by the transmission device 700.

To this end, the reception device 800 may determine a parameter (e.g., at least one of an input bit length, a modulation and code rate (ModCod), a parameter for zero padding (or shortening), a code rate/code word length of an LDPC code, a parameter for interleaving, and a parameter for repetition and puncturing, and a modulation scheme) necessary for demodulation and decoding, and the demodulation unit 810 may perform a decoding process in which the signal received from the transmission device 700 is demodulated according to a mode, thereby generating values corresponding to the LDPC codeword bits, based on the determined parameter.

Meanwhile, values corresponding to the bits transmitted from the transmission device 700 may be likelihood ratio (LR) values or log likelihood ratio (LLR) values.

Specifically, the LR value may refer to a ratio of the probability that the bit transmitted by the transmission device 700 is 0 to the probability that the bit transmitted by the transmission device 700 is 1, and the LLR value may be expressed as a value obtained by taking a logarithm of the ratio of the probability that the bit transmitted by the transmission device 700 is 0 to the probability that the bit transmitted by the transmission device 700 is 1. Alternatively, the LR or LLR value may be determined according to the probability, the ratio of the probability, or the log value of the ratio of the probability, and may be indicated by the bit value itself, or the LR or LLR value may be indicated by a representative value previously defined according to the interval in which the probability, the ratio of the probability, or the log value of the ratio of the probability is located. As an example of the method of determining a predefined representative value according to an interval to which the probability or the ratio of probabilities or the log value of the ratio of probabilities belongs, there is a method considering quantization or the like. In addition, various other values corresponding to the probability, the ratio of the probability, or the log value of the ratio of the probability may be used.

In the disclosure, for convenience in describing the operation of the reception method and the device, an operation based on the LLR value is represented, but the disclosure is not limited thereto.

The demodulation unit 810 may include a function of performing multiplexing (not shown) with regard to the LLR values. Specifically, a MUX (not shown) is a component corresponding to a bit DeMUX (not shown) of the transmission device 700 and may perform an operation corresponding to the bit DeMUX (not shown).

To this end, the reception device 800 may store information regarding parameters used by the transmission device 700 for demultiplexing and block interleaving. Accordingly, the MUX (not shown) may perform the reverse demultiplexing and block interleaving operations performed in the bit DeMUX (not shown) on the LLR valuescorresponding to cell words (information representing a reception symbol for the LDPC codeword as vector values), thereby multiplexing the LLR values corresponding to the cell words on a bit-by-bit basis.

The rate dematching unit 820 may additionally insert an LLR value into the LLR values output from the demodulation unit 810. In this case, the dematching unit 820 may insert pre-arranged LLR values between the LLR values output from the demodulation unit 810.

Specifically, the rate dematching unit 820 may be an element corresponding to the rate matching unit 740 of the transmission device 700, and may perform an operation corresponding to the interleaver 741 and the zero-removal and puncturing/repetition/zero-removal unit 742.

First, the rate dematching unit 820 performs deinterleaving to correspond to the interleaver 741 of the transmitter. The LLR insertion unit 822 may insert an LLR value corresponding to a zero bit into a position where a zero bit has been padded in an LDPC codeword from among the output values of the deinterleaver 824. In this case, the LLR values corresponding to the padded zero bits, that is, the zero bits having been shortened may be $\infty$ or $-\infty$. However, $\infty$ or $-\infty$ are theoretical values, and in practice, they may be the maximum or minimum values of the LLR values used in the reception device 800.

To this end, the reception device 800 may store information regarding the parameter used by the transmission device 700 to pad zero bits. Accordingly, the rate dematching unit 820 may determine a position where zero bits have been padded in the LDPC codeword, and insert an LLR value corresponding to a shortened zero bit in the corresponding position.

In addition, the LLR insertion unit 822 of the rate dematching unit 820 may insert LLR values corresponding to punctured bits into locations of the punctured bits in the LDPC codeword. In this case, the LLR values corresponding to the punctured bits may be 0 or other values predetermined. In general, if parity bits of degree 1 are punctured, since there is no effect on performance improvement in the LDPC decoding process, a part or all of the corresponding puncturing positions may not be used in the LDPC decoding process without LLR insertion. However, in order to improve the efficiency of the LDPC decoding process based on parallel processing, the LLR insertion unit 822 may insert a predetermined LLR value to a position corresponding to some or all of the puncturing bits of degree 1 regardless of decoding performance improvement.

To this end, the reception device 800 may store information on parameters used by the transmission device 700 for puncturing. Accordingly, the LLR insertion unit 822 may insert a corresponding LLR value (e.g., LLR = 0) to a position at which an LDPC information word bit or a parity bit has been punctured. However, this process may be omitted for positions of some punctured parity bits.

The LLR combiner 823 may combine, that is, sum, the LLR values output from the LLR insertion unit 822 and the demodulation unit 810. Specifically, the LLR combiner 823 may be a component corresponding to the puncturing/ repetition/zero removal unit 742 of the transmission device 700, and may perform an operation corresponding to the repetition unit 742. First, the LLR combiner 823 may combine an LLR value corresponding to a repeated bit with another LLR value. Here, the other LLR values may be LLR values for the bits that served as the basis for generating the repeated bits by the transmission device 700, that is, the LLR values for the LDPC information word bits or parity bits that were selected for repetition.

That is, as described above, the transmission device 700 selects LDPC code bits, repeats same between LDPC information word bits and LDPC parity bits, and transmits same to the reception device 800. Accordingly, the LLR values for the LDPC-encoded bits may be configured by the LLR values for the repeated LDPC-encoded bits and the LLR values for the non-repeated LDPC-encoded bits. The LLR combiner 823 may combine LLR values for the same LDPC code bits.

To this end, the reception device 800 may store information on parameters used by the transmission device 700 for repetition. Accordingly, the LLR combiner 823 may determine the LLR value for the repeated LDPC encoded bits, and combine same with the LLR value for the LDPC encoded bits, which served as the basis for the repetition.

In addition, the LLR combiner 823 may combine an LLR value corresponding to retransmitted or increment redundancy (IR) bits with other LLR values. Here, the other LLR values may be LLR values for some or all of the LDPC code bits that served as the basis for generating retransmitted or IR bits by the transmission device 700.

As described above, when a NACK occurs for HARQ, the transmission device 700 may transmit some or all of the codeword bits to the reception device 800.

Accordingly, the LLR combiner 823 may combine the LLR values for the bits received through retransmission or IR with the LLR values for the LDPC codeword bits received through a previous frame.

To this end, the reception device 800 may store information on parameters used by the transmission device 700 for retransmission or IR bit generation. Accordingly, the LLR combiner 823 may determine an LLR value regarding the number of retransmission or IR bits and combine same with an LLR value regarding LDPC codeword bits that serve as the basis for generating retransmission bits.

The deinterleaver 824 may deinterleave the LLR value output by the LLR combiner 823.

Specifically, the deinterleaver 824 may be a component corresponding to the interleaver 741 of the transmission device 700 and may perform an operation corresponding to the interleaver 741.

To this end, the reception device 800 may have stored information on parameters used by the transmission device 700 for interleaving. Accordingly, the deinterleaver 824 may perform the inverse of the interleaving operation performed by the interleaver 741 on the LLR values corresponding to the transmitted LDPC-encoded bits, thereby deinterleaving the LLR values corresponding to the transmitted LDPC-encoded bits.

The LDPC decoding unit 830 may perform LDPC decoding, based on the LLR values output from the rate dematching unit 820.

Specifically, the LDPC decoding unit 830 may be a component corresponding to the LDPC encoding unit 730 of the transmission device 700, and may perform an operation corresponding to the LDPC encoding unit 730.

To this end, the receiver 800 may have pre-stored information on parameters used by the transmission device 700 to perform LDPC encoding according to the mode. Therefore, the LDPC decoding unit 830 may perform LDPC decoding, based on the LLR values output from the rate dematching unit 820, according to the mode.

For example, the LDPC decoding unit 830 may perform LDPC decoding based on a sum-product algorithm-based iterative decoding method, based on the LLR values output from the rate dematching unit 820, and may output bits in which errors have been corrected by the LDPC decoding. The LDPC decoding unit 830 performs LDPC decoding for an LDPC codeword, based on a parity check matrix or an exponent matrix or sequence corresponding to the parity check matrix. In addition, LDPC decoding may be performed by using a parity check matrix defined differently according to a code rate (i.e., a code rate of an LDPC code). The LDPC decoding unit 830 may perform LDPC decoding by passing an LLR value corresponding to LDPC codeword bits through an iterative decoding algorithm to generate information word bits. Here, the LLR value is a channel value corresponding to LDPC code bits, and may be expressed by various methods.

The zero removal unit 840 may remove zero bits from bits output from the LDPC decoding unit 830.

Specifically, the zero-removing unit 840 is a component corresponding to the zero-padding unit 720 of the transmission device 700, and may perform an operation corresponding to the zero-padding unit 720.

To this end, the reception device 800 may have pre-stored information on parameters used by the transmission device 700 for padding zero bits. Accordingly, the zero removal unit 840 may remove zero bits padded in the zero padding unit 720 from the bits output from the LDPC decoding unit 830.

The de-segmentation unit 850 may be a component corresponding to the segmentation unit 710 of the transmission device 700, and may perform an operation corresponding to the segmentation unit 710.

To this end, the reception device 800 may have pre-stored information on parameters used by the transmission device 700 for segmentation. Accordingly, the de-segmentation unit 850 may combine segments regarding bits output from the zero removal unit 840, that is, variable-length input bits to restore the bits before segmentation.

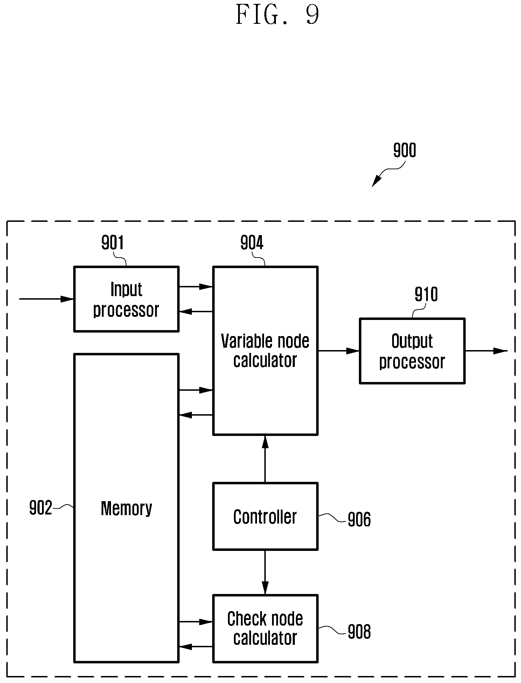

FIG. 9 is a diagram illustrating a structure of an LDPC decoding unit according to an embodiment of the disclosure.

Meanwhile, as described above, the LDPC decoding unit 830 may perform LDPC decoding by using an iterative decoding algorithm, and in this case, the LDPC decoding unit 830 may have a structure as shown in FIG. 9. However, the detailed configuration shown in FIG. 9 is also only an example.

As shown in FIG. 9, a decoding device 900 may include an input processor 901, a memory 902, a variable node calculator 904, a controller 906, a check node calculator 908, an output processor 910, and the like.

The input processor 901 stores a value input thereinto. Specifically, the input processor 901 may store an LLR value of a reception signal received through a channel.

The controller 904 determines the number of values input to the variable node calculator 904 and address values in the memory 902, the number of values input to the check node calculator 908 and address values in the memory 902, and the like, based on a parity check matrix corresponding to an encoding rate and the size (i.e., the length of the codeword) of a block of the reception signal received through a channel.

The memory 902 stores input data and output data of the variable node calculator 904 and the check node calculator 908.

The variable node calculator 904 performs variable node operations by receiving data from the memory 902, according to the address information of input data and the number information of input data received from the controller 906. Thereafter, the variable node calculator 904 stores variable node operation results in the memory 902, based on the address information of the output data and the number information of output data received from the controller 906. In addition, the variable node calculator 904 inputs the variable node operation result to the output processor 910, based on data received from the input processor 901 and the memory 902. The variable node operation is as described above based on FIG. 6.

The check node calculator 908 performs a check node operations by receiving data from the memory 902, based on the address information of input data and the number information of input data received from the controller 906. Thereafter, the check node calculator 908 stores check node operation results in the memory 902, based on the address information of the output data and the number information of output data received from the controller 906. The check node operation is as described above with reference to FIG. 6.

The output processor 910 determines whether the information word bits of the codeword of the transmission side are 0 or 1, based on the data input from the variable node calculator 904, and then outputs the determination result, and the output value of the output processor 910 is ultimately a decoded value. In this case, in FIG. 6, the determination may be made based on the sum of all message values (including an initial message value and all message values input from a check node) input to a single variable node.

Meanwhile, the memory 902 of the decoding device 900 may store information regarding a code rate, a code length, and a parity check matrix of an LDPC code, and the LDPC decoding unit 810 may perform LDPC encoding using this information. However, this is only an example, and the corresponding pieces of information may be provided from the transmission side.

For reference, in the disclosure, a description is limited to a low-density parity-check (LDPC) code as a forward error correction (FEC) technique of a communication system, but in general, FEC encoding and decoding of a communication system may be subdivided into a concatenated code including an outer code and an inner code. According to the definitions of the external code and the internal code, the transmitter performs internal encoding after external encoding, and the receiver performs external decoding after internal decoding.

In the case of an external code, a relatively simple algebraic code such as a cyclic redundancy check (CRC) code, a Bose-Chaudhuri-Hocquenghem (BCH) code, and a Reed-Solomon (RS) code, which enable error detection or correction, is commonly used, but the disclosure is not limited thereto, and multiple codes may be applied in a combined manner.

In the case of an inner code, relatively complex but highly error-correcting encoding schemes such as LDPC codes, Turbo codes, and Polar codes are widely used, though they are not necessarily the only options. (For example, a tail-biting convolutional code or other algebraic codes may be used, and multiple codes may be applied redundantly.) For reference, in 3GPP 5G systems, a CRC code is used for an external code, and for an internal code for a data channel, an LDPC code is used and for an internal code for a control channel, a Polar code is used.

In various broadcast systems and communication systems, an LDPC code optimized for each system is used. In the disclosure, a system using an LDPC code defined based on a parity check matrix having the same structure as the LDPC code used in a 3GPP 5G system is described, but the disclosure is not limited thereto. In addition, in a communication system including 5G or 6G systems, in order to support various code rates and various code lengths, rate matching may be applied in a transmitter and rate dematching may be applied in a receiver. However, in a system which performs encoding/decoding based on a fixed LDPC code, such as some broadcasting systems, some or all of other operations in addition to rate matching or rate dematching may be omitted.

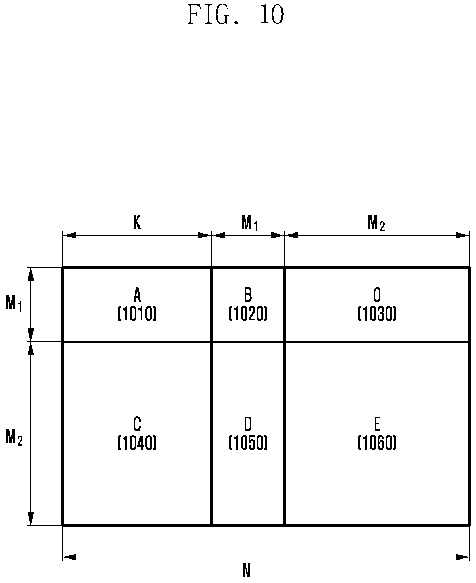

FIG. 10 illustrates a general structure of a parity check matrix of an LDPC code which is an internal code applied to an FEC encoding unit (not shown) and an FEC decoding unit (not shown) to be described in the disclosure.

The number of columns of the parity check matrix illustrated in FIG. 10 is N, and the number of rows is (M1 + M2)

(where $M_1$, $M_2 \geq 0$, $M_1 + M_2 > 0$). In general, the number of columns in the parity check matrix corresponding to the information word bits is equal to the total number of columns minus the total number of rows when the parity check matrix has the maximum rank (full rank). In other words, if the parity check matrix of FIG. 10 has a maximum rank ($M_1 + M_2$), this means that the number K of information word bits is N - ($M_1 + M_2$). In the disclosure, for convenience, only the case where the parity check matrix in FIG. 10 has a maximum rank is described, but the disclosure is not necessarily limited thereto.

First, the parity check matrix in FIG. 10 may be divided into a first part of a parity check matrix, including submatrices A 1010 and B 1020, and a second part of a parity check matrix, including submatrices C 1040, D 1050, and E 1060 (in case that one of $M_1$ or $M_2$ is 0, the first part and the second part may not be distinguished). The submatrix O 1030 denotes a 0-matrix of size ($M_1 \times M_2$). The submatrix O 1030 is a 0-matrix (zero matrix) of size ($M_1 \times M_2$), and therefore, even if it is included in the first part of the parity check matrix, it has no influence on the matrix operations. For this reason, in the disclosure, for convenience, the first part of the parity check matrix is defined as a matrix composed of a sub-matrix A 1010 and a sub-matrix B 1020 excluding a ($M_1 \times M_2$)size 0-matrix, but the first part of the parity check matrix may include the ($M_1 \times M_2$)size 0-matrix as needed.

In case that the parity check matrix in FIG. 10 is defined as a QC LDPC code of lifting size or block size Z, the parity check matrix in FIG. 10 may correspond to a base matrix or weight matrix of size $m_b \times n_b$ for $k_b = K/Z$ and $n_b = N/Z$, $m_b = (M_1 + M_2)/Z = m_{b1} + m_{b2}$ ($m_{b1} = M_1/Z, m_{b2} = M_2/Z$). Similarly, a first part of the parity check matrix composed of submatrices A 1010 and B 1020 corresponds to a submatrix of a base matrix or a submatrix of a base matrix or a weight matrix having a size of $\left(\frac{M_1}{Z}\right) \times \left(\frac{K+M_1}{Z}\right)$ or $m_{b1} \times (k_b + m_{b1})$, and a second part of the parity check matrix composed of submatrices C 1040, D 1050, and E 1060 corresponds to a submatrix of a base matrix or a weight matrix having a size of $\left(\frac{M_2}{Z}\right) \times \left(\frac{K+M_1+M_2}{Z}\right)$ or $m_{b2} \times (k_b + m_{b1} + m_{b2}) = m_{b2} \times n_b$.

For convenience, assuming that the parity check matrix of FIG. 10 is denoted as H, the information word bits (or the information word bit vector) corresponding to the submatrix A 1010 or C 1040 are denoted as $\underline{i} = (i_0, i_1, i_2, ... , i_{K-1})$, the first parity bits (or the first parity bit vector) corresponding to the submatrix B 1020 or D 1050 are denoted as $\underline{w_1} = (w_{1,0}, w_{1,1}, w_{1,2}, ... , w_{1,M_1-1})$, and the second parity bits (or the second parity bit vector) corresponding to the submatrix E 1060 are denoted as $\underline{w_2} = (w_{2,0}, w_{2,1}, w_{2,2}, ... , w_{2,M_2-1})$, the following relationship equation like Equation 13 may be derived from Equation 1.

[Equation 13]

$$H \cdot c^T = H \cdot \begin{bmatrix} \underline{i}^T \\ \underline{w_1}^T \\ \underline{w_2}^T \end{bmatrix} = \begin{bmatrix} A & B & O \\ C & D & E \end{bmatrix} \cdot \begin{bmatrix} \underline{i}^T \\ \underline{w_1}^T \\ \underline{w_2}^T \end{bmatrix}$$

$$= \begin{cases} A \cdot \underline{i}^T + B \cdot \underline{w_1}^T = 0 \\ C \cdot \underline{i}^T + D \cdot \underline{w_1}^T + E \cdot \underline{w_2}^T = 0 \end{cases}$$

Referring to Equation 13, the first parity vector $\underline{w_1}$ may be obtained (or calculated or determined) based on the information word bit vector i and a first part of the parity check matrix. In addition, after obtaining the parity vector $\underline{w_1}$, a parity vector $\underline{w_2}$ may be obtained (or calculated or determined) based on the information word bit vector $\underline{i}$, the parity vector $\underline{w_1}$, and the second part of the parity check matrix.

In the disclosure, for the convenience, the first part of the parity check matrix composed of submatrices A 1010 and B 1020, which is required to generate the first parity vector $\underline{w_1}$ based on the information word bit vector $\underline{i}$, may be referred to as a core part or core matrix, a kernel part or kernel matrix, a precoding part or matrix, or the like. In addition, the second part of the parity check matrix composed of submatrices C 1040, D 1050, and E 1060, which is required to generate a second parity vector $\underline{w_2}$ based on the information word bit vector $\underline{i}$ and/or the first parity vector $\underline{w_1}$, may be referred to as an extension part, a single parity-check extension part, or the like.

As a specific example, the core matrix parts of base matrix 1 $M(\mathbf{H_{BG1}})$ and base matrix 2 $M(\mathbf{H_{BG2}})$ defined in the 3GPP 5G standard described above may be represented as follows.

Core matrix of $M(\mathbf{H}_{BG1})$

0 1 2 3 5 6 9 10 11 12 13 15 16 18 19 20 21 22 23

0 2 3 4 5 7 8 9 11 12 14 15 16 17 19 21 22 23 24

0 1 2 4 5 6 7 8 9 10 13 14 15 17 18 19 20 24 25

0 1 3 4 6 7 8 10 11 12 13 14 16 17 18 20 21 22 25

Core matrix of $M(\mathbf{H}_{BG2})$

0 1 2 3 6 9 10 11

0 3 4 5 6 7 8 9 11 12

0 1 3 4 8 10 12 13

1 2 4 5 6 7 8 9 10 13

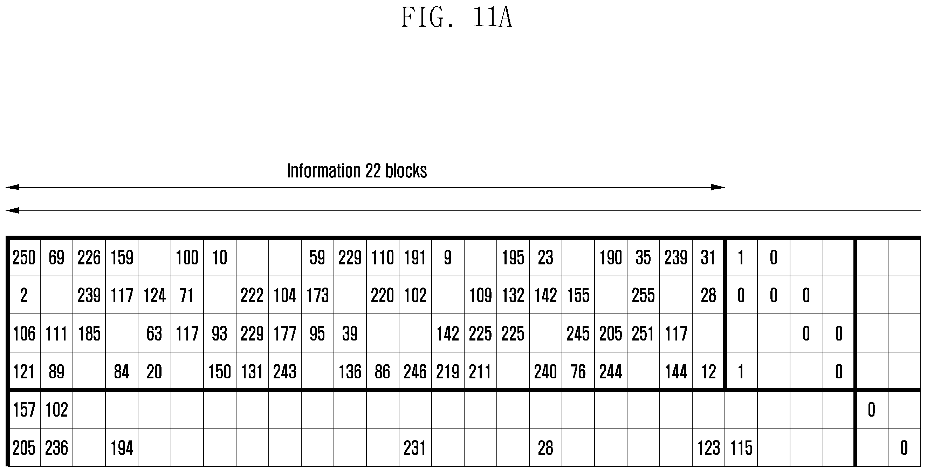

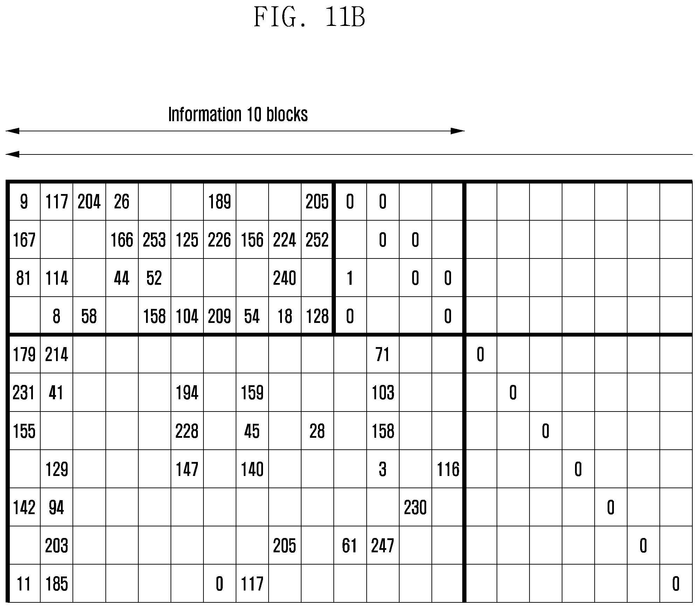

The size of the core matrix of $M(\mathbf{H}_{BG1})$ is $4\times26$, and the size of the core matrix of $M(\mathbf{H}_{BG2})$ is $4\times14$. In addition, the sizes of the core matrices are $4Z\times26Z$ and $4Z\times14Z$, respectively, based on the parity check matrix. As a specific example, a part of an exponent matrix of an LDPC code defined in 3GPP 5G standard TS 38.212 for a case of lifting size set index $i_{LS}$ = 0 is shown in FIG. 11A and FIG. 11B. In the base matrix or the parity check matrix, the part corresponding to the core matrix in FIGS. 11A and 11B is as follows.

Core matrix of $V(\mathbf{H}_1)$, $i_{LS} = 0$

250 69 226 159 100 10 59 229 110 191 9 195 23 190 35 239 31 1 0

2 239 117 124 71 222 104 173 220 102 109 132 142 155 255 28 0 0 0

106 111 185 63 117 93 229 177 95 39 142 225 225 245 205 251 117 0 0

121 89 84 20 150 131 243 136 86 246 219 211 240 76 244 144 12 1 0

Core matrix of $V(\mathbf{H}_2)$, $i_{LS} = 0$

9 117 204 26 189 205 0 0

167 166 253 125 226 156 224 252 0 0

81 114 44 52 240 1 0 0

8 58 158 104 209 54 18 128 0 0

The following parity check matrix based on the following conditions may be considered for the parity check matrix corresponding to FIG. 10 in the disclosure.

In the following, the submatrix A 1010 and the submatrix B 1020 may be referred to as a first submatrix and a second submatrix, respectively. In addition, the circulant permutation matrix in the following may refer to a circulant permutation matrix having a size of $Z \times Z$ determined based on the lifting size Z, and may be configured as in Equation 5 or Equation 6 below, for example. In addition, in the disclosure, a circulant matrix may refer to a matrix in which circulant permutation matrices are overlapped.

**Condition** 1(a): In case that the submatrix B 1020 of the parity check matrix for the QC-LDPC code of FIG. 10 does not include a circulant matrix in which circulant permutation matrices of size $Z \times Z$ are overlapped, the weight of all the column blocks of the submatrix B 1020 is 2 or more, and the submatrix B 1020 may include at least one column block having a weight of an odd number greater than or equal to 3. In addition, the weight of all the columns of the base matrix M(B) corresponding to the submatrix B 1020 is 2 or more, and at least one column having a weight of an odd number greater than or equal to 3 may be included in the base matrix $M(\mathbf{B})$.

**Condition 1 (b):** In the case that the submatrix B 1020 of the parity check matrix for the QC-LDPC code of FIG. 10 includes at least one circulant matrix in which circulant permutation matrices of size $Z \times Z$ are overlapped, the weight of all the column blocks of the submatrix B 1020 is 2 or more, and at least one column block having a weight of an odd number greater than or equal to 3 is included in the submatrix B 1020. In addition, in the weight matrix $W(\mathbf{B})$ corresponding to the submatrix B 1020, a sum of elements in all columns is 2 or more, and the weight matrix $W(\mathbf{B})$ includes at least one column in which a sum of elements in a column is an odd number greater than or equal to 3. (The weight of the column block including the circulant matrix in which circulant permutation matrices of size $Z \times Z$ are overlapped may be 2 or 3 or more.)

**Condition 2:** The column weights and the row weights of the submatrix E 1060 in FIG. 10 are all 1. In addition, the column weight and the row weight of the submatrices of the base matrix and the weight matrix corresponding to the submatrix E 1060 are all 1. Therefore, the submatrix E 1060 and the corresponding submatrices of the base matrix and weight matrix are either identity matrices or matrices that may be transformed into identity matrices when appropriate column permutations or row permutations are applied thereto. (That is, it means that submatrix E 1060 is the identity matrix or a matrix having the same (equivalent) algebraic characteristics as the identity matrix.) If the parity check matrix in FIG. 10 is defined as a quasi-cyclic parity check matrix, the sub-matrix E may be divided into multiple $Z \times Z$ size identity matrices.

FIGS. 11A and 11B illustrate examples of a parity check matrix satisfying at least one of Condition 1(a), Condition 1(b), or Condition 2. As briefly described above, FIG. 11A is an example in the case of K = 22*Z, $M_1$ = 4*Z, and $M_2$ = 2*Z in FIG. 10, and FIG. 11B is an example in the case of K = 10*Z, $M_1$ = 4*Z, and $M_2$ = 7*Z in FIG. 10. Note that the code rate of the LDPC code corresponding to the parity check matrix of FIGS. 10, 11A, and 11B is K/N, and as $M_2$ decreases, a code word with a lower code rate may be generated. In other words, according to the disclosure, by including FIG. 11A and FIG. 11B and expanding the columns of degree 1, LDPC encoding and decoding may be performed based on a parity check matrix supporting a lower code rate.

If a lifting size set is used for LDPC encoding or decoding for a quasi-cyclic LDPC code parity check matrix, the number of columns constituting one column block of the parity check matrix is equal to or greater than a minimum value of the lifting size. For example, in case that the values in Table 6 are used as the lifting size, the number of columns constituting a column block of the parity check matrix may be at least 4. Therefore, in a communication system in which the lifting size in Table 6 is substantially applied to the parity check matrix of the LDPC code having the structure of FIGS. 10, 11A, and 11B, satisfying at least one of Condition 1(a), Condition 1(b), or Condition 2, the number of columns with degree 3 in the submatrix B 1020 is at least 4.

For reference, a core matrix in the parity check matrix, base matrix, or weight matrix may be defined in a form in which one or two rows are added so as to satisfy at least one of Condition 1(a), Condition 1(b), or Condition 2. However, for the convenience of description, in the disclosure, a parity check matrix [A (1010) B (1020)] including a submatrix B that satisfies only Condition 1(a) or Condition 1(b) is considered as a core matrix (or Kernel matrix or precoding matrix).

Core matrix of $M(\mathbf{H_{BG1}})$

0 1 2 3 5 6 9 10 11 12 13 15 16 18 19 20 21 22 23

0 2 3 4 5 7 8 9 11 12 14 15 16 17 19 21 22 23 24

0 1 2 4 5 6 7 8 9 10 13 14 15 17 18 19 20 24 25

0 1 3 4 6 7 8 10 11 12 13 14 16 17 18 20 21 22 25

0 1 26

Core matrix of $M(\mathbf{H_{BG2}})$

0 1 2 3 6 9 10 11

0 3 4 5 6 7 8 9 11 12

0 1 3 4 8 10 12 13

1 2 4 5 6 7 8 9 10 13

0 1 11 14

As an embodiment of the disclosure, a method for improving the performance of an LDPC code according to a weight matrix and a method for improving a decoding convergence speed will be described.

First, the core matrix of base matrix 2 $M(\mathbf{H_{BG2}})$ defined in the **[base matrix determination method]** includes four rows, which may also be expressed as a weight matrix as in Equation 14 below. The LDPC codes defined by the base matrix 1 $M(\mathbf{H_{BG1}})$ or the base matrix 2 $M(\mathbf{H_{BG2}})$ are defined such that one circulant permutation matrix corresponds to one block with size $Z \times Z$, and thus the base matrix and the weight matrix are essentially the same.

[Equation 14]

$$W(\mathbf{H_{BG2}}) = \begin{bmatrix} 1 & 1 & 1 & 1 & 0 & 0 & 1 & 0 & 0 & 1 & 1 & 1 & 0 & 0 \\ 1 & 0 & 0 & 1 & 1 & 1 & 1 & 1 & 1 & 1 & 0 & 1 & 1 & 0 \\ 1 & 1 & 0 & 1 & 1 & 0 & 0 & 0 & 1 & 0 & 1 & 0 & 1 & 1 \\ 0 & 1 & 1 & 0 & 1 & 1 & 1 & 1 & 1 & 1 & 1 & 0 & 0 & 1 \end{bmatrix}$$

The LDPC code designed such that a maximum of one circulant permutation matrix corresponds to one block with size $Z \times Z$ has a structure suitable for layered decoding in units of one row block during decoding. In other words, this means that the structure of the LDPC code is suitable for decoding using a $Z$-unit parallel processing processor.

In the layered decoding scheme, since parallel processing is typically performed with a single row block as a basic unit, it may be determined that one iteration of decoding is completed when decoding has been performed for the total number of row blocks. This means that, if there are sufficient parallel processing processors, the decoding throughput through layered decoding is inversely proportional to the number of row blocks. However, in a case of supporting the same code length by using a parity check matrix having a smaller number of row blocks, the lifting size Z value increases further, and thus the amount of parallel processors needed to perform decoding for one row block simultaneously increases.

For example, the weight matrix $W(\mathbf{H_{BG2}})$ may have 4 rows and 14 columns, and the weights of the respective columns may be 3, 3, 2, 3, 3, 2, 3, 2, 3, 3, 3, 2, 2, and 2. In this case, a weight matrix $W(\mathbf{H'_{BG2}})$ having 3 rows and 13 columns and having a similar weight distribution to $W(\mathbf{H_{BG2}})$ and a weight matrix $W(\mathbf{H''_{BG2}})$ having 2 rows and 12 columns and having a similar weight distribution to $W(\mathbf{H_{BG2}})$ may be configured as follows.

$$W(\mathbf{H'_{BG2}}) = \begin{bmatrix} 1 & 1 & 1 & 1 & 1 & 1 & 1 & 0 & 1 & 1 & 1 & 1 & 0 \\ 1 & 1 & 0 & 1 & 1 & 1 & 1 & 1 & 1 & 1 & 1 & 1 & 1 \\ 1 & 1 & 1 & 1 & 1 & 0 & 1 & 1 & 1 & 1 & 1 & 0 & 1 \end{bmatrix},$$

$$W(\mathbf{H''_{BG2}}) = \begin{bmatrix} 2 & 1 & 1 & 2 & 1 & 1 & 2 & 1 & 1 & 2 & 1 & 1 \\ 1 & 2 & 1 & 1 & 2 & 1 & 1 & 1 & 2 & 1 & 2 & 1 \end{bmatrix}.$$

If LDPC codes having the same code length may be generated by using the respective weight matrices $W(\mathbf{H_{BG2}})$, $W(\mathbf{H'_{BG2}})$, and $W(\mathbf{H''_{BG2}})$, and the lifting sizes corresponding to the respective parity check matrices are $Z_1, Z_2$, and $Z_2$, then there is a relationship of $Z_3 = \frac{14}{12}Z_1$ and $Z_2 = \frac{13}{12}Z_1$. In addition, if $Z_i$ parallel processing processors are allowed in each LDPC decoder, the approximate decoding throughput of $W(\mathbf{H'_{BG2}})$ may be 1.5 times that of $W(\mathbf{H_{BG2}})$ and the approximate decoding throughput of $W(\mathbf{H''_{BG2}})$ may be 2 times that of $W(\mathbf{H_{BG2}})$.

As such, when a sufficient number of parallel processing processors are available, the number of row blocks may be reduced, thereby increasing the decoding throughput in inverse proportion. Therefore, in a system that requires a very high decoding throughput, if more parallel processing processors are applied, it is more advantageous to maintain the number of rows of the base matrix or the weight matrix, that is, the number of row blocks of the parity check matrix, to be small.

Maintaining the number of rows of the base matrix or weight matrix, i.e., the number of row blocks of the parity check matrix, to be small may be advantageous in terms of the decoding throughput, but if the number of row blocks is configured to be too small, the LDPC code may have serious constraints on algebraic characteristics, such as cycle characteristics or minimum distance characteristics, thereby causing performance degradation. Therefore, the base matrix or weight matrix should be determined by considering both the target throughput and the target error correction capability of the system.

As an embodiment of the disclosure, a method for improving the performance of the code while increasing the decoding throughput is proposed. In particular, the disclosure proposes an algebraic characteristic that a core matrix part of a base matrix or a weight matrix, which is closely related to the maximum decoding throughput or the peak data rate of the system, should satisfy. Of course, when the parity check matrix does not include the second part of the parity check matrix including the submatrices C 1040, D 1050, and E 1060 in FIG. 10, the core matrix may be the same as the base matrix or the weight matrix.

One of conditions that the core matrix of a parity check matrix needs to satisfy is that, when two columns having only one non-zero element in the weight matrix corresponding to the core matrix are selected, non-zero elements should not be included in only one row as in $\begin{bmatrix} 0 & 0 \\ \vdots & \vdots \\ w_1 & w_2 \\ \vdots & \vdots \\ 0 & 0 \end{bmatrix}(w_1, w_2 \geq 1)$ . As a simple example, there are

$\begin{bmatrix} w_1 & w_2 \\ 0 & 0 \end{bmatrix}$, $\begin{bmatrix} 0 & 0 \\ w_1 & w_2 \end{bmatrix}$, $\begin{bmatrix} w_1 & w_2 \\ 0 & 0 \\ 0 & 0 \end{bmatrix}$, $\begin{bmatrix} 0 & 0 \\ w_1 & w_2 \\ 0 & 0 \end{bmatrix}$ , and the like. Because a minimum distance of a parity check matrix corresponding to the weight matrix or a core matrix thereof including the structure is equal to or less than $w_1 + w_2$, an error floor phenomenon may easily occur. Therefore, in any two columns where there is only one non-zero element,

such as $\begin{bmatrix} w_1 & 0 \\ 0 & w_2 \end{bmatrix}$, $\begin{bmatrix} w_1 & 0 \\ 0 & w_2 \\ 0 & 0 \end{bmatrix}$, and $\begin{bmatrix} w_1 & 0 \\ 0 & 0 \\ 0 & w_2 \end{bmatrix}$ , the non-zero elements must be located in different rows. This means that the non-zero elements in the columns with weight 1 with respect to the base matrix are all located in different rows. The above may be defined as follows in Conditions 3(a) and 3(b) below.

Condition 3(a): All the columns of the base matrix or the weight matrix corresponding to the core matrix have a weight of 2 or more, or the number of columns having a weight of 1 is at most one.

Condition 3(b): When the number of columns having a weight of 1 in the base matrix or the weight matrix corresponding to the core matrix is two or more, non-zero elements included in the columns having a weight of 1 are located in different rows.

Conditions 3(a) and 3(b) indicate that the number of column blocks configured only by one circulant permutation matrix or cyclic matrix included in the core matrix is at most one, or when two or more column blocks configured only by one circulant permutation matrix or cyclic matrix are included in the core matrix, the circulant permutation matrices or cyclic matrices of size $Z \times Z$ is necessarily included in different row blocks. In addition, Condition 3(a) and Condition 3(b) are structures for preventing a serious error floor phenomenon. If improved error floor characteristics are required, the following Condition 4 may be additionally added. As described above, the circulant permutation matrix and the cyclic matrix may have a size of $Z \times Z$.

Condition 4: The weight of a column corresponding to the information bit (or input bit or code block) in the parity check matrix corresponding to the core matrix is 3 or higher.

Condition 4 may be applied when the weight of a column corresponding to an information bit is configured not to be 2 so as to reduce code gain but to improve the error floor phenomenon, as in the parity check matrix corresponding to the base matrix 2 $M(\mathbf{H_{BG2}})$ of Equation 14.

Condition 4 indicates that, in the case that the submatrix A 1010 in the parity check matrix for the QC-LDPC code does not include a cyclic matrix in which circulant permutation matrices of size $Z \times Z$ are overlapped, the weight of all the column blocks of the submatrix A 1010 is 3 or more, and the weight of all the columns of the base matrix $M(\mathbf{A})$ corresponding to the submatrix A 1010 is 3 or more. In addition, Condition 4 indicates that, in the case that the submatrix A 1010 in the parity check matrix for the QC-LDPC code includes at least one cyclic matrix in which circulant permutation matrices of size $Z \times Z$ are overlapped, the weight of all the column blocks of the submatrix A 1010 is 3 or more, and the sum of all elements in each column of the weight matrix $W(\mathbf{A})$ corresponding to the submatrix A 1010 is 3 or more.

As another condition that the core matrix of the parity check matrix must satisfy, it may be considered that the weight matrix corresponding to the core matrix has no elements of 3 or more. Generally, when the core matrix of a weight matrix includes an element that is an integer greater than or equal to 3, this means that three or more circulant permutation matrices correspond to the corresponding position, and when three or more circulant permutation matrices for configuring a cyclic matrix of size $Z \times Z$ overlap, the maximum length of a cycle is limited to 6 regardless of the $Z$ value. When the cycle length is short, the performance improvement effect due to iterative decoding is reduced, so that the parity check matrix corresponding to the weight matrix or the core matrix including a value of 3 or larger as an element is suitable for use in cases of short code lengths or relatively high code rates. In the disclosure, since a method for designing an LDPC code supporting various code rates and various code lengths is discussed, no element of 3 or more is included in the core matrix of the weight matrix. (Of course, an element of 3 or more may be included in a part corresponding to the single parity check (SPC) extension part.) The above may be defined as Condition 5 below.

Condition 5: A weight matrix corresponding to a core matrix includes only 0 and 1 or 0, 1, and 2.

As another condition that the core matrix must satisfy, the submatrix B 1020 in FIG. 10 corresponding to the first parity vector $\underline{w}_1$ needs to have a maximum rank in order to enable efficient encoding, and a limited structure as follows is preferable in order to prevent severe deterioration of the cyclic characteristics.

Condition 6(a): When a weight matrix corresponding to a core matrix includes 4 rows, a submatrix corresponding to submatrix B 1020 in the weight matrix and the base matrix is one of the following:

$$\begin{bmatrix} 1 & 1 & 0 & 0 \\ 1 & 1 & 1 & 0 \\ 0 & 0 & 1 & 1 \\ 1 & 0 & 0 & 1 \end{bmatrix}, \begin{bmatrix} 1 & 1 & 0 & 0 \\ 0 & 1 & 1 & 0 \\ 1 & 0 & 1 & 1 \\ 1 & 0 & 0 & 1 \end{bmatrix}, \begin{bmatrix} 1 & 1 & 0 & 0 \\ 1 & 1 & 1 & 0 \\ 0 & 0 & 1 & 1 \\ 1 & 0 & 1 & 1 \end{bmatrix}, \begin{bmatrix} 1 & 1 & 0 & 0 \\ 0 & 1 & 1 & 0 \\ 1 & 1 & 1 & 1 \\ 1 & 0 & 1 & 1 \end{bmatrix},$$

$$\begin{bmatrix} 1 & 1 & 0 & 0 \\ 0 & 1 & 1 & 0 \\ 1 & 1 & 1 & 1 \\ 1 & 0 & 1 & 1 \end{bmatrix}, \begin{bmatrix} 1 & 1 & 0 & 0 \\ 0 & 1 & 1 & 0 \\ 1 & 0 & 1 & 1 \\ 1 & 1 & 1 & 1 \end{bmatrix}$$

Condition 6(b): When a weight matrix corresponding to a core matrix includes 3 rows, a sub-matrix of the base matrix corresponding to a submatrix B 1020 is $\begin{bmatrix} 1 & 1 & 0 \\ 1 & 1 & 1 \\ 1 & 0 & 1 \end{bmatrix}$ and the weight matrix is one of the following:

$$\begin{bmatrix} 1 & 1 & 0 \\ 1 & 1 & 1 \\ 1 & 0 & 1 \end{bmatrix}, \begin{bmatrix} 1 & 1 & 0 \\ 0 & 1 & 1 \\ 2 & 0 & 1 \end{bmatrix}, \begin{bmatrix} 2 & 1 & 0 \\ 0 & 1 & 1 \\ 1 & 0 & 1 \end{bmatrix}, \begin{bmatrix} 1 & 2 & 0 \\ 0 & 1 & 1 \\ 2 & 0 & 1 \end{bmatrix}, \begin{bmatrix} 1 & 2 & 0 \\ 0 & 1 & 2 \\ 2 & 0 & 1 \end{bmatrix}.$$

Condition 6(c): When a weight matrix corresponding to a core matrix includes 2 rows, a sub-matrix of the base matrix corresponding to a submatrix B 1020 is $\begin{bmatrix} 1 & 1 \\ 1 & 1 \end{bmatrix}$ and the weight matrix is one of the following:

$$\begin{bmatrix} 1 & 1 \\ 2 & 1 \end{bmatrix}, \begin{bmatrix} 1 & 2 \\ 2 & 1 \end{bmatrix}.$$

For reference, Condition 6(a) indicates the case in which the weight matrix and the base matrix are the same, and in Condition 6(b), only the case in which the weight matrix is $\begin{bmatrix} 1 & 1 & 0 \\ 1 & 1 & 1 \\ 1 & 0 & 1 \end{bmatrix}$ has the same shape as the base matrix. In the base matrix or the weight matrix indicated by Conditions 6(a), 6(b), and 6(c), 0 indicates a 0-matrix of size $Z \times Z$, and 1 indicates an identity matrix $I = (P^0)$ or a circulant permutation matrix $P^v$ of size $Z \times Z$ ($v > 0$). In addition, 2 represents a cyclic matrix ($P^{v_1} + P^{v_2}$) of size $Z \times Z$ ($v_1, v_2 \geq 0$, $v_1 \neq v_2$).

In general, an upper bound for the cycle length may be predicted from the base matrix or the weight matrix, but the cycle characteristics of the parity check matrix corresponding to the base matrix or the weight matrices are not known. For example, assuming that the submatrix B 1020 is $\begin{bmatrix} I & I \\ P^{v_1} + P^{v_2} & I \end{bmatrix}$ or $\begin{bmatrix} I & I & 0 \\ P^{v_1} & I & I \\ P^{v_2} & 0 & I \end{bmatrix}$, in each case, the base matrix or the weight matrix is $\begin{bmatrix} 1 & 1 \\ 2 & 1 \end{bmatrix}$ or $\begin{bmatrix} 1 & 1 & 0 \\ 1 & 1 & 1 \\ 1 & 0 & 1 \end{bmatrix}$ identical regardless of the values of v1 and v2, but the cycle characteristics are very different. In the case of $\begin{bmatrix} I & I \\ P^{v_1} + P^{v_2} & I \end{bmatrix}$, at least one of v1 or v2 is 0, or

$v_1 \equiv v_2 \left( \mod \frac{Z}{2} \right)$ (or $v_1 - v_2 \equiv \frac{Z}{2} (\mod Z)$), a large number of 4-cycles are generated, and therefore v1 and v2 are basically configured as integers satisfying $v_1, v_2 \pmod{Z} > 0$ or $v_1 \not\equiv v_2 \left( \mod \frac{Z}{2} \right)$ (or

$$v_1 - v_2 \not\equiv \frac{Z}{2} \pmod{Z}$$ ). Similarly, for the case of $\begin{bmatrix} I & I & 0 \\ P^{v_1} & I & I \\ P^{v_2} & 0 & I \end{bmatrix}$ , when v1 = 0, a large number of 4-cycles are generated, so basically, v1 is configured as an integer satisfying $v_1 \pmod{Z} \geq 1$, and v2 is configured as an integer satisfying $v_2 \pmod{Z} \geq 0$. The above is only a method for removing the 4-cycle, and the v1 and v2 values may be limited in various ways in order to obtain longer cycles.

If the communication system employs the puncturing of the information word bit as described in [Table 9], the following additional conditions for the core matrix may be satisfied.

Condition 7: In an LDPC encoding system to which puncturing of an information word bit is applied, a submatrix of a core matrix including only columns corresponding to the punctured information word bit has at least one row with a row weight of 1.

In the receiver, a punctured bit is considered to be a lost bit during a reception process, and thus, it is determined that the probability that the punctured bit is 0 and the probability that the punctured bit is 1 are the same. This typically indicates 1 when decoding is performed using an LR value, and 0 when decoding is performed using an LLR value, but may be determined in another form based on values used in the decoding process. When performing LDPC decoding based on a parity check matrix that does not satisfy Condition 7, if a maximum likelihood (ML) decoding or a pseudo ML decoding technique is not used, the punctured information word bits may not be decoded. Since ML or similar ML decoding schemes are not typically used due to the complexity thereof, the parity check matrix may be determined to satisfy Condition 7 in order to guarantee decoding success.

In case that the LDPC code is a QC-LDPC code, the parity check matrix may be expressed as in the following Condition 8, since the parity check matrix may be expressed based on a lifting size Z value, a base matrix, and/or a weight matrix, and/or an exponent matrix.

Condition 8: In a QC-LDPC encoding system to which puncturing of the information word bits in a lifting size Z or multiple unit is applied, the submatrix of the base matrix including only a columns corresponding to the submatrix of the core matrix including only a*Z columns corresponding to the punctured a*Z (a: integer greater than or equal to 1) information word bits has at least one row with a weight of 1. In addition, the submatrix of the weight matrix including a columns corresponding to the submatrix of the core matrix including a*Z columns has at least one row with a weight of 1 and an element of 1.

For example, in a QC-LDPC encoding system to which a puncturing of information word bits of 2Z bits is always applied, a = 2 is indicated in Condition 8.

In the disclosure, at least one of the above conditions may be used to configure a parity check matrix. That is, the parity check matrix may be determined to satisfy at least one of the conditions or to satisfy a combination of at least two of the conditions.

As an embodiment of the disclosure, a method for improving the error floor performance of an LDPC code is proposed. In general, the error floor phenomenon of the LDPC code is largely affected by the cycle characteristic of the Tanner graph. However, since the QC LDPC code has a cycle characteristic on a Tanner graph determined by the relationship between a base matrix and an exponent or a cyclic shift value of a circulant permutation matrix, a cyclic shift value as well as a position of a circulant permutation matrix configuring a parity check matrix needs to be appropriately selected.

The disclosure proposes an algebraic characteristic to be satisfied by the submatrix B 1020 corresponding to first parity bits (or a first parity bit vector) $\underline{w_1} = (w_{1,0}, w_{1,1}, w_{1,2}, ..., w_{1,M-1})$ in the first part of the parity check matrix including the submatrices A 1010 and B 1020 in FIG. 10.

The size of the submatrix B 1020 is $M_1 \times M_1$ (or $m_{b1}Z \times m_{b1}Z$), and the submatrix B 1020 corresponds to a base matrix or a weight matrix of size $\left(\frac{M_1}{Z}\right) \times \left(\frac{M_1}{Z}\right)$ (or $m_{b1} \times m_{b1}$). In addition, a first column block of the submatrix B 1020 includes three circulant permutation matrices. In this case, the circulant permutation matrices may include an identity matrix. That is, in the disclosure, a circulant permutation matrix is defined as a matrix in which elements of an identity matrix are cyclically shifted by i, and when the i value is 0, the circulant permutation matrix may be an identity matrix. The definition may be applied to the entire detailed description of the disclosure. In addition, the remaining column blocks of the submatrix B 1020 are configured by two circulant permutation matrices or identity matrices. In the disclosure, for the convenience, the remaining column blocks are expressed as identity matrices configured in a double diagonal structure, but it is not necessary to limit them thereto in general.

An example of a submatrix B 1020 in Equation 15 is given below. The submatrix B 1020 may be determined based on at least one of the matrices included in Equation 15 below. However, the embodiments of the disclosure are not limited thereto, and various matrices that satisfy the above characteristics (the first column block includes three circulant permutation matrices, and the remaining column blocks include two circulant permutation matrices or identity matrices) may be considered.

[Equation 15]

$$B_1 = \begin{bmatrix} P^a & I & 0 \\ P^b & I & I \\ P^c & 0 & I \end{bmatrix}, \quad B_{2,1} = \begin{bmatrix} P^a & I & 0 & 0 \\ P^b & I & I & 0 \\ 0 & 0 & I & I \\ P^c & 0 & 0 & I \end{bmatrix},$$

$$B_{2,2} = \begin{bmatrix} P^a & I & 0 & 0 \\ 0 & I & I & 0 \\ P^b & 0 & I & I \\ P^c & 0 & 0 & I \end{bmatrix}, \quad B_3 = \begin{bmatrix} P^a & I & 0 & 0 & 0 \\ 0 & I & I & 0 & 0 \\ P^b & 0 & I & I & 0 \\ 0 & 0 & 0 & I & I \\ P^c & 0 & 0 & 0 & I \end{bmatrix}$$

$$M(B_1) = \begin{bmatrix} 1 & 1 & 0 \\ 1 & 1 & 1 \\ 1 & 0 & 1 \end{bmatrix}, \quad M(B_{2,1}) = \begin{bmatrix} 1 & 1 & 0 & 0 \\ 1 & 1 & 1 & 0 \\ 0 & 0 & 1 & 1 \\ 1 & 0 & 0 & 1 \end{bmatrix},$$

$$M(B_{2,2}) = \begin{bmatrix} 1 & 1 & 0 & 0 \\ 0 & 1 & 1 & 0 \\ 1 & 0 & 1 & 1 \\ 1 & 0 & 0 & 1 \end{bmatrix}, \quad M(B_3) = \begin{bmatrix} 1 & 1 & 0 & 0 & 0 \\ 0 & 1 & 1 & 0 & 0 \\ 1 & 0 & 1 & 1 & 0 \\ 0 & 0 & 0 & 1 & 1 \\ 1 & 0 & 0 & 0 & 1 \end{bmatrix},$$

$$V(B_{2,1}) = \begin{bmatrix} a & 0 & -1 & -1 \\ b & 0 & 0 & -1 \\ -1 & -1 & 0 & 0 \\ c & -1 & -1 & 0 \end{bmatrix}, \quad V(B_3) = \begin{bmatrix} a & 0 & -1 & -1 & -1 \\ -1 & 0 & 0 & -1 & -1 \\ b & -1 & 0 & 0 & -1 \\ -1 & -1 & -1 & 0 & 0 \\ c & -1 & -1 & -1 & 0 \end{bmatrix}$$

In Equation 15, $B_1$, $B_{2,1}$, $B_{2,2}$, and $B_3$ have a first column block including three different circulant permutation matrices $P^a$, $P^b$, and $P^c$. In addition, although only the cases in which the value $m_{b1}$ is 3, 4, or 5 are illustrated for the convenience in Equation 15, the submatrix B 1020 may be similarly defined for values greater than 5. In addition, matrices that may be transformed into the submatrix B 1020 of the above-described form through an appropriate inverse transform process may be considered to be algebraically the same matrix.

In the disclosure, a method for improving the cycle characteristics with regard to not only $B_1$, $B_{2,1}$, $B_{2,2}$, and $B_3$ of Equation 15, but also a larger submatrix B 1020 having a similar shape is proposed. For convenience, the method of analyzing the cycle characteristics of QC LDPC codes and the detailed description of some algebraic characteristics are omitted in the disclosure, but the contents of Reference [Myung2005] may be referenced.

[Myung2005]

S. Myung, K. Yang, and J. Kim, " Quasi-Cyclic LDPC Codes for Fast Encoding," IEEE Transactions on Information Theory, vol. 51, No.8, pp. 2894-2901, Aug. 2005.

In case that a submatrix B 1020 has a dual diagonal structure in which, except for the first column block, the remaining column blocks are composed of identity matrices of size as in Equation 15, in the conventional art, for the convenience of encoding, at least two of the exponents (or cyclic shift values) $a$, $b$, and $c$ of the first column block's circulant permutation matrix are configured to the same value. In this case, the $Z \times Z$-sized $\phi$ matrix used in the encoding process becomes either the identity matrix $I$ or a simple circulant permutation matrix $P^x$, and the inverse matrix $\phi^{-1}$ of $\phi$ is simplified to either the identity matrix $I$ or $P^{-x}$, thereby simplifying the encoding process. (For a detailed encoding process of the QC LDPC code, see [Myung2005]). As a specific example, when $a = c$ is configured, $\phi$ becomes $P^b$ and $\phi^{-1}$ becomes $P^{-b}$, so that encoding may be efficiently performed. Similarly, when $a = b$ is configured, $\phi$ becomes $P^c$ and $\phi^{-1}$ becomes $P^{-c}$, so that efficient encoding may be performed.

However, in the case of $a = c \neq b$, there always exists $Z$ cycles of length $2m_{b1}$ on the Tanner graph due to a structure shown in Equation 16 below. In other words, if the value of $m_{b1}$ is fixed, a cycle of length $2m_{b1}$ always exists regardless of the lifting size $Z$ and the exponent $a(= c)$ value. (For detailed information on the cycle characteristics of the QC LDPC code, refer to [Myung2005])

[Equation 16]

$$\begin{bmatrix} P^a & I & * & * & * \\ * & I & I & * & * \\ * & * & \ddots & \ddots & * \\ * & * & * & I & I \\ P^a & * & * & * & I \end{bmatrix}$$

In addition, in case of $a = b$, due to a structure as shown in Equation 17 below, a shorter cycle than $2m_{b1}$ always exists regardless of the lifting size $Z$ and the exponent $a(= b)$ value.

[Equation 17]

$$\begin{bmatrix} P^a & I & * \\ P^b & I & * \\ * & * & * \end{bmatrix}, \begin{bmatrix} P^a & I & * & * \\ * & I & I & * \\ P^b & * & I & * \\ * & * & * & * \end{bmatrix}$$

If the value $m_{b1}$ is appropriately large, the cycle characteristics of the Tanner graph corresponding to the structures of Equations 16 and 17 may not have a significant impact on the performance of the LDPC code. However, when the value $m_{b1}$ is relatively small, the BLER may increase due to the error floor phenomenon, and this may become a non-negligible problem as the target BLER of the system decreases.

In order to solve the above problems, the disclosure proposes a method of improving the cycle characteristics by limiting the exponents (or cyclic shift values) $a$, $b$, and $c$ of the circulant permutation matrices configuring the first column block of the submatrix B 1020 having a structure of Equation 15 to satisfy a specific algebraic condition. In addition, it will be described that the method has a feature that the computational complexity related to the $\phi^{-1}$ matrix required in the LDPC encoding process increases to a reasonable level while the cycle characteristics are improved.

If the lifting size $Z$ of the parity check matrix of the QC LDPC code is $Z = p \cdot 2^L$ ($p$ is an odd integer, and $L$ is a non-negative integer), the exponents (or cyclic shift values) $a, b,$ and $c$ of the circulant permutation matrices configuring the first column block of the submatrix B 1020 are different integers, and satisfy at least some or all of the following conditions:

Exponent condition 1a: At least one of differences between two exponents (cyclic shift values) is relatively prime to the lifting size $Z$ or has the smallest divisor of $Z$ greater than 1. (That is, the at least one difference is either relatively prime to $Z$, or shares a greatest common divisor equivalent to the minimum divisor of $Z$ that exceeds 1.)

Exponent condition 1b: Two of differences between the two exponents are relatively prime to the lifting size $Z$ or have the smallest divisor of $Z$ greater than 1.

Exponent condition 2a: At least one of differences between two exponents is $\frac{Z}{2^i}$ $(0 \le i \le L)$.

Exponent condition 2b: At least one of differences between two exponents is $\frac{Z}{2^i}$ $(1 \le i < L)$ when $p$ is 1 and $L > 1$ is satisfied and is $\frac{Z}{2^i}$ $(1 \le i \le L)$ when $p$ is an odd number greater than or equal to 3 and $L > 0$ is satisfied.

For reference, the difference between the exponents used in the above exponent conditions may mean $|a - b|$, $|b - c|$, $|c - a|$, and the like.

According to Exponent condition 1a, when the difference between the two exponents is coprime with $Z$, the length of the cycle determined by the circulant permutation matrix associated with the two exponents is maximized. For example, in the case where a value of $|a - b|$ and $Z$ are coprime, the length of the cycle on the Tanner graph determined by $\begin{bmatrix} P^a & I & * \\ P^b & I & * \\ * & * & * \end{bmatrix}$ in Equation 17 is $4Z$. If the maximum common divisor of $|a - b|$ and $Z$ is $D$, the cycle length is $4Z/D$. As a result, as the value $Z$ increases, the length of the cycle also increases.

As another example, when the value of $|a - c|$ is coprime to $Z$, the cycle length determined by the structure of Equation 16 is $2m_{b1}Z$. If the maximum common divisor of $|a - c|$ and $Z$ is $D$, the cycle length is $2m_{b1}Z/D$. As a result, it may be seen that the cycle length is not fixed regardless of the Z value, but the cycle length also increases as the Z value increases. When considering only the cyclic characteristics, it is preferable that the difference between the exponents is relatively prime to Z, but depending on the situation, the exponents may be selected such that the greatest common divisor D is small (e.g., such that the minimum divisor of Z greater than 1 is obtained) based on other conditions. For example, if the feature that the difference between the exponents is relatively prime to Z cannot be satisfied, it is preferable to select an exponent to induce a smaller greatest common divisor *D*.

Exponent condition 1b is a condition for further limiting Exponent condition 1a in order to improve the cycle characteristics further. For example, when the values of |a - b| and |b - c| are relatively prime to Z, the cycle characteristics related to the exponents a and b as $\begin{bmatrix} P^a & I & * \\ P^b & I & * \\ * & * & * \end{bmatrix}$ are improved and the cycle characteristics related to the exponents b

and c as $\begin{bmatrix} * & * & * \\ P^b & * & I \\ P^c & * & I \end{bmatrix}$ are also similarly improved. (Also, the same holds for Equation 15 and other forms of submatrices B extended based on Equation 15.)

In Equation 15 and other forms of the submatrix B extended based on Equation 15, when, *a, b,* and *c* are all different, a $\phi$ matrix required for an encoding process is defined as $\phi = P^a + P^b + P^c$. For such a $\phi$ matrix, not only is it difficult to obtain $\phi^{-1}$, but the weight density of the $\phi^{-1}$ matrix also typically exhibits high-density characteristics rather than low-density ones. In other words, there is a problem in that the $\phi$ matrix having a low density characteristic may not guarantee the low density characteristic of the $\phi^{-1}$ matrix. The high-density characteristic of the $\phi^{-1}$ matrix is a cause for increasing encoding complexity, and thus the density of the $\phi^{-1}$ matrix is preferably as low as possible, and the $\phi^{-1}$ matrix is preferably of a simple structure.

Exponent conditions 2a and 2b are conditions to simplify the $\phi^{-1}$ matrix as much as possible for efficient LDPC encoding. For example, when $|a - c| = \dfrac{Z}{2^i}$ is satisfied in Exponent condition 2a,

$\phi^{2i} = P^{2ia} + P^{2ib} + P^{2ic} = P^{2ia} (I + P^{2i(c-a)}) + P^{2ib} = P^{2i \cdot b}$ is satisfied, and $\phi^{-1} = P^{-2ib} \cdot \phi^{2i-1}$ is derived. Here, $\phi^{2i-1}$ is represented as

$$\phi^{2^i - 1} = \phi^{2^{i-1}} \cdot \phi^{2^{i-2}} \cdot \cdots \cdot \phi^2 \cdot \phi = \left( P^{2^{(i-1)}a} + P^{2^{(i-1)}b} + \right.$$

$$\left. P^{2^{(i-1)}c} \right) \left( P^{2^{(i-2)}a} + P^{2^{(i-2)}b} + P^{2^{(i-2)}c} \right) \cdot \cdots \cdot (P^{2a} + P^{2b} + P^{2c}) \cdot (P^a + P^b + P^c)$$

and thus $\phi^{-1}$ may be determined relatively simply, but as the value of *i* increases, the computational complexity due to $\phi^{-1}$ increases. Therefore, the *i* value may be appropriately limited and used according to the complexity allowable in the system. In general, the *i* value is preferably used in the range of $0 \leq i \leq 4$, but a larger value may be used depending on an allowable range of the system.

For reference, the operation $P^x \cdot \underline{v}^T$ which involves multiplying a bit string $\underline{v}^T$ of length *Z* by a circular permutation matrix $P^x$ of size $Z \times Z$ is not an actual matrix multiplication operation, but rather equivalent to performing a circular shift of *x* bits on the bit string $\underline{v}^T$. That is, the operation is a calculation or an operation with very low complexity, since it may be implemented by a bit shift operation rather than a matrix multiplication in reality. Furthermore, in the process of calculating $\phi^{2i-1} \cdot \underline{v}^T$, the complexity of the calculation may be minimized by performing a step-by-step calculation, such as $\phi^{2i-1} \cdot \underline{v}^T = \phi^{2i-1} (\cdots (\phi^2(\phi \cdot \underline{v}^T)))$, rather than extending and calculating each term of $\phi^{2i-1}$. As a simple example, the operations may be performed in the following manner:

$$(P^{2a} + P^{2b} + P^{2c}) \cdot (P^a + P^b + P^c) \cdot \underline{v}^T = P^{3a} \left( I + P^{2(b-a)} + P^{2(c-a)} \right) \cdot$$
$$\left( I + P^{b-a} + P^{c-a} \right) \cdot \underline{v}^T = P^{3a} \left( I + P^{2(b-a)} + P^{2(c-a)} \right) \cdot \left( \underline{v}^T + P^{b-a} \cdot \underline{v}^T + P^{c-a} \cdot \right.$$
$$\left. \underline{v}^T \right) = P^{3a} \left( I + P^{2(b-a)} + P^{2(c-a)} \right) \cdot \underline{v}_1^T = P^{3a} \left( \underline{v}_1^T + P^{2(b-a)} \cdot \underline{v}_1^T + P^{2(c-a)} \cdot \right.$$
$$\left. \underline{v}_1^T \right) = P^{3a} \cdot \underline{v}_2^T .$$

The same method may be used to determine $\phi^{-1}$ and perform encoding even in the case of $|a - b| = \dfrac{Z}{2^i}$ or

$|b - c| = \frac{Z}{2^i}$ in Exponent condition 2a. However, if all the differences between two exponents are in the form of $\frac{Z}{2^i}$, the cycle characteristic may be likely to deteriorate. Therefore, for efficient encoding and good cycle characteristics, a method may be considered in which at least one of the differences between two exponents satisfies the characteristic of $\frac{Z}{2^i}$ $(0 \le i \le L)$ and the remaining exponent differences satisfy Exponent condition 1a or Exponent condition 1b.

In addition, if a difference between the two exponents is $\frac{Z}{2^i}$ and at least one of Exponent condition 1a or Exponent condition 1b is satisfied, the exponents may be selected.

Exponential condition 2b is a condition for further restricting an exponent condition than Exponent condition 2a to make more efficient encoding possible and to further improve the cycle characteristics. In case that Exponent condition 2b is satisfied, although the encoding complexity is slightly increased compared to the existing 5G LDPC code, the cycle characteristics are improved. Of course, if there is no case in which Exponent condition 2b is satisfied, exponents may be determined by considering Exponent condition 2a. For reference, except for the case where $\frac{Z}{2^i} = 1$ is satisfied in Exponential condition 2a, it may be seen that the difference between the two exponents is not always relatively prime to $Z$. In other words, the difference between the two exponents and $Z$ have a common divisor greater than 1. The existence of an $i$ satisfying $\frac{Z}{2^i} = 1$ implies that $Z = 2^L$. This means that, only if Exponent condition 2b is satisfied, the difference between two exponents and $Z$ are not coprime under the condition $1 \le i < L$, and they share $2^{L-i}$ as a common divisor.

An embodiment of the disclosure will now describe a more specific example of configuring the submatrix B 1020 in FIG. 10 by using the exponent conditions.

First, a communication system or broadcast system is considered, in which a lifting size set as shown in Tables 3 to 8, as in 5G, is defined, and only the lifting sizes included in the lifting size set may be applied. In addition, a separate parity check matrix or exponent matrix may be defined for each lifting size set. That is, in the case of Tables 3 to 8, a total of eight sets of parity check matrices or exponent matrices may be defined for each of the eight set indices.

It is assumed that in Equation 15 and another type of submatrix B extended based on Equation 15, *a, b,* and *c* are determined as follows. In general, since exponent values of *a, b, c* of the sub-matrix B of the parity check matrix corresponding to $i_{LS} = k \, (k = 0, 1, 2, ...)$ may be all different, they are expressed as $a_k$, $b_k$, and $c_k$ for the sake of convenience.

**Exponent selection example <u>1</u>** ($i_{LS} = k$)

- $a_k$ is an arbitrary integer
- $b_k$ is $b_k = a_k + s_k$, where $s_k$ is an integer satisfying $\gcd(s_k, Z_k) = 1$, i.e., $a_k$ and $b_k$ are an integer satisfying $\gcd(|a_k - b_k|, Z_k) = 1$ among the exponents corresponding to the submatrix B. Here, $\gcd(x, y)$ denotes the greatest common divisor of $x$ and $y$, and $Z_k$ denotes any lifting size included in the lifting size set corresponding to $i_{LS} = k$.
- $c_k$ is $c_k = a_k + t_k$, where $t_k$ is one of the lifting size values smaller than the largest lifting size $Z_{k,max}$ among lifting size values included in in the lifting size set corresponding to $i_{LS} = k$.

When calculating the differences of the exponents for the submatrix B determined via Exponent selection example 1, $|a_k - b_k| = |s_k|$ is satisfied for an arbitrary lifting size $Z_k$, and thus Exponent condition 1a is satisfied, and since $t_k$ is one of the $Z_k$ values in $|b_k - c_k| = |s_k - t_k|$, and each of the $Z_k$ values has a multiple relationship ($2^i$ multiple relationship) with each other, according to the definition of $s_k$, $1 = \gcd(s_k, Z_k) = gcd(s_k - Z_k, Z_k) = \gcd(s_k - t_k, Z_k)$ is established, and thus Exponent condition 1b is also satisfied. However, since $|c_k - a_k| = t_k = \frac{Z_{max}}{2^i} = p \cdot 2^{(L-i)}$, whether Exponent conditions 2a and 2b are satisfied depends on the lifting size $Z_k$. For example, in the case of $Z_k > t_k$, Exponent conditions 2a and 2b are always satisfied, but in the case of $Z_k \le t_k$, $c_k = a_k + t_k \equiv a_k \pmod{Z_k}$ is established, and $Z_k \times Z_k$-sized circulant permutation matrices $P^{a_k}$ and $P^{c_k}$ are substantially the same, so Exponent conditions 2a and 2b may not be satisfied. In other words, in the case of $Z_k \le t_k$, a structure of Equation 16 is obtained, and this means that the cycle characteristics are not improved. In conclusion, in order to improve the cycle characteristics with regard to various lifting sizes, it is preferable to determine the $t_k$ value to be as small as possible.

However, in the case where the lifting size $Z_k$ value for LDPC encoding is relatively large compared to $t_k$ (i.e., in the case where the $i$ value is large in $\frac{Z_k}{t_k} = 2^i$), the encoding complexity may significantly increase due to $\phi^{-1}$ matrix-related

operations. Therefore, the $t_k$ value may be selected in consideration of the cycle characteristics and the encoding complexity. If only the cycle characteristic improvement is considered, the smallest lifting size among the lifting size values in the lifting size set corresponding to $i_{LS} = k$ may be selected as $t_k$. In addition, when considering limited increase in encoding complexity, a lifting size larger than the smallest lifting size in the lifting size set corresponding to $i_{LS} = k$ and smaller than the largest lifting size may be selected as $t_k$. In general, when the lifting sizes included in the lifting size set are $Z_1 = p \cdot 2^{j_1}$, $Z_2 = p \cdot 2^{j_2}$, ..., $Z_{max} = p \cdot 2^{j_{max}}$ ($j_1 < j_2 < \cdots < j_{max}$), the $t_k$ value may be configured as $t_k = p \cdot 2^i$ ($j_1 < i < j_{max}$). If the values of $j_1, j_2, ..., j_{max}$ are not consecutive integer values, the i value may be selected as an integer other than $j_2, j_3$, or the like. In addition to the above embodiments, $t_k$ may be selected based on various conditions as described above for other embodiments as well, and detailed descriptions may be omitted for the sake of convenience.

As a specific example of the method for selecting an exponent, for the convenience, an example of exponent selection when $a = 1$, that is, $P^a = P^1$ is configured is described below.

**Exponent selection example 2** ($i_{LS} = k$)

-

$$a_k = 1 \ (\rightarrow P^a = P)$$

- $b_k = 0$ ($s_k = -1$ is configured, gcd($|a_k - b_k|, Z_k$) = 1 and $P^b = I$)
- $c_k$ is $c_k = 1 + t_k$ (or $c_k = 1 - t_k$), where $t_k$ is one of the lifting size values smaller than the largest lifting size $Z_{k,max}$ among lifting size values included in in the lifting size set corresponding to $i_{LS} = k$.

Calculating the difference of the exponents for the submatrix B determined through Exponent selection example 2, $|a_k - b_k| = 1$ holds, ensuring that gcd($|a_k - b_k|, Z_k$) = 1 is always satisfied for an arbitrary lifting size $Z_k$, and since $|b_k - c_k| = 1 + t_k$ is satisfied to ensure 1 = gcd(1, $Z_k$) = gcd(1 + $Z_k, Z_k$) = gcd(1 + $t_k, Z_k$), Exponent condition 1a and Exponent condition 1b may be satisfied. As in Exponent selection example 2 above, in the case of $b_k = 0$, Exponent condition 1a and Exponent condition 1b may be satisfied for an arbitrary $a_k$ generally satisfying gcd($a_k, Z_k$) = 1 as well as $a_k = 1$. That is, for an integer a satisfying gcd($a, Z_k$) = 1, the submatrix B configured as $a_k = a$, $b_k = 0$, and $c_k = a + t_k$ satisfies Exponent condition 1a and Exponent condition 1b. In addition, since $\left| c_k - a_k \right| = t_k = \dfrac{Z_{max}}{2^i} = p \cdot 2^{(L-i)}$ holds, whether Exponent condition 2a and Exponent condition 2b are satisfied depends on the lifting size $Z_k$. Here, $t_k$ (or $c_k$) may be selected based on various conditions, as described earlier, considering cycle characteristic improvement and encoding complexity.

A specific embodiment related to Exponent selection example 2 is described below.

Given the lifting size set as in Table 8, a specific example of the submatrix B is represented in Equation 18 below. Equation 18 shows an example of the submatrix B in the parity check matrix for $i_{LS} = 0$ in Table 8. (This is an example of configuring ($P^a, P^b, P^c$) for the matrices in Equation 15.) The submatrix B may be determined based on at least one of the matrices included in Equation 18 below. However, the embodiments of the disclosure are not limited thereto. In other words, the following embodiment has been described as an example in which 32 is selected as the lifting size, but any one of the lifting sizes included in Table 8 may be selected. Therefore, various matrices may be considered, based on c determined according to the lifting size.

[Equation 18]

$$- \ a = 1, \ b = 0, \ c = 1 + 32 = 33 \ \text{(selection of 32 from the lifting size)}$$

$$B_1 = \begin{bmatrix} P^1 & I & 0 \\ I & I & I \\ P^{33} & 0 & I \end{bmatrix}, \quad B_{2,1} = \begin{bmatrix} P^1 & I & 0 & 0 \\ I & I & I & 0 \\ 0 & 0 & I & I \\ P^{33} & 0 & 0 & I \end{bmatrix}, \quad B_{2,2} = \begin{bmatrix} P^1 & I & 0 & 0 \\ 0 & I & I & 0 \\ I & 0 & I & I \\ P^{33} & 0 & 0 & I \end{bmatrix}, \quad B_3 =$$

$$\begin{bmatrix} P^1 & I & 0 & 0 & 0 \\ 0 & I & I & 0 & 0 \\ I & 0 & I & I & 0 \\ 0 & 0 & 0 & I & I \\ P^{33} & 0 & 0 & 0 & I \end{bmatrix}, \quad B_{4,1} = \begin{bmatrix} P^1 & I & 0 & 0 & 0 & 0 \\ 0 & I & I & 0 & 0 & 0 \\ 0 & 0 & I & I & 0 & 0 \\ I & 0 & 0 & I & I & 0 \\ 0 & 0 & 0 & 0 & I & I \\ P^{33} & 0 & 0 & 0 & 0 & I \end{bmatrix},$$

$$B_{4,2} = \begin{bmatrix} P^1 & I & 0 & 0 & 0 & 0 \\ 0 & I & I & 0 & 0 & 0 \\ I & 0 & I & I & 0 & 0 \\ 0 & 0 & 0 & I & I & 0 \\ 0 & 0 & 0 & 0 & I & I \\ P^{33} & 0 & 0 & 0 & 0 & I \end{bmatrix}.$$

In the case of Equation 18, when the lifting size $Z$ is selected to be 32 or less, such as 8, 16, or 32, from the 0-th lifting size set, $P^{33} = P^1$ holds due to $33 \equiv 1 \pmod{Z}$, and consequently, the $\phi$ matrix effectively becomes an identity matrix $I$ and its inverse $\phi^{-1}$ also becomes an identity matrix $I$, which simplifies the encoding process but has the disadvantage of failing to improve cycle characteristics. On the other hand, considering a limited increase in encoding complexity while improving cycle characteristics, the following combinations for the exponent triplet ($a$, $b$, $c$) corresponding to ($P^a$, $P^b$, $P^c$) in the submatrix with the structure of Equation 18 may be possible.

[Table 10]

| Set index ($i_{LS}$) | (a, b) | c |
|---|---|---|
| 0 | | 17 or 33 or 65 (or 129) |
| 1 | | 25 or 49 or 97 (or 193) |
| 2 | | 21 or 41 or 81 (or 161) |
| 3 | (a, b) = (1,0) | 15 or 29 or 57 (or 113) |
| 4 | | 19 or 37 or 73 (or 145) |
| 5 | | 23 or 45 or 89 (or 177) |
| 6 | | 27 or 53 (or 105) |
| 7 | | 31 or 61 (or 121) |

Table 10 is an example, and generally, a value t among values smaller than Zmax may be selected and determined as $c = t + 1$.

As an embodiment of the disclosure, the $c$ value may be determined based on the largest lifting size among the lifting sizes smaller than a specific reference value. To describe in detail, if the reference value is configured to be 96, in a system using lifting size sets as in Tables 3 to 8, numbers equal to or less than 96 in each lifting size set are 64, 96, 80, 56, 72, 88, 52, and 60 in sequence. Therefore, if a c value corresponding to the parity check matrix defined according to each lifting size set index is determined based on the given reference value in each lifting size set, the c value may be defined as 65, 97, 81, 57, 73, 89, 53, and 61 in the order of each lifting size set index. If the reference value is configured as 48, in a similar manner, the c value may be defined as 33, 49, 41, 29, 37, 45, 27, and 31 in sequence according to each lifting size set index. For reference, when using a lifting size set excluding the numbers in the parentheses in [Table 3] or [Table 8], if an i-th largest lifting size in the lifting size set having $i_{LS}$ = 1 is determined as a reference value, a c value corresponding to the parity check matrix defined according to each lifting size set index may be determined as an integer obtained by adding 1 to the i-th largest lifting size in each set.

In addition, for the uniformity in the encoding method, the i-th largest lifting size may be selected from each lifting size set (i = 2, 3, 4, ...). For example, in a system using the lifting size set as in [Table 3], a fifth largest number in each of the lifting size sets is 16, 24, 20, 14, 18, 22, 13, and 15, respectively. Therefore, if the *c* value corresponding to the parity check matrix defined according to each lifting size set index is determined based on the fifth largest number in each lifting size set (i=5), the *c* value may be defined in the order of 17, 25, 21, 15, 19, 23, 14, and 16 according to each lifting size set index. In a similar manner, if the *c* value corresponding to the parity check matrix defined according to the lifting size set index is determined based on the fourth largest number in each lifting size set (i=4), the *c* value may be defined in order of the lifting size set index as 33, 49, 41, 29, 37, 45, 27, and 31. In a similar manner, if the *c* value corresponding to the parity check matrix defined according to the lifting size set index is determined based on the third largest number in each lifting size set (i=3), the *c* value may be defined in order of the lifting size set index as 65, 97, 81, 57, 73, 89, 53, and 61. In a similar manner, if the *c* value corresponding to the parity check matrix defined according to the lifting size set index is determined based on the second largest number in each lifting size set (i=2), the *c* value may be defined in order of the lifting size set index as 129, 193, 161, 113, 145, 177, 105, and 121.

In a system using a lifting size set excluding the values in the parentheses in [Table 8], the fifth largest number in each of the lifting size sets is 32, 48, 40, 28, 36, 44, 26, and 30. Therefore, if the *c* value corresponding to the parity check matrix defined according to each lifting size set index is determined based on the fifth largest number in each lifting size set (i=5), the *c* value may be defined in the order of 33, 49, 41, 29, 37, 45, 27, and 31 according to each lifting size set index. In a similar manner, if the *c* value corresponding to the parity check matrix defined according to the lifting size set index is determined based on the fourth largest number in each lifting size set (i=4), the *c* value may be defined in order of the lifting size set index as 65, 97, 81, 57, 73, 89, 53, and 61. In a similar manner, if the c value corresponding to the parity check matrix defined according to the lifting size set index is determined based on the third largest number in each lifting size set (i=3), the *c* value may be defined in order of the lifting size set index as 129, 193, 161, 113, 145, 177, 105, and 121. In a similar manner, if the *c* value corresponding to the parity check matrix defined according to the lifting size set index is determined based on the second largest number in each lifting size set (i=2), the *c* value may be defined in order of the lifting size set index as 257, 385, 321, 225, 289, 353, 209, and 241.

In addition, according to a pair $(P^a, P^b, P^c) = (P, I, P^c)$ indicated in Equation 18, Table 10, and the corresponding embodiment, the $\phi$ matrix becomes $\phi = P + I + P^c$. According to Exponent selection example 2, when the lifting size $Z_k$ value is smaller or equal to $(c - 1)$, $c \equiv 1 \pmod{Z_k}$ is satisfied, and thus, $P^a = P = P^c$ holds, so that the cycle characteristics are not improved, but efficient LDPC encoding is possible by using $\phi = I + P + P^c = I = \phi^{-1}$ satisfied. In the case where the listing size $Z_k$ value is larger than $(c - 1)$, there exists i satisfying $(P)^{2i} = (P^c)^{2i}$ $(i = 1)$ so that $\phi^{2i} = I$ is satisfied, and therefore, using the property that $\phi^{-1} = \phi^{2i-1} = \phi^{2i-1} \cdot \phi^{2i-2} \cdot \cdots \cdot \phi^2 \cdot \phi$, it is possible to perform efficient LDPC encoding while increasing the encoding complexity. Here, the cycle length determined by $P^a$ and $P^c$ increases from the existing $2m_{b1}$ to $2m_{b1} \cdot Z/D = 2m_{b1} \cdot 2^i = 2^{i+1} \cdot m_{b1}$. The cycle length determined by $P^a$ and $P^b$ or $P^b$ and $P^c$ is increased significantly in proportion to the Z value because Exponent condition 1a and Exponent condition 1b are satisfied.

As a specific example of the method for selecting an exponent, for the convenience, an example of exponent selection when $a = 0$, that is, $P^a = I$ is configured is described below.

**<u>Exponent selection example 3</u>** ($i_{LS} = k$)

-

$$a_k = 0 \ (\rightarrow P^a = I)$$

- $b_k = 1$ ($s_k = 1$ is configured, gcd($|a_k - b_k|$, $Z_k$) = 1 and $P^b = P$)
- $c_k$ is $c_k = t_k$ (or $c_k = -t_k$), where $t_k$ is one of lifting size values smaller than the largest lifting size $Z_{k,max}$ among lifting size values included in the lifting size set corresponding to $i_{LS} = k$.

Calculating the difference of the exponents for the submatrix B determined through Exponent selection example 3, $|a_k - b_k| = 1$ holds, ensuring that gcd($|a_k - b_k|$, $Z_k$) = 1 is always satisfied for an arbitrary lifting size $Z_k$, and since $|b_k - c_k| = t_k - 1$ is satisfied to ensure $1 = \gcd(1, Z_k) = \gcd(Z_k - 1, Z_k) = \gcd(t_k - 1, Z_k)$, Exponent condition 1a and Exponent condition 1b may be satisfied. As in Exponent selection example 3 above, in the case of $a_k = 0$, Exponent condition 1a and Exponent condition 1b may be satisfied for an arbitrary $b_k$ generally satisfying gcd($b_k$, $Z_k$) = 1 as well as $b_k = 1$. That is, for an integer a satisfying $gcd(b, Z_k) = 1$, the submatrix B configured as $a_k = 0$, $b_k = b$, and $c_k = t_k$ satisfies Exponent condition 1a and Exponent condition 1b. In addition, since $\left| c_k - a_k \right| = t_k = \frac{Z_{max}}{2^i} = p \cdot 2^{(L-i)}$ holds, whether Exponent condition 2a and Exponent condition 2b are satisfied depends on the lifting size $Z_k$. Here, $t_k$ (or $c_k$) may be selected based on various conditions, as described earlier, considering cycle characteristic improvement and encoding complexity.

A specific embodiment related to Exponent selection example 3 is described below.

Given the lifting size set as in Table 8, a specific example of the submatrix B is represented in Equation 19 below. Equation 19 shows an example of the submatrix B in the parity check matrix for $i_{LS} = 0$ in Table 8. (This is an example of configuring ($P^a$, $P^b$, $P^c$) for the matrices in Equation 15.) The submatrix B may be determined based on at least one of the matrices included in Equation 19 below. However, the embodiments of the disclosure are not limited thereto. In other words, the following embodiment has been described as an example in which 32 is selected as the lifting size, but any one of the lifting sizes included in Table 8 may be selected. Therefore, various matrices may be considered, based on c determined according to the lifting size.

$$[Equation\ 19]$$

$$- \ a = 0, \ b = 1, \ c = 32$$

(selection of 32 from the lifting size)

$$B_1 = \begin{bmatrix} I & I & O \\ P & I & I \\ P^{32} & O & I \end{bmatrix}, \ B_{2,1} = \begin{bmatrix} I & I & O & O \\ P & I & I & O \\ O & O & I & I \\ P^{32} & O & O & I \end{bmatrix}, \ B_{2,2} = \begin{bmatrix} I & I & O & O \\ O & I & I & O \\ P & O & I & I \\ P^{32} & O & O & I \end{bmatrix}, \ B_3 =$$

$$\begin{bmatrix} I & I & O & O & O \\ O & I & I & O & O \\ P & O & I & I & O \\ O & O & O & I & I \\ P^{32} & O & O & O & I \end{bmatrix}, \ B_{4,1} = \begin{bmatrix} I & I & O & O & O & O \\ O & I & I & O & O & O \\ O & O & I & I & O & O \\ P & O & O & I & I & O \\ O & O & O & O & I & I \\ P^{32} & O & O & O & O & I \end{bmatrix},$$

$$B_{4,2} = \begin{bmatrix} I & I & O & O & O & O \\ O & I & I & O & O & O \\ P & O & I & I & O & O \\ O & O & O & I & I & O \\ O & O & O & O & I & I \\ P^{32} & O & O & O & O & I \end{bmatrix}.$$

In the case of Equation 19, when the lifting size $Z$ is selected to be 32 or less, such as 8, 16, or 32, from the 0-th lifting size set, $P^{32} = P^0 = I$ holds due to $32 \equiv 0 \pmod Z$, and consequently, the $\phi$ matrix effectively becomes a circulant permutation matrix $P$ and its inverse $\phi^{-1}$ also becomes a circulant permutation matrix $P^{-1}$, which simplifies the encoding process but has the disadvantage of failing to improve cycle characteristics. On the other hand, considering a limited increase in encoding complexity while improving cycle characteristics, the following combinations for the exponent triplet ($a$, $b$, $c$) corresponding to ($P^a$, $P^b$, $P^c$) in the submatrix with the structure of Equation 18 may be possible.

[Table 11]

| Set index ($i_{LS}$) | (a, b) | c |
|---|---|---|
| 0 | | 16 or 32 or 64 (or 128) |
| 1 | | 24 or 48 or 96 (or 192) |
| 2 | | 20 or 40 or 80 (or 160) |
| 3 | | 14 or 28 or 56 (or 112) |
| 4 | (a, b) = (0,1) | 18 or 36 or 72 (or 144) |
| 5 | | 22 or 44 or 88 (or 176) |
| 6 | | 26 or 52 (or 104) |
| 7 | | 30 or 60 (or 120) |

Table 11 is an example, and generally, a value $t$ among values smaller than Zmax may be selected and determined as $c = t$.

As an embodiment of the disclosure, the $c$ value may be determined based on the largest lifting size among the lifting sizes smaller than a specific reference value. To describe in detail, if the reference value is configured to be 96, in a system using lifting size sets as in Tables 3 to 8, numbers equal to or less than 96 in each lifting size set are 64, 96, 80, 56, 72, 88, 52, and 60 in sequence. Therefore, if a c value corresponding to the parity check matrix defined according to each lifting size set index is determined based on the given reference value in each lifting size set, the c value may be defined as 64, 96, 80, 56, 72, 88, 52, and 60 in the order of each lifting size set index. If the reference value is configured as 48, in a similar manner, the c value may be defined as 32, 48, 40, 28, 36, 44, 26, and 30 in sequence according to each lifting size set index. When using a lifting size set excluding the numbers in the parentheses in [Table 3] or [Table 8], if an i-th largest lifting size in the lifting size set having $i_{LS} = 1$ is determined as a reference value, a $c$ value corresponding to the parity check matrix defined according to each lifting size set index may be determined as the i-th largest lifting size in each set.

In addition, for the uniformity in the encoding method, the i-th largest lifting size may be selected from each lifting size set (i = 2, 3, 4, 5, 6, ...). For example, in a system using the lifting size set as in [Table 3], a fifth largest number in each of the lifting size sets is 16, 24, 20, 14, 18, 22, 13, and 15, respectively. Therefore, if the $c$ value corresponding to the parity check matrix defined according to each lifting size set index is determined based on the fifth largest number in each lifting size set (i=5), the $c$ value may be defined in the order of 16, 24, 20, 14, 18, 22, 13, and 15 according to each lifting size set index. In a similar manner, if the $c$ value corresponding to the parity check matrix defined according to the lifting size set index is determined based on the fourth largest number in each lifting size set (i=4), the $c$ value may be defined in order of the lifting size set index as 32, 48, 40, 28, 36, 44, 26, and 30. In a similar manner, if the c value corresponding to the parity check matrix defined according to the lifting size set index is determined based on the third largest number in each lifting size set (i=3), the $c$ value may be defined in order of the lifting size set index as 64, 96, 80, 56, 72, 88, 52, and 60. In a similar manner, if the $c$ value corresponding to the parity check matrix defined according to the lifting size set index is determined based on the second largest number in each lifting size set (i=2), the c value may be defined in order of the lifting size set index as 128, 192, 160, 112, 144, 176, 104, and 120.

In a system using a lifting size set excluding the values in the parentheses in [Table 8], the fifth largest number in each of the lifting size sets is 32, 48, 40, 28, 36, 44, 26, and 30. Therefore, if the $c$ value corresponding to the parity check matrix defined according to each lifting size set index is determined based on the fifth largest number in each lifting size set (i=5), the $c$ value may be defined in the order of 32, 48, 40, 28, 36, 44, 26, and 30 according to each lifting size set index. In a similar manner, if the $c$ value corresponding to the parity check matrix defined according to the lifting size set index is determined based on the fourth largest number in each lifting size set (i=4), the $c$ value may be defined in order of the lifting size set index as 64, 96, 80, 56, 72, 88, 52, and 60. In a similar manner, if the $c$ value corresponding to the parity check matrix defined according to the lifting size set index is determined based on the third largest number in each lifting size set (i=3), the c value may be defined in order of the lifting size set index as 128, 192, 160, 112, 144, 176, 104, and 120. In a similar manner, if the $c$ value corresponding to the parity check matrix defined according to the lifting size set index is determined based on the second largest number in each lifting size set (i=2), the $c$ value may be defined in order of the lifting size set index as 256, 384, 320, 224, 288, 353, 208, and 240.

In addition, according to a pair $(P^a, P^b, P^c) = (I, P, P^c)$ indicated in Equation 19, Table 11, and the corresponding embodiment, the $\phi$ matrix becomes $\phi = I + P + P^c$. According to Exponent selection example 3, when the lifting size $Z_k$ value is smaller or equal to $c$, $c \equiv 0 \pmod{Z_k}$ is satisfied, and thus, $P^a = I = P^c$ holds, so that the cycle characteristics are not improved, but efficient LDPC encoding is possible by using $\phi = P$ and $\phi^{-1} = P^{-1}$ satisfied. In the case where the listing size $Z_k$ value is larger than $c$, there exists i satisfying $(P^c)^{2i} = I (i \geq 1)$ so that $\phi^{2i} = I$ is satisfied, and therefore, using the property that $\phi^{-1} = \phi^{2i-1} = \phi^{2i-1} \cdot \phi^{2i-2} \cdot \cdots \cdot \phi^2 \cdot \phi$, it is possible to perform efficient LDPC encoding while increasing the encoding complexity. Here, the cycle length determined by $P^a$ and $P^c$ increases from the existing $2m_{b1}$ to $2m_{b1} \cdot Z/D = 2m_{b1} \cdot 2^i = 2^{i+1} \cdot m_{b1}$. The cycle length determined by $P^a$ and $P^b$ or $P^b$ and $P^c$ is increased significantly in proportion to the $Z$ value because Exponent condition 1a and Exponent condition 1b are satisfied.

Exponent selection example 1, Exponent selection example 2, and Exponent selection example 3 are methods for selecting an exponent of a circulant permutation matrix that configures the submatrix B 1020 in the parity check matrix of FIG. 10, which simultaneously consider the cycle characteristic improvement and encoding complexity. The above-described examples of exponent selection suggest a method where, when the lifting size is small and the code length is short, the cycle characteristics are not improved but the coding complexity is very low, and as the lifting size increases, the coding complexity increases slightly but the cycle characteristics are improved. In general, since LDPC codes are more sensitive to the error floor phenomenon due to cycle characteristics as the code length increases, the above methods in which the code length increases together with the lifting size and the cycle characteristics are further improved may be considered as methods for improving the error floor phenomenon according to the length of the LDPC code.

Of course, in the case of a small lifting size and a short code length, the cycle characteristic does not greatly affect the error floor phenomenon, but even in the case of a small lifting size, a method for improving the cycle characteristic may be applied.

As an embodiment of the disclosure, a method for improving cycle characteristics in a case where the code length is short is described.

**<u>Exponent selection example 4</u>** ($i_{LS} = k$)

- $a_k$ is an arbitrary integer
- $b_k$ is $b_k = a_k + s_k$, where $s_k$ is an integer satisfying gcd($s_k$, $Z_k$) = 1, i.e., $a_k$ and $b_k$ are an integer satisfying gcd($|a_k - b_k|$, $Z_k$) = 1 among the exponents corresponding to the submatrix B. Here, gcd($x$, $y$) denotes the greatest common divisor of $x$ and $y$, and $Z_k$ denotes any lifting size included in the lifting size set corresponding to $i_{LS} = k$. (wherein $Z_k = p_k \cdot 2^{L_k}$, $p_k$ is an odd number, and $L_k \geq 0$)

- $c_k$ satisfies $\quad c_k = a_k + \dfrac{Z_k}{2^{\min(J, L_k)}} = a_k + p_k \cdot 2^{L_k - 2^{\min(J, L_k)}}$

$$\text{or } c_k = \begin{cases} a_k + p_k, & L_k < J \\ a_k + \frac{Z_k}{2^J}, & L_k \geq J \end{cases} \left( = \begin{cases} a_k + p_k, & L_k < J \\ a_k + p_k \cdot 2^{L_k - J}, & L_k \geq J \end{cases} \right).$$

If the size of $Z_k$ supported by the system is always equal to or larger than $p_k \cdot 2^J$, it may be simply expressed as

$$c_k = a_k + \frac{Z_k}{2^J} (= a_k + p_k \cdot 2^{L_k - J}).$$

Exponent selection example 4 describes a method in which all the exponents of the circulant permutation matrix ($P^a$, $P^b$, $P^c$) are not fixed values, but are variably determined based on at least one lifting size Z. Therefore, even if lifting size sets other than the lifting size sets in [Table 3] to [Table 8] are defined, the method proposed in the disclosure may be applied.

If $L_k < J$ holds in $Z_k = p_k \cdot 2^{L_k}$, $\dfrac{Z_k}{2^J}$ is not an integer, and thus in the above example, the example may be configured to satisfy $c_k = a_k + p_k$. That is, the $c_k$ value may be variably determined according to the $Z_k$ values supported by the system and the given J value. If the $Z_k$ value supported by the system is greater than or equal to $p_k \cdot 2^J$, since $\dfrac{Z_k}{2^J}$ is always an integer, the example may be determined using one method such as $c_k = a_k + \dfrac{Z_k}{2^J}$.

In the method of Exponent selection example 4, Exponent conditions 1a and 1b are satisfied, and whether Exponent conditions 2a and 2 are satisfied differs according to the lifting size $Z_k$. For example, in case that the range of the $Z_k$ value supported is equal to or greater than $p_k \cdot 2^J$, Exponent condition 2a and Exponent condition 2b are satisfied, and in case that the range is smaller than $p_k \cdot 2^J$, Exponent condition 2a and Exponent condition 2b are not satisfied.

According to the embodiment of Exponent selection example 4, when $Z_k \geq p_k \cdot 2^J$ (or $L_k \geq J$) is satisfied, the cycle length determined by $P^a$ and $P^c$ increases from the existing $2m_{b1}$ to $2^{J+1} \cdot m_{b1}$, and when $Z_k < p_k \cdot 2^J$ (or $L_k < J$) is satisfied, the cycle length increases to $2^{L_k+1} \cdot m_{b1}$. (In the case of $L_k = 0$, the value is not increased.) The cycle length determined by $P^a$ and $P^b$ or $P^b$ and $P^c$ is increased significantly in proportion to the Z value because Exponent condition 1a and Exponent condition 1b are satisfied.

In addition, in the case of $Z_k \geq p_k \cdot 2^J$ (or $L_k \geq J$), the $\phi$ matrix is

$$\phi = P^{a_k} + P^{a_k + s_k} + P^{a_k + \frac{Z}{2^J}} = P^{a_k} \left( I + P^{s_k} + P^{\frac{Z}{2^J}} \right)$$

and thus LDPC encoding is possible using

$$\phi^{2^J} = P^{a_k \cdot 2^J} \cdot \left( I + P^{s_k \cdot 2^J} + P^Z \right) = P^{(a_k + s_k) \cdot 2^J}$$

$\phi^{-1} = P^{-(a_k + s_k) \cdot 2^J} \cdot \phi^{2^J - 1} = {}_P{}^{-(a_k + s_k) \cdot 2^J} \cdot \phi^{2^J - 1} \cdot \phi^{2^J - 2} \cdot \cdots \cdot \phi^2 \cdot \phi$. In the case of $Z_k < p_k \cdot 2^J$ (or $L_k < J$), the $\phi$ matrix is

$$\phi = P^{a_k} + P^{a_k+s_k} + P^{a_k+p_k} = P^{a_k}(I + P^{s_k} + P^{p_k}),$$

and since there is an integer $j$ $(j < J)$ satisfying $\phi^{2^j} = P^{a_k \cdot 2^j}(I + P^{s_k \cdot 2^j} + P^Z) = P^{(a_k+s_k) \cdot 2^j}$, LDPC encoding is possible in a similar manner.

The method of Exponent selection example 4 has a disadvantage in that the maximum value of the cycle length that may be improved depending on the J value is fixed regardless of the lifting size Z, but has the advantage that the cycle characteristics are improved even when the lifting size Z is small. In other words, the cycle characteristics may be improved for various lifting sizes by determining at least one of the exponents of the circulant permutation matrix ($P^a$, $P^b$, $P^c$) variably based on the lifting size Z instead of all of the exponents being fixed integer values.

As a specific example of Exponent selection example 4, for the convenience, an example of exponent selection when $a = 1$, that is, $P^a = P^1$ is configured is described below.

**Exponent selection example 5** ($i_{LS} = k$)

-

$$a_k = 1 \; (P^a = P)$$

-

$$b_k = 0 \; (P^b = I)$$

-    $c_k$ satisfies $c_k = 1 + \dfrac{Z_k}{2^{\min(J,L_k)}} = 1 + p_k \cdot 2^{L_k - 2^{\min(J,L_k)}}$

or $c_k = \begin{cases} 1 + p_k, & L_k < J \\ 1 + \frac{Z_k}{2^J}, & L_k \geq J \end{cases} \left( = \begin{cases} 1 + p_k, & L_k < J \\ 1 + p_k 2^{L_k - J}, & L_k \geq J \end{cases} \right).$

If the size of $Z_k$ supported by the system is always equal to or larger than $p_k \cdot 2^J$, it may be simply expressed as

$c_k = 1 + \dfrac{Z_k}{2^J} (= 1 + p_k \cdot 2^{L_k - J})$ .

As in Exponent selection example 5 above, in the case of $b_k = 0$, Exponent condition 1a and Exponent condition 1b are satisfied for an arbitrary $a_k$ satisfying $\gcd(a_k, Z_k) = 1$ as well as $a_k = 1$. That is, for an integer $a$ satisfying $\gcd(a, Z_k) = 1$,

the submatrix B configured as $a_k = a$, $b_k = 0$, and $c_k = 1 + p_k \cdot 2^{\max(L_k - J, 0)}$ (or $c_k = \begin{cases} a + p_k, & L_k < J \\ a + \frac{Z_k}{2^J}, & L_k \geq J \end{cases}$ ) satisfies Exponent condition 1a and Exponent condition 1b.

In accordance with a method as in Exponent selection example 5 above,

$\phi^{2^J} = P^{a \cdot 2^J} + I + P^{a \cdot 2^J + Z} = I$ is satisfied, and thus efficient encoding is possible by using $\phi^{-1} = \phi^{2^J - 1} \cdot \phi^{2^J - 2} \cdot \cdots \cdot \phi^2 \cdot \phi$.

As a more specific example of Exponent selection example 4, for the convenience, an example of exponent selection when $a = 0$, that is, $P^a = I$ is configured is described below.

**Exponent selection example 6** ($i_{LS} = k$)

-

$$a_k = 0 \; (P^a = I)$$

-

$$b_k = 1 \; (P^b = P)$$

- $c_k$ satisfies $\;\; c_k = \dfrac{Z_k}{2^{\min(J,L_k)}} = p_k \cdot 2^{L_k - 2^{\min(J,L_k)}}$

or $\;\; c_k = \begin{cases} p_k, & L_k < J \\ \dfrac{Z_k}{2^J}, & L_k \geq J \end{cases} = \begin{cases} p_k, & L_k < J \\ p_k \cdot 2^{L_k - J}, & L_k \geq J \end{cases}.$

If the size of $Z_k$ supported by the system is always equal to or larger than $p_k \cdot 2^J$, it may be simply expressed as $c_k = \dfrac{Z_k}{2^J} \left( = p_k \cdot 2^{L_k - J} \right)$.

As in Exponent selection example 6 above, in the case of $a_k = 0$, Exponent condition 1a and Exponent condition 1b are satisfied for an arbitrary $b_k$ satisfying $\gcd(b_k, Z_k) = 1$ as well as $b_k = 1$. That is, for an integer b satisfying $\gcd(b, Z_k) = 1$, the submatrix B configured as $a_k = 0$, $b_k = b$, and $c_k = p_k \cdot 2^{\max(L_k - J, 0)}$ (or $c_k = \begin{cases} p_k, & L_k < J \\ \dfrac{Z_k}{2^J}, & L_k \geq J \end{cases}$) satisfies Exponent condition 1a and Exponent condition 1b.

In accordance with a method as in Exponent selection example 6 above, efficient encoding is possible based on

$$\phi^{2^J} = I + P^{b \cdot 2^J} + P^Z = P^{b \cdot 2^J}$$

$$\phi^{-1} = P^{-b \cdot 2^J} \cdot \phi^{2^J - 1} = P^{-b \cdot 2^J} \cdot \phi^{2^{J-1}} \cdot \phi^{2^{J-2}} \cdot \cdots \cdot \phi^2 \cdot \phi.$$

The exponent selection method of Exponent selection example 4, Exponent selection example 5, and Exponent selection example 6 may enable the cycle length to be improved to a maximum of $2^{J+1} \cdot m_{b1}$ considering efficient encoding. If the $m_{b1}$ value is relatively large, the cycle characteristics may be sufficiently improved even without a large J value. The J value may be determined in consideration of a parameter $m_{b1}$ value indicating the number of rows in the core matrix part in a given parity check matrix in the system and target BLER values. For example, in the case where the target BLER is relatively high or the $m_{b1}$ value of the core matrix is large, J=1 or 2 may be sufficient, but in the case where the target BLER is relatively low or the $m_{b1}$ value of the core matrix is small, it is preferable to configure J=2, 3, 4, and so on.

In general, since the performance of a code is influenced by the cycle characteristics to different degrees depending on the code length, it is also possible to configure a J value differently depending on the lifting size. That is, at least one of the exponents may be determined based on the lifting size, and when the lifting size is relatively small, the $J_1$ value may be configured to a small value, and when the lifting size is relatively large, the $J_2$ value may be set to a large value ($J_1 < J_2$). When the J value is configured differently according to the lifting size, a reference lifting size and an appropriate $J_1$ and $J_2$ value should be determined.

Various possible exponent selection methods including Exponent selection examples 1 to 6 may be variably applied according to the system's target BLER and/or lifting size. For example, if the target BLER of the system is high, the cycle characteristics may not have a significant influence on the decoding performance of the code, and thus, even if the cycle characteristics are not improved, encoding may be performed by using a conventional method having the highest coding efficiency. However, if the target BLER is low, the exponent selection methods proposed in the disclosure may be applied. Here, whether the target BLER is high or low may be determined relatively when there are multiple target BLERs available for the system. For example, when a first target BLER is $10^{-1}$ and a second target BLER is $10^{-5}$, the first target BLER may be considered to be higher than the second target BLER. If the first target BLER is $10^{-1}$, the second target BLER is $10^{-5}$, and the third target BLER is $10^{-6}$ (or $10^{-7}$), it may be determined that the first target BLER is higher than the second target BLER and the third target BLER, and it may also be determined that the first target BLER and the second target BLER are higher than the third target BLER. As such, when multiple target BLERs are available in the system, the BLER may be determined to be high or low based on a specific BLER value, and then the exponent selection method proposed in the disclosure may be variably applied based on same.

However, this is merely an embodiment of the disclosure, and the exponent selection method proposed in the disclosure may be applied when the target BLER is high or regardless of the target BLER, and may be variably applied based on other factors. In addition, the exponent selection method described throughout the entire disclosure refers to a method for selecting the exponents of the circulant permutation matrices included in the sub-matrix (specifically, submatrix B) of the parity check matrix, and thus, the exponent selection method of the disclosure may be described as a method for determining a parity check matrix or a method for determining a sub-matrix included in the parity check matrix. In addition, since the lifting size is closely related to the code length or TBS, all processes determined based on the lifting size in the embodiments disclosed in the disclosure may be changed to methods determined based on the code length or TBS. In addition, in Exponent selection examples 1 to 6, the lifting size $Z_k$ is expressed as "$Z_k = p_k \cdot 2^{L_k}$, $L_k \geq 0$, and $p_k$ is an odd number" for convenience, but in general, as in [Table 7-1] or [Table 7-2], the same exponent selection methods may be applied even in a case where $p_k$ is not restricted to an odd number, such as "$Z_k = p_k \cdot Z^{L_k}$, $L_k \geq 0$, and $p_k$ is the smallest lifting size in the k-th lifting size set."

As a specific example of the application of the J value in Exponent selection examples 4 to 6, when a system target BLER is determined to be high, the J value may be configured to be small as $J_1$, and when the system target BLER is determined to be low, the J value may be configured to be a relatively large value as $J_2$ ($J_1 < J_2$). In addition, the method for selecting the exponent or the determination of the J value may be determined in consideration of the lifting size. In general, A reference BLERs and/or lifting sizes may be configured, and the total of (A+1) different J values may be distinguished. For example, in case that there are a first reference value, a second reference value, and the like, the J value may be subdivided as $J_1 < J_2$, $J_1 < J_2 < J_3$, and the like. In general, J may also be configured as 0, and in this case, $P^a = P^c$ is established, and the cycle characteristics are not improved, and the existing scheme with the simplest encoding is indicated.

For reference, the method for determining the target BLER in a UE or a base station may be variously applied according to the system. For example, the system target BLER may be directly indicated from higher layer signaling such as configured radio resource control (RRC) information, the target BLER may be indirectly indicated by a configured CQI table or an MCS table, or indirectly indicated according to a configured service scenario.

The electronic device according to various embodiments set forth herein may be one of various types of electronic devices. The electronic device may include, for example, at least one of a portable communication device (e.g., a smart phone), a computer device, a portable multimedia device, a portable medical device, a camera, a wearable device, or a home appliance. The electronic device according to embodiments of the disclosure is not limited to those described above. In addition, an operation of transmitting a frame not only means that a frame is transmitted through a radio channel, but also means that an interface which outputs a frame is included in order to transmit the frame to various electronic devices. For example, some processors may output a frame to an RF front end in order to transmit the frame via a bus interface. Likewise, an operation of receiving a frame from any other device may also mean that there is an interface for obtaining, by various devices, a frame received from any other device. For example, it means that some processors may receive or obtain a frame from an RF front end via a bus interface.

It should be appreciated that various embodiments of the disclosure and the terms used therein are not intended to limit the technological features set forth herein to particular embodiments and the disclosure includes various changes, equivalents, and/or alternatives for a corresponding embodiment.

With regard to the description of the drawings, similar reference numerals may be used to designate similar or relevant elements. A singular expression may include a plural expression unless they are definitely different in a context. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such expressions as "a first", "a second", "the first", and "the second" may modify corresponding elements regardless of the order or importance thereof, and may be used to simply distinguish a corresponding element from the other elements and does not limit the corresponding elements. When an element (e.g., a first element) is referred to as being (operatively or communicatively) "connected" or "coupled" to/with another element (e.g., a second element), the element may be connected or coupled to/with the other element directly or via another element (e.g., a third element).

Also, the term "determining" may imply various meanings, for example, may mean, according to situations, various operations such as "identifying", "calculating or computing", "processing", "deriving", "investigating", "estimating", "looking up" (e.g., from other data structures in a database), or "ascertaining".

In the drawings in which methods of the disclosure are described, the order of the description does not always correspond to the order in which steps are performed, and the order relationship between the steps may be changed or the steps may be performed in parallel.

Alternatively, in the drawings in which methods of the disclosure are described, some elements may be omitted and only some elements may be included therein without departing from the essential spirit and scope of the disclosure.

In addition, in methods of the disclosure, some or all of the contents of each embodiment may be implemented in combination without departing from the essential spirit and scope of the disclosure.

Although exemplary embodiments of the disclosure have been described, various changes and modifications may be presented to those skilled in the art. These changes and modifications are intended to fall within the appended claims. In addition, operations that are represented by different blocks for the convenience of description in the operation flowcharts of the disclosure may be implemented by a plurality of separate processors in an actual system, but it will be obvious that they may also be implemented by a single integrated processor.

**Claims**

1. A method performed by a transmitter in a communication system, the method comprising:

   determining a number of input bits;
   determining a base matrix, based on the number of the input bits;
   determining a lifting size (Z), based on at least one of the number of the input bits or the base matrix;
   determining a parity check matrix, based on at least one of the base matrix or the lifting size (Z); and
   performing encoding, based on the parity check matrix and the input bits,
   wherein the parity check matrix comprises a first submatrix corresponding to the input bits and a second submatrix corresponding to first parity bits,
   wherein a first column block of the second submatrix comprises three circulant permutation matrices,
   wherein a greatest common divisor of at least one of difference values of respective exponents of the circulant permutation matrices and the lifting size (Z) is 1 or a smallest number greater than 1 among divisors of the lifting size (Z),
   wherein at least one of the difference values of the respective exponents of the circulant permutation matrices is $\dfrac{Z}{2^i}$ ($0 \le i \le L$), and
   wherein $Z = p * 2^i$ (P is an odd number, and $0 \le i \le L$).

2. The method of claim 1, wherein a greatest common divisor of two of the difference values of the respective exponents of the circulant permutation matrices and the lifting size (Z) is 1 or a smallest number greater than 1 among divisors of the lifting size (Z), and

   wherein at least one of the difference values of the respective exponents of the circulant permutation matrices is $\dfrac{Z}{2^i}$ ($1 \le i < L$) in case that $p$ is 1 and $L > 1$, and $\dfrac{Z}{2^i}$ ($1 \le i \le L$) in case that $p$ is an odd number of 3 or greater and $L > 0$.

3. The method of claim 1, wherein the second submatrix comprises at least one of $\begin{bmatrix} P^a & I & 0 & 0 \\ P^b & I & I & 0 \\ 0 & 0 & I & I \\ P^c & 0 & 0 & I \end{bmatrix}$ or

   $\begin{bmatrix} P^a & I & 0 & 0 \\ 0 & I & I & 0 \\ P^b & 0 & I & I \\ P^c & 0 & 0 & I \end{bmatrix}$, or

   wherein the second submatrix comprises $\begin{bmatrix} P^a & I & 0 & 0 & 0 \\ 0 & I & I & 0 & 0 \\ P^b & 0 & I & I & 0 \\ 0 & 0 & 0 & I & I \\ P^c & 0 & 0 & 0 & I \end{bmatrix}$.

4. The method of claim 1, wherein a greatest common divisor of a first value among the difference values of the respective exponents of the circulant permutation matrices and the lifting size (Z) is 1, and
   wherein a second value among the difference values of the respective exponents of the circulant permutation matrices is one of lifting size values smaller than a greatest lifting size value among the lifting size values included in a lifting size set.

5. A method performed by a receiver in a communication system, the method comprising:

receiving a signal;

determining a number of input bits, based on the signal;

determining a base matrix, based on the number of the input bits;

determining a lifting size ($Z$), based on at least one of the number of the input bits or the base matrix;

determining a parity check matrix, based on at least one of the base matrix or the lifting size ($Z$); and

performing decoding of the signal, based on the parity check matrix,

wherein the parity check matrix comprises a first submatrix corresponding to the input bits and a second submatrix corresponding to first parity bits,

wherein a first column block of the second submatrix comprises three circulant permutation matrices,

wherein a greatest common divisor of at least one of difference values of respective exponents of the circulant permutation matrices and the lifting size ($Z$) is 1 or a smallest number greater than 1 among divisors of the lifting size ($Z$),

wherein at least one of the difference values of the respective exponents of the circulant permutation matrices is

$\dfrac{Z}{2^i}$ ($0 \leq i \leq L$), and

wherein $Z = p * 2^i$ (P is an odd number, and $0 \leq i \leq L$).

6. The method of claim 5, wherein a greatest common divisor of two of the difference values of the respective exponents of the circulant permutation matrices and the lifting size ($Z$) is 1 or a smallest number greater than 1 among divisors of the lifting size ($Z$), and

wherein at least one of the difference values of the respective exponents of the circulant permutation matrices is $\dfrac{Z}{2^i}$

($1 \leq i < L$) in case that $p$ is 1 and $L > 1$, and $\dfrac{Z}{2^i}$ ($1 \leq i \leq L$) in case that $p$ is an odd number of 3 or greater and $L > 0$.

7. The method of claim 5, wherein the second submatrix comprises at least one of $\begin{bmatrix} P^a & I & 0 & 0 \\ P^b & I & I & 0 \\ 0 & 0 & I & I \\ P^c & 0 & 0 & I \end{bmatrix}$ or

$\begin{bmatrix} P^a & I & 0 & 0 \\ 0 & I & I & 0 \\ P^b & 0 & I & I \\ P^c & 0 & 0 & I \end{bmatrix}$, or

wherein the second submatrix comprises $\begin{bmatrix} P^a & I & 0 & 0 & 0 \\ 0 & I & I & 0 & 0 \\ P^b & 0 & I & I & 0 \\ 0 & 0 & 0 & I & I \\ P^c & 0 & 0 & 0 & I \end{bmatrix}$.

8. The method of claim 5, wherein a greatest common divisor of a first value among the difference values of the respective exponents of the circulant permutation matrices and the lifting size ($Z$) is 1, and

wherein a second value among the difference values of the respective exponents of the circulant permutation matrices is one of lifting size values smaller than a greatest lifting size value among the lifting size values included in a lifting size set.

9. A transmitter in a communication system, the transmitter comprising:

a transceiver; and

a controller coupled with the transceiver and configured to:

determine a number of input bits;

determine a base matrix, based on the number of the input bits;

determine a lifting size ($Z$), based on at least one of the number of the input bits or the base matrix;

determine a parity check matrix, based on at least one of the base matrix or the lifting size ($Z$); and

perform encoding, based on the parity check matrix and the input bits, wherein the parity check matrix comprises a first submatrix corresponding to the input bits and a second submatrix corresponding to first parity bits,

wherein a first column block of the second submatrix comprises three circulant permutation matrices,

wherein a greatest common divisor of at least one of difference values of respective exponents of the circulant permutation matrices and the lifting size (Z) is 1 or a smallest number greater than 1 among divisors of the lifting size (Z),

wherein at least one of the difference values of the respective exponents of the circulant permutation matrices is $\frac{Z}{2^i}$ ($0 \leq i \leq L$), and

wherein $Z = p * 2^i$ (P is an odd number, and $0 \leq i \leq L$).

10. The transmitter of claim 9, wherein a greatest common divisor of two of the difference values of the respective exponents of the circulant permutation matrices and the lifting size (Z) is 1 or a smallest number greater than 1 among divisors of the lifting size (Z), and

wherein at least one of the difference values of the respective exponents of the circulant permutation matrices is $\frac{Z}{2^i}$ ($1 \leq i < L$) in case that $p$ is 1 and $L > 1$, and $\frac{Z}{2^i}$ ($1 \leq i \leq L$) in case that p is an odd number of 3 or greater and $L > 0$.

11. The transmitter of claim 9, wherein the second submatrix comprises at least one of $\begin{bmatrix} P^a & I & 0 & 0 \\ P^b & I & I & 0 \\ 0 & 0 & I & I \\ P^c & 0 & 0 & I \end{bmatrix}$ or

$\begin{bmatrix} P^a & I & 0 & 0 \\ 0 & I & I & 0 \\ P^b & 0 & I & I \\ P^c & 0 & 0 & I \end{bmatrix}$, or

wherein the second submatrix comprises $\begin{bmatrix} P^a & I & 0 & 0 & 0 \\ 0 & I & I & 0 & 0 \\ P^b & 0 & I & I & 0 \\ 0 & 0 & 0 & I & I \\ P^c & 0 & 0 & 0 & I \end{bmatrix}$.

12. The transmitter of claim 9, wherein a greatest common divisor of a first value among the difference values of the respective exponents of the circulant permutation matrices and the lifting size (Z) is 1, and

wherein a second value among the difference values of the respective exponents of the circulant permutation matrices is one of lifting size values smaller than a greatest lifting size value among the lifting size values included in a lifting size set.

13. A receiver in a communication system, the receiver comprising:

a transceiver; and
a controller coupled with the transceiver and configured to:

receive a signal;
determine a number of input bits, based on the signal;
determine a base matrix, based on the number of the input bits;
determine a lifting size (Z), based on at least one of the number of the input bits or the base matrix;
determine a parity check matrix, based on at least one of the base matrix or the lifting size (Z); and
perform decoding of the signal, based on the parity check matrix,
wherein the parity check matrix comprises a first submatrix corresponding to the input bits and a second submatrix corresponding to first parity bits,
wherein a first column block of the second submatrix comprises three circulant permutation matrices,

wherein a greatest common divisor of at least one of difference values of respective exponents of the circulant permutation matrices and the lifting size (Z) is 1 or a smallest number greater than 1 among divisors of the lifting size (Z),

wherein at least one of the difference values of the respective exponents of the circulant permutation matrices is $\frac{Z}{2^i}$ $(0 \le i \le L)$, and

wherein $Z = p * 2^i$ (P is an odd number, and $0 \le i \le L$).

**14.** The receiver of claim 13, wherein a greatest common divisor of two of the difference values of the respective exponents of the circulant permutation matrices and the lifting size (Z) is 1 or a smallest number greater than 1 among divisors of the lifting size (Z),

wherein at least one of the difference values of the respective exponents of the circulant permutation matrices is $\frac{Z}{2^i}$ $(1 \le i < L)$ in case that $p$ is 1 and $L > 1$, and $\frac{Z}{2^i}$ $(1 \le i \le L)$ in case that $p$ is an odd number of 3 or greater and $L > 0$,

wherein a greatest common divisor of a first value among the difference values of the respective exponents of the circulant permutation matrices and the lifting size (Z) is 1, and

wherein a second value among the difference values of the respective exponents of the circulant permutation matrices is one of lifting size values smaller than a greatest lifting size value among the lifting size values included in a lifting size set.

**15.** The receiver of claim 13, wherein the second submatrix comprises at least one of $\begin{bmatrix} P^a & I & 0 & 0 \\ P^b & I & I & 0 \\ 0 & 0 & I & I \\ P^c & 0 & 0 & I \end{bmatrix}$ or

$\begin{bmatrix} P^a & I & 0 & 0 \\ 0 & I & I & 0 \\ P^b & 0 & I & I \\ P^c & 0 & 0 & I \end{bmatrix}$, or

wherein the second submatrix comprises $\begin{bmatrix} P^a & I & 0 & 0 & 0 \\ 0 & I & I & 0 & 0 \\ P^b & 0 & I & I & 0 \\ 0 & 0 & 0 & I & I \\ P^c & 0 & 0 & 0 & I \end{bmatrix}$.

# FIG. 1

100

Codeword

$K_{ldpc}$        $N_{parity}$

| Information word [102] | Parity [104] |

$N_{ldpc}$

# FIG. 2

$$H_1 = \left\{ \begin{matrix} 1 & 1 & 1 & 1 & 1 & 1 & 0 & 0 \\ 1 & 1 & 0 & 1 & 0 & 1 & 1 & 0 \\ 1 & 1 & 1 & 0 & 0 & 0 & 1 & 1 \\ 1 & 0 & 1 & 1 & 1 & 0 & 0 & 1 \end{matrix} \right\}$$

FIG. 3A

FIG. 3B

FIG. 4

FB : filler bits

EP 4 757 219 A1

# FIG. 5

```
          ┌─────────────┐
          │    START    │
          └──────┬──────┘
                 │
                 ▼
      ┌──────────────────────┐  510
      │     Determine TBS     │
      └──────────┬───────────┘
                 │
                 ▼
           ╱──────────╲          520
          ╱            ╲     Yes        ┌──────────────────┐  530
         ╱  TBS > max   ╲──────────────▶│   Segmentation   │
         ╲    CBS ?     ╱               └─────────┬────────┘
          ╲            ╱                          │
           ╲──────────╱                           │
                 │ No                             │
                 ▼                                │
      ┌──────────────────────┐  540               │
      │ Determine block size │◀──────────────────┘
      │         (Z)          │
      └──────────┬───────────┘
                 │
                 ▼
      ┌──────────────────────┐  550
      │ Determine LDPC        │
      │   exponent matrix     │
      └──────────┬───────────┘
                 │
                 ▼
      ┌──────────────────────┐  560
      │ Perform LDPC encoding │
      └──────────┬───────────┘
                 │
                 ▼
          ┌─────────────┐
          │     END     │
          └─────────────┘
```

# FIG. 6

```
                    ┌─────────────┐
                    │    START    │
                    └──────┬──────┘
                           │
                           ▼
              ┌────────────────────────┐   610
              │      Determine TBS     │
              └────────────┬───────────┘
                           │
                           ▼
                     ╱╲              620
                   ╱     ╲
                 ╱         ╲      Yes
                ╱ TBS > max  ╲──────────────────┐
                ╲  CBS ?     ╱                   │
                 ╲         ╱                     ▼
                   ╲     ╱                ┌──────────────────────────┐  630
                     ╲╱                   │ Determine segmented      │
                      │ No                │      CBS size            │
                      ▼                   └────────────┬─────────────┘
              ┌────────────────────────┐  640          │
              │ Determine block size (Z)│◄─────────────┘
              └────────────┬───────────┘
                           │
                           ▼
              ┌────────────────────────┐  650
              │ Determine LDPC exponent │
              │        matrix           │
              └────────────┬───────────┘
                           │
                           ▼
              ┌────────────────────────┐  660
              │  Perform LDPC decoding  │
              └────────────┬───────────┘
                           │
                           ▼
                    ┌─────────────┐
                    │     END     │
                    └─────────────┘
```

FIG. 7

Transmission device (700)

| 710 | 720 | 730 | 740 | 750 |
|-----|-----|-----|-----|-----|
| Segmentation unit | Zero-padding unit | LDPC encoding unit | Rate matching unit | Modulation unit |

741       742

| Interleaver | Puncturing/repetition /zero removal unit |
|-------------|-------------------------------------------|

Rate matching unit (740)

EP 4 757 219 A1

FIG. 8

Reception device (800)

810

Demodulation unit

820

Rate dematching unit

830

LDPC decoding unit

840

Zero removal unit

850

De-segmentation unit

Rate dematching unit (820)

822

LLR insertion unit

823

LLR combiner

824

Deinterleaver

EP 4 757 219 A1

# FIG. 9

FIG. 10

# FIG. 11A

Information 22 blocks

| 250 | 69 | 226 | 159 |  | 100 | 10 |  |  | 59 | 229 | 110 | 191 | 9 |  | 195 | 23 |  | 190 | 35 | 239 | 31 | 1 | 0 |  |  |  |  |
|---|---|---|---|---|---|---|---|---|---|---|---|---|---|---|---|---|---|---|---|---|---|---|---|---|---|---|---|
| 2 |  | 239 | 117 | 124 | 71 |  | 222 | 104 | 173 |  | 220 | 102 |  | 109 | 132 | 142 | 155 |  | 255 |  | 28 | 0 | 0 | 0 |  |  |  |
| 106 | 111 | 185 |  | 63 | 117 | 93 | 229 | 177 | 95 | 39 |  |  | 142 | 225 | 225 |  | 245 | 205 | 251 | 117 |  |  |  | 0 | 0 |  |  |
| 121 | 89 |  | 84 | 20 |  | 150 | 131 | 243 |  | 136 | 86 | 246 | 219 | 211 |  | 240 | 76 | 244 |  | 144 | 12 | 1 |  |  | 0 |  |  |
| 157 | 102 |  |  |  |  |  |  |  |  |  |  |  |  |  |  |  |  |  |  |  |  |  |  |  |  | 0 |  |
| 205 | 236 |  | 194 |  |  |  |  |  |  |  | 231 |  |  | 28 |  |  |  |  |  | 123 | 115 |  |  |  |  |  | 0 |

EP 4 757 219 A1

FIG. 11B

Information 10 blocks

| 9 | 117 | 204 | 26 | | | 189 | | | 205 | 0 | 0 | | | | | | | | | |
|---|---|---|---|---|---|---|---|---|---|---|---|---|---|---|---|---|---|---|---|---|
| 167 | | | 166 | 253 | 125 | 226 | 156 | 224 | 252 | | 0 | 0 | | | | | | | | |
| 81 | 114 | | 44 | 52 | | | | 240 | | 1 | | 0 | 0 | | | | | | | |
| | 8 | 58 | | 158 | 104 | 209 | 54 | 18 | 128 | 0 | | | 0 | | | | | | | |
| 179 | 214 | | | | | | | | | | 71 | | | 0 | | | | | | |
| 231 | 41 | | | 194 | | 159 | | | | | 103 | | | | 0 | | | | | |
| 155 | | | | 228 | | 45 | | 28 | | | 158 | | | | | 0 | | | | |
| | 129 | | | 147 | | 140 | | | | | 3 | | 116 | | | | 0 | | | |
| 142 | 94 | | | | | | | | | | | 230 | | | | | | 0 | | |
| | 203 | | | | 205 | | | | | 61 | 247 | | | | | | | | 0 | |
| 11 | 185 | | | | 0 | 117 | | | | | | | | | | | | | | 0 |

EP 4 757 219 A1

## INTERNATIONAL SEARCH REPORT

| International application No. |
|---|
| **PCT/KR2024/013252** |

| **A.** | **CLASSIFICATION OF SUBJECT MATTER** |
|---|---|

**H04L 1/00**(2006.01)i; **H03M 13/11**(2006.01)i

According to International Patent Classification (IPC) or to both national classification and IPC

| **B.** | **FIELDS SEARCHED** |
|---|---|

Minimum documentation searched (classification system followed by classification symbols)

H04L 1/00(2006.01); H03M 13/00(2006.01); H03M 13/11(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 패리티 체크(Parity Check), 기본 행렬(basic matrix), 리프팅 (lifting), 순환 순열 행렬(circulant permutation matrix), 부분 행렬(partial matrix)

| **C.** | **DOCUMENTS CONSIDERED TO BE RELEVANT** | | |
|---|---|---|---|

| Category* | Citation of document, with indication, where appropriate, of the relevant passages | Relevant to claim No. |
|---|---|---|
| A | KR 10-2276721 B1 (HUAWEI TECHNOLOGIES CO., LTD.) 12 July 2021 (2021-07-12)<br>See paragraphs [0048]-[0051] and [0164]-[0189]; and figure 6. | 1-15 |
| A | KR 10-2146803 B1 (SAMSUNG ELECTRONICS CO., LTD.) 21 August 2020 (2020-08-21)<br>See paragraphs [0050] and [0074]-[0185]; and figure 3. | 1-15 |
| A | KR 10-2227250 B1 (HUAWEI TECHNOLOGIES CO., LTD.) 12 March 2021 (2021-03-12)<br>See paragraphs [0086]-[0144]; claim 1; and figure 8. | 1-15 |
| A | KR 10-1998199 B1 (LG ELECTRONICS INC.) 09 July 2019 (2019-07-09)<br>See paragraphs [0010]-[0020] and [0067]-[0103]. | 1-15 |
| A | US 2020-0067527 A1 (FUTUREWEI TECHNOLOGIES, INC.) 27 February 2020 (2020-02-27)<br>See paragraphs [0005]-[0022] and [0149]-[0191]; and figure 3. | 1-15 |

☐ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 December 2024** | **16 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/013252**

| Patent document cited in search report | | | Publication date (day/month/year) | Patent family member(s) | | | Publication date (day/month/year) |
|---|---|---|---|---|---|---|---|
| KR | 10-2276721 | B1 | 12 July 2021 | CN | 109067407 | A | 21 December 2018 |
| | | | | CN | 109150191 | A | 04 January 2019 |
| | | | | CN | 109150197 | A | 04 January 2019 |
| | | | | CN | 109327225 | A | 12 February 2019 |
| | | | | CN | 110754042 | A | 04 February 2020 |
| | | | | CN | 111066253 | A | 24 April 2020 |
| | | | | CN | 111416625 | A | 14 July 2020 |
| | | | | EP | 3567731 | A1 | 13 November 2019 |
| | | | | EP | 3588786 | A1 | 01 January 2020 |
| | | | | EP | 4064573 | A1 | 28 September 2022 |
| | | | | JP | 2020-520570 | A | 09 July 2020 |
| | | | | JP | 2020-526111 | A | 27 August 2020 |
| | | | | JP | 2021-064962 | A | 22 April 2021 |
| | | | | JP | 2022-179504 | A | 02 December 2022 |
| | | | | KR | 10-2019-0113983 | A | 08 October 2019 |
| | | | | US | 2020-0007159 | A1 | 02 January 2020 |
| | | | | US | 2020-0052720 | A1 | 13 February 2020 |
| | | | | US | 2020-0343912 | A1 | 29 October 2020 |
| | | | | US | 2021-0058095 | A1 | 25 February 2021 |
| | | | | US | 2022-0231705 | A1 | 21 July 2022 |
| | | | | WO | 2018-227681 | A1 | 20 December 2018 |
| | | | | WO | 2018-228514 | A1 | 20 December 2018 |
| | | | | WO | 2019-001090 | A1 | 03 January 2019 |
| | | | | WO | 2019-001477 | A1 | 03 January 2019 |
| KR | 10-2146803 | B1 | 21 August 2020 | US | 2014-0372826 | A1 | 18 December 2014 |
| | | | | WO | 2014-200303 | A1 | 18 December 2014 |
| KR | 10-2227250 | B1 | 12 March 2021 | CN | 109417392 | A | 01 March 2019 |
| | | | | EP | 3479486 | A1 | 08 May 2019 |
| | | | | JP | 2019-522435 | A | 08 August 2019 |
| | | | | US | 2019-0222229 | A1 | 18 July 2019 |
| | | | | WO | 2018-014272 | A1 | 25 January 2018 |
| KR | 10-1998199 | B1 | 09 July 2019 | CN | 109891755 | A | 14 June 2019 |
| | | | | EP | 3567730 | A2 | 13 November 2019 |
| | | | | JP | 2020-501429 | A | 16 January 2020 |
| | | | | US | 2021-0167800 | A1 | 03 June 2021 |
| | | | | WO | 2018-128435 | A2 | 12 July 2018 |
| US | 2020-0067527 | A1 | 27 February 2020 | CN | 110612668 | A | 24 December 2019 |
| | | | | CN | 114301470 | A | 08 April 2022 |
| | | | | EP | 3628112 | A1 | 01 April 2020 |
| | | | | JP | 2020-520143 | A | 02 July 2020 |
| | | | | US | 2018-0323802 | A1 | 08 November 2018 |
| | | | | US | 2020-0412480 | A1 | 31 December 2020 |
| | | | | US | 2022-0094474 | A1 | 24 March 2022 |
| | | | | WO | 2018-204505 | A1 | 08 November 2018 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. MYUNG** ; **K. YANG** ; **Y. KIM**. Lifting Methods for Quasi-Cyclic LDPC Codes. *IEEE Communications Letters*, June 2006, vol. 10, 489-491

- **S. MYUNG** ; **K. YANG** ; **J. KIM**. Quasi-Cyclic LDPC Codes for Fast Encoding. *IEEE Transactions on Information Theory*, August 2005, vol. 51 (8), 2894-2901